# EUROPÄISCHE PATENTANMELDUNG

(11) **EP 2 993 176 A1**
(43) Veröffentlichungstag der Anmeldung: **09.03.2016**
(21) Anmeldenummer: 15183243.3
(22) Anmeldetag: 01.09.2015
(51) Int. Cl.: C07F 9/50, H01L 51/00

(54) **METALL(I)-KOMPLEXE FÜR VERBESSERTE LEITFÄHIGKEIT**

(30) Priorität: 02.09.2014 EP 14003026
(71) Anmelder: cynora GmbH, 76646 Bruchsal (DE)
(72) Erfinder: MYDLAK, Mathias, 76133 Karlsruhe (DE); VOLZ, Daniel, 76137 Karlsruhe (DE); BAUMANN, Thomas, 76137 Karlsruhe (DE)
(74) Vertreter: Jacobi, Markus Alexander

(57) **Zusammenfassung**

Die vorliegende Erfindung betrifft einen Metall(I)-Komplex eines Metalls M ausgewählt aus der Gruppe bestehend aus Cu, Ag und Au, wobei das Metall(I) komplexiert ist mit: I.) mindestens einem organischen Liganden L, der mindestens eine nicht-komplexierte ionische Gruppe enthält; und II.) mindestens einen anorganischen Liganden ausgewählt aus der Gruppe bestehend aus einem Halogenid, einem Thiosulfation, einem Isocyanation, einem Cyanidion und einem Azid, wobei der Metall(I)-Komplex ein Salz darstellt. Ferner umfasst die Erfindung eine einen derartigen Metall(I)-Komplex enthaltende Zusammensetzung Z, sowie ein Verfahren zur Herstellung eines derartigen Metall(I)-Komplexes. Zudem betrifft die vorliegende Erfindung eine opto-elektronische Vorrichtung, die mindestens einen erfindungsgemäßen Metall(I)-Komplex enthält.

## Beschreibung

Die vorliegende Erfindung betrifft einen Metall(I)-Komplex eines Metalls M ausgewählt aus der Gruppe bestehend aus Cu, Ag und Au, wobei das Metall(I) komplexiert ist mit: I.) mindestens einem organischen Liganden L, der mindestens eine nicht-komplexierte ionische Gruppe enthält; und II.) mindestens einem anorganischen Liganden ausgewählt aus der Gruppe bestehend aus einem Halogenid, einem Thiosulfation, einem Isocyanation, einem Cyanidion und einem Azid, wobei der Metall(I)-Komplex ein Salz darstellt. Ferner umfasst die Erfindung eine einen derartigen Metall(I)-Komplex enthaltende Zusammensetzung Z, sowie ein Verfahren zur Herstellung eines derartigen Metall(I)-Komplexes. Zudem betrifft die vorliegende Erfindung eine opto-elektronische Vorrichtung, die mindestens einen erfindungsgemäßen Metall(I)-Komplex enthält, sowie ein Verfahren zu deren Herstellung.

Opto-elektronische Vorrichtungen, die auf der Grundlage von organischen Verbindungen, wie beispielsweise lichtemittierende elektrochemische Zellen (engl. "light emitting electrochemical cells", LECs), organische Leuchtdioden (engl. "organic light emitting diodes", OLEDs), organische Laser, organische Solarzellen (engl. "organic solar cells", OSCs) oder optische Sensoren basieren, gewinnen zunehmend an praktischer Bedeutung. Besonders LECs und OLEDs sind vielversprechende Bauteile in elektronischen Vorrichtungen wie beispielsweise Bildschirmen, aber auch in der Beleuchtungstechnik und in der Verpackung. Im Gegensatz zu den meisten anorganisch basierten opto-elektronischen Vorrichtungen sind solche auf organischen Verbindungen basierenden häufig biegsam und in besonders dünner Schichtdicke herzustellen. Die bereits verfügbaren LEC- und OLED-Beleuchtungen zeigen ein angenehmes Lichtspektrum. OLED-Bildschirme bestechen durch besonders hohe Farbbrillanz, hohe Kontraste und Energieeffizienz. OSCs sind im Gegensatz zu Silizium-basierten Solarzellen besonders energieeffizient herzustellen.

Die hierbei verwendeten Emitter- bzw. Absorber-Verbindungen werden in die Emitterschicht (lichtemittierende bzw. absorbierende Schicht) der entsprechenden opto-elektronischen Vorrichtung eingebracht. Seit einigen Jahren werden hierzu vermehrt Metall-Komplexe eingesetzt, um die Quantenausbeute zu maximieren. Die hierbei vom Metall induzierte Spin-Bahn-Kopplung resultiert in einer erhöhten Intersystem-Crossing-Rate (ISC-Rate) vom angeregten Singulett- zum Triplett-Zustand bzw. in einer erhöhten reversen Intersystem-Crossing-Rate (reverse ISC-Rate) vom angeregten Triplett- zum Singulett-Zustand und somit zu einer Nutzung sowohl der Singulett- als auch der Triplett-Exzitonen für die Emission. Dies ermöglicht eine theoretisch erreichbare innere Quantenausbeute von 100 %.

Von Nachteil sind bei den bekannten opto-elektronischen Vorrichtungen auf Basis von Metall(I)-Komplexen die in der Regel vergleichsweise schlechte Leitfähigkeit und Löslichkeit der verwendeten Materialien.

Allgemein ist im Stand der Technik (Z.B. WO 2014/102079, WO 2013/07707, WO 2010/149748, WO 2013/017675, WO 2013/072508 und WO 2013/001086) bekannt, dass polare Substituenten von Liganden ihre Löslichkeit in polaren Lösungsmitteln tendenziell verbessern können. Eine polare Gruppe kann hiernach eine beliebige polare Gruppe, insbesondere auch eine nichtionische polare Gruppe, die nicht stromleitend ist, sein, die optional an einer Komplexbildung beteiligt sein kann. In den im Stand der Technik genannten bevorzugten Ausführungsformen werden jeweils unpolare Substituenten genannt, da in vielen Anwendungen eine Migration der Emitterverbindungen im elektrischen Feld gerade vermieden werden soll. Zudem wird im Stand der Technik nicht ein Metall-(I)-Komplex gelehrt, der in seiner Gesamtheit ein Salz darstellt.

Daher besteht ein Bedürfnis, Emitterverbindungen bereitzustellen, die über eine gute Leitfähigkeit und Löslichkeit verfügen. Diese sollen auch in opto-elektronischen Vorrichtungen einsetzbar sein.

Überraschend wurde gefunden, dass Metall(I)-Komplexe mit ionischen Gruppen versehen werden können, ohne dass die Funktionalität als Emitterverbindung darunter leidet. Dadurch wird jedoch u.a. die Leitfähigkeit und Löslichkeit merklich verbessert.

Ein erster Aspekt der vorliegenden Erfindung betrifft einen Metall(I)-Komplex eines Metalls M ausgewählt aus der Gruppe bestehend aus Cu, Ag und Au, wobei das Metall(I) (= Metall M) komplexiert ist mit:
I.) mindestens einem organischen Liganden L, der mindestens eine nicht-komplexierte ionische Gruppe enthält; und
II.) mindestens einem anorganischen Liganden ausgewählt aus der Gruppe bestehend aus einem Halogenid, einem Thiosulfation, einem Isocyanation, einem Cyanidion und einem Azid,
   wobei der Metall(I)-Komplex ein Salz darstellt.

Da der Metall(I)-Komplex ein Salz darstellt, enthält der Metall(I)-Komplex bevorzugt mindestens eine nicht-komplexierte ionische Gruppe. Der Fachmann wird verstehen, dass der Metall(I)-Komplex dann im neutralisierten Zustand auch mindestens ein Gegenion, dass ionisch an die nicht-komplexierte ionische Gruppe gebunden sein kann, umfasst. Das Gegnion kann unter bestimmten bedingungen und in bestimmten Lösungsmitteln (beispielsweise in wässriger Lösung) aber abgespaltenwerden.

Der Metall(I)-Komplex weist bevorzugt eine niedrige molare Masse auf, weist daher bevorzugt ein Molekulargewicht von nicht mehr als 10 kDa, stärker bevorzugt von nicht mehr als 5 kDa, insbesondere nicht mehr als 2 kDa, auf.

Das im Metall(I)-Komplex enthaltene Metall M stellt ein Metal(I) dar. Daher liegt das Metall M im Komplex bevorzugt in einer Form ausgewählt aus der Gruppe bestehend aus Cu(I), Ag(I) und Au(I) vor.

Dass der Metall(I)-Komplex ein Salz darstellt, bedeutet bevorzugt, dass ein Gegenion zu der mindestens einen nicht-komplexierten ionischen Gruppe vorliegt, was in wässriger Lösung abgetrennt werden kann, oder dass zwei entgegengesetzte Ladungen räumlich getrennt vorliegen (daher bevorzugt in einem Abstand von mindestens 200 pm oder mindestens 400 pm). Somit ist eine nicht-komplexierte ionische Gruppe kein Zwitterion.

Der Metall(I)-Komplex kann eine, zwei, drei, vier, fünf, sechs, sieben, acht, neun, zehn oder mehr nicht-komplexierte ionische Gruppe(n) enthalten. Diese können eine Gesamtladung des Metall(I)-Komplexes von >0, von <0 oder von 0 ergeben, daher einen geladenen oder ungeladenen Metall(I)-Komplex ergeben. Bevorzugt ist ein geladener Metall(I)-Komplex, insbesondere ein Metall(I)-Komplex mit einer Gesamtladung von -1, -2, -3, -4, +1, +2, +3 oder +4, , insbesondere von -2 oder +2.

Unter einem Halogenid ist im Sinne der Erfindung bevorzugt ein Anion eines Halogens zu verstehen. Bevorzugt ist der mindestens eine anorganische Ligand ein Halogenid, bevorzugt I⁻, Br⁻ oder Cl⁻, insbesondere Iodid. Unter einem Azid ist im Sinne der Erfindung bevorzugt ein in dem Metall(I)-Komplex enthaltene Gruppe N₃⁻ zu verstehen.

Es wird verstanden werden, dass die negative Ladung der Anionen und die positiven Ladungen der Metall(I)-Ionen sich ganz oder teilweise neutralisieren können, etwa dann, wenn sie im Metall(I)-Komplex vorliegen.

Ein erfindungsgemäßer Metall(I)-Komplex kann eine beliebige Stöchiometrie zwischen Metall(I) M und einem oder mehreren organischen Liganden L aufweisen. Bevorzugt handelt es sich um einen Komplex eine Stöchiometrie aufweisend ausgewählt aus der Gruppe bestehend aus M₂L₂, M₂L₃, M₁L₁, M₁L₂, M₁L₃, M₁L₄, M₂L₁ und M₂L₄. Stärker bevorzugt handelt es sich um einen Komplex aus der Gruppe bestehend aus M₂L₂, M₂L₃, M₁L₁ und M₁L₂, insbesondere M₂L₂ oder M₂L₃. Hierbei stellt L die Gesamtheit der organischen Liganden L dar, die gleichartige (homoleptische) oder verschiedenartige (heteroleptische) Liganden sein können. Anorganische Liganden und Ionen sind in der vorgenannten Stöchiometrie nicht einbezogen. Ein zwei Metalle M enthaltender Komplex (z.B. M₂L₂ oder M₂L₃) kann eine planare oder schmetterlingsartige Struktur (engl. "butterfly structure") aufweisen oder auch eine Struktur, die abhängig von der Umgebung die Konformation wechseln kann.

Ein M₂L₂-Komplex kann beispielsweise ein Cu₂L₂-Komplex, ein Au₂L₂-Komplex oder ein Ag₂L₂-Komplex sein, besonders bevorzugt ist ein Cu₂L₂-Komplex.

Ein M₂L₃-Komplex kann beispielsweise ein Cu₂L₃-Komplex, ein Au₂L₃-Komplex oder ein Ag₂L₃-Komplex sein, besonders bevorzugt ist ein Cu₂L₃-Komplex.

Bevorzugt ist ein Metall-Komplex im Sinne der Erfindung ein M(I)-Komplex. Stärker bevorzugt weist der M(I)-Komplex eine der folgenden Strukturen (a), (b) oder (c) auf: 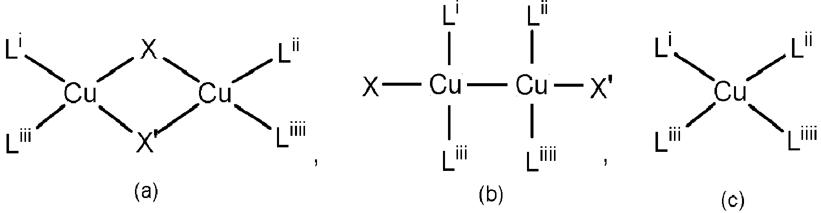 worin Lⁱ - Lⁱⁱⁱⁱ jeweils unabhängig von einander darstellen:
A) geeignete organische Liganden L, die entweder gleich oder verschieden sein können,oder
B) Teile von organischen Liganden L, die entweder gleich oder verschieden sein können, wobei zwei oder mehr aus Lⁱ - Lⁱⁱⁱⁱ kovalent miteinander verbunden sein können, so wie etwa Lⁱ mit Lⁱⁱⁱ, Lⁱⁱ mit Lⁱⁱⁱⁱ, Lⁱ mit Lⁱⁱ, Lⁱⁱⁱ mit Lⁱⁱⁱⁱ, Lⁱ mit Lⁱⁱⁱⁱ, Lⁱⁱ mit Lⁱⁱⁱ Lⁱ mit Lⁱⁱ und Lⁱⁱⁱ, Lⁱ mit Lⁱⁱ und L^{iv}, Lⁱ mit Lⁱⁱⁱ und L^{iv}, Lⁱⁱ mit Lⁱⁱⁱ und L^{iv} oder alle Liganden Li - L^{iv} miteinander, wobei dann das Konjugat einen organischen Liganden L darstellt; und
worin X und X' jeweils unabhängig von einander ein geeigneter anionischer Ligand ist, wie beispielsweise ein Anion ausgewählt aus der Gruppe bestehend aus Cl⁻, Br⁻, I⁻, SCN⁻, CN⁻, RS⁻, RSe⁻, RR'N⁻, RR'P⁻ und R-C≡C⁻,
wobei R und R' unabhängig von einander ausgewählt sind aus der Gruppe bestehend aus einem C₁₋₂₀-Alkyl-Rest, Adamantyl-Rest, C₆₋₁₄-Aryl-Rest, C₂₋₁₃-Heteroaryl-Rest, C₂₋₂₀-Alkenyl-Rest, C₂₋₂₀-Alkinyl-Rest (-C=C-R"), -OR", und -NR"R"', und
wobei R", R'" wie R definiert sind und auch H sein können.

Die Begriffe "Alkyl-Rest", "Alkyl-Gruppe" und dergleichen bezeichnen lineare oder auch verzweigte Alkylreste, bei denen optional ein oder mehrere Wasserstoffatome substituiert sein können, so wie beispielsweise durch organische Gruppen, funktionelle Gruppen oder auch Heteroatome. Entsprechend können auch Alkylen-, Alkenyl-, Alkenylen-, Alkinyl- und Alkinylenreste lineare oder auch verzweigt und optional substituiert sein.

Bevorzugt sind die Liganden Lⁱ - Lⁱⁱⁱⁱ ausgewählt aus ein- und zweizähnigen Phosphan- und Arsanliganden sowie Liganden mit mindestens einem N-Donoratom. Die Liganden können entweder neutral oder einfach negativ geladen sein.

Gemäß der vorliegenden Erfindung trägt mindestens einer der Liganden Lⁱ-Lⁱⁱⁱⁱ eine nicht-komplexierte ionische Gruppe.

Die Liganden können entweder einzähnige Liganden sein oder miteinander verbunden sein und mehrzähnige, insbesondere zweizähnige, Liganden bilden. Die Strukturen enthalten daher entweder vier einzähnige Liganden oder zwei zweizähnige Liganden oder einen zweizähnigen und zwei einzähnige Liganden oder einen dreizähnigen und einen einzähnigen Liganden oder einen vierzähnigen Liganden.

Ein M₂L₂-Komplex kann demnach beispielsweise ein Cu₂L₂-Komplex, ein Au₂L₂-Komplex oder ein Ag₂L₂-Komplex sein, besonders bevorzugt ist ein Cu₂L₂-Komplex. Ein M₂L₃-Komplex kann beispielsweise ein Cu₂L₃-Komplex, ein Au₂L₃-Komplex oder ein Ag₂L₃-Komplex sein, besonders bevorzugt ist ein Cu₂L₃-Komplex.

Es finden insbesondere ein- und zweizähnige Phosphan- und Arsanliganden sowie Liganden mit mindestens einem N-Donoratom Verwendung. Die Liganden können entweder neutral oder einfach negativ geladen sein.

Wie hierin verwendet, kann ein organischer Ligand L jede organische Verbindung sein, die mit dem Metall(I) eine Komplexbindung eingehen kann und zudem eine nicht-komplexierte ionische Gruppe trägt. Eine organische Verbindung ist dabei eine Kohlenwasserstoffverbindung, die optional mit Heteroatomen wie beispielsweise Stickstoff, Phosphor, Sauerstoff und/oder Halogenen substituiert sein kann.

Eine nicht-komplexierte ionische Gruppe ist hierbei eine chemische Gruppe, die eine ionische Bindung eingeht. Eine ionische Bindung liegt bevorzugt dann vor, wenn die Elektronegativitäts-Differenz (ΔE_{N}) zwischen den Bindungspartnern größer als 1,7 ist und/oder wenn in 1 molarer wässriger Lösung mehr als 50 mol-% der Bindung unter Bildung von Ionen gespalten würde.

Bevorzugt weist die der erfindungsgemäße Metall(I)-Komplex einen ΔE-Abstand zwischen dem untersten Triplett-Zustand und dem darüber liegenden Singulett-Zustand von nicht über 3000 cm⁻¹, bevorzugt nicht über 2000 cm⁻¹, insbesondere von nicht über 1000 cm⁻¹, auf.

Erfindungsgemäß liegt im ausgebildeten Metall(I)-Komplex mindestens eine ionische Gruppe vor, die nicht-komplexiert, daher frei vorliegt. Eine nicht-komplexierte Gruppe kann beispielsweise -SO₃⁻, -PO₃⁻ oder -COO⁻, oder -NH₃⁺ sein.

An das Metall(I), das von dem mindestens einem organischen Liganden L komplexiert wird, ist zudem erfindungsgemäß mindestens ein Halogenid gebunden, daher Iodid, Chlorid, Bromid und/oder Fluorid. Bevorzugt liegt das Halogen hierbei als Anion vor, daher als Halogenid, bevorzugt als I⁻, Cl⁻, Br⁻ und/oder F⁻. Stärker bevorzugt ist das Halogenid ausgewählt aus der Gruppe bestehend aus I⁻, Cl⁻, und Br⁻. Besonders bevorzugt ist das Halogenid Iodid.

Alternativ oderzusätzlich kann auch ein Anion ausgewählt aus der Gruppe bestehend aus SCN⁻, CN⁻, RS⁻, RSe⁻, R₂N⁻, R₂P⁻, R-C≡C⁻ vorliegen, wobei R = C₁₋₂₀-Alkyl (z.B. Methyl, Ethyl, n-Propyl, iso-Propyl, n-Butyl, tert.-Butyl, Adamantyl), C₆₋₁₄-Aryl (z.B. Phenyl, Tolyl, Napthyl, C₆F₅), C₂₋₁₃-Heteroaryl (z.B. Furyl, Thienyl, Pyridyl, Pyrimidyl), C₂₋₂₀-Alkenyl (z.B. CR=CR"R"'), C₂₋₂₀-Alkinyl (-C=C-R"), -OR", -NR"R"', wobei R", R'" definiert sind wie R und auch H sein können.

Gemäß einer bevorzugten Ausführungsform weist das Gegenion der nicht-komplexierten ionischen Gruppe einen van-der-Waals-Radius von nicht mehr als 400 pm auf.

Stärker bevorzugt beträgt der van-der-Waals-Radius des Gegenions nicht mehr als 375 pm, nicht mehr als 350 pm, nicht mehr als 300 pm oder nicht mehr als 280 pm.

Gemäß einer alternativen bevorzugten Ausführungsform weist das Gegenion der nicht-komplexierten ionischen Gruppe einen van-der-Waals-Radius von mehr als 400 pm auf.

Gemäß einer weiteren alternativen Ausführungsform kann der Komplex auch zwei oder mehr (teils) verschieden geladene, räumlich voneinander getrennte ionische Gruppen aufweisen, so dass sich die Ladungen (teilweise oder vollständig) gegenseitig aufheben. Räumlich getrennt bedeutet in diesem Zusammenhang, dass zwischen den Ladungen ein Abstand von mindestens 200 pm oder mindestens 400 pm vorliegt, so dass nicht lediglich ein Zwitterion, sondern voneinander getrennte Ladungen vorliegen. So kann beispielsweise eine positiv geladene und eine negativ geladene ionische Gruppe vorliegen, so dass der Metallkomplex amphiphil/ambipolar ist. Diese ionischen Gruppen können an demselben Liganden L oder an verschiedenen Liganden L lokalisiert sein. Es kann ein Spacer zwischen den ionischen Gruppen vorliegen, so wie etwa ein C₁₋₂₀-Alkylspacer.

Besonders bevorzugt handelt es sich beim Vorliegen einer negativ geladenen nicht-komplexierten ionischen Gruppe (beispielshaft -SO₃⁻, -PO₃⁻ oder -COO⁻) bei dem jeweiligen Gegenion um ein Alkalimetallion oder ein Erdalkalimetallion, insbesondere ein Alkalimetallion.

Beispielhaft handelt es sich dann bei dem Gegenion um ein Kation ausgewählt aus der Gruppe bestehend aus Alkalimetallionnen (z.B. Na⁺, K⁺, Li⁺, Rb⁺, Cs⁺), Erdalkalimetallionen (z.B. Mg²⁺, Ca²⁺, Sr²⁺, Ba²⁺, Be²⁺), Zn²⁺, Cd²⁺, NR*₄⁺, [R*-(CN₃H₅)]⁺ (Guanidinium), einer positiv geladenen substituierten oder unsubstituierten, aliphatischen oder aromatischen C₂₋₂₀-mono-, di- oder trizyklischen Verbindung und einer positiv geladenen substituierten oder unsubstituierten, aliphatischen oder aromatischen Heterozyklus (z.B. einem Imidazoliumion, Oxoniumkation, Phosphoniumkation), wobei R* Wasserstoff, ein beliebiger unverzweigter oder verzweigter, optional substituierter C₁₋₂₀-Alkylrest, ein beliebiger unverzweigter oder verzweigter, optional substituierter C₂₋₂₀-Alkenylrest, ein beliebiger unverzweigter oder verzweigter, optional substituierter C₂₋₂₀-Alkinylrest, ein beliebiger optional substituierter aliphatischer oder aromatischer C₅₋₂₀-Zyklus sein kann.

Gemäß einer spezifischen Ausführungsform ist ein Kation ausgewählt aus der Gruppe bestehend aus Na⁺, K⁺ und Li⁺, insbesondere Na⁺.

Besonders bevorzugt handelt es sich beim Vorliegen einer positiv geladenen nicht-komplexierten ionischen Gruppe (beispielshaft -NH₃⁺, eine am Liganden L gebundene Guanidiniumgruppe, eine am Liganden L gebundene Imidazoiliumgruppe) bei dem jeweiligen Gegenion um ein Halogenidion, ein Isothiocyanation, ein Cyanidion, ein Isocanation, ein Phosphation, ein hydrogenphosphation, ein Sulfation, ein Boration, ein Parchloration, ein Interhalogenidion (z.B. IBr2⁻), ein Alumination, ein Wolframation, ein Molybdation, BF₄⁻ oder ein organisches Anionen (z.B. ein R*-COO-, R*-SO₃⁻ usw.)., wobei R* Wasserstoff, ein beliebiger unverzweigter oder verzweigter, optional substituierter C₁₋₂₀-Alkylrest, ein beliebiger unverzweigter oder verzweigter, optional substituierter C₂₋₂₀-Alkenylrest, ein beliebiger unverzweigter oder verzweigter, optional substituierter C₂₋₂₀-Alkinylrest, ein beliebiger optional substituierter aliphatischer oder aromatischer C₅₋₂₀-Zyklus sein kann.

Beispielhaft handelt es sich dann bei dem Gegenion um ein Anion ausgewählt aus der Gruppe bestehend aus Cl⁻, Br⁻, F⁻, I⁻, CN⁻ und SCN⁻, insbesondere Cl⁻.

Bevorzugt ist der Metall(I)-Komplex der vorliegenden Erfindung ein Cu(I)-Komplex, bei dem das Cu(I) auch an ein Halogenid ausgewählt aus der Gruppe bestehend aus Iodid, Chlorid und Bromid gebunden ist. Ein Cu(I)-Komplex kann hergestellt werden aus dem/den organischen Liganden L und einem oder mehren Kupferhalogenid(en) (insbesondere CuI, CuBr, CuCl und/oder CuF), wobei das/die Halogenid(e) anorganische Liganden des/der Metalls/Metalle sein können.

Gemäß einer bevorzugten Ausführungsform ist das komplexierte Metall(I) Cu(I) und der anorganische Ligand ein Halogenid, bevorzugt Iodid, Bromid oder Chlorid, insbesondere Iodid.

Daher ist besonders bevorzugt das komplexierte Metall(I) Cu(I) und das Halogenid Iodid.

Stärker bevorzugt ist das komplexierte Metall(I) Cu(I), das daran koordinierte Halogenid Iodid und das Gegenion mindestens einer nicht-komplexierten ionischen Gruppe des Metall(I)-Komplexes ein Kation ausgewählt aus der Gruppe bestehend aus Na⁺, K⁺ und Li⁺, insbesondere Na⁺.

Wie oben dargelegt, kann der erfindungsgemäße Metall(I)-Komplex eine beliebige Stöchiometrie aufweisen. Bevorzugt ist das Metall(I) (bevorzugt ein Übergangsmetall der Gruppe 10, insbesondere ein Metall(I) ausgewählt aus Cu(I), Ag(I) und Au(I)) vierfach koordiniert, daher an maximal vier Liganden gebunden. Die Liganden können von vier-, drei-, zwei- oder auch nur einzähnig sein. So können beispielsweise zweizähnige organische Liganden L jeweils zwei Bindungsstellen bereitstellen und somit als Chelatkomplex-Bildner fungieren. Liegt mehr als ein organischer Ligand L in dem Metall(I)-Komplex vor, können diese organischen Liganden L gleichartig oder verschiedenartig sein.

Mindestens eine Koordinationsstelle am Metall M wird erfindungsgemäß von einem Halogid besetzt, so dass eine, zwei oder drei Koordinationsstellen des vierfach koordinierten Metall(I)-Komplexes von organischen Ligand(en) L besetzt werden können. Bevorzugt sind zwei der vier Koordinierungsstellen je von einem Halogenid besetzt und zwei der vier Koordinierungsstellen von einem oder zwei separaten organischen Liganden L besetzt. Liegen zwei organische Liganden L in dem Metall(I)-Komplex vor, können diese gleichartig oder verschiedenartig sein.

Gemäß einer stark bevorzugten Ausführungsform ist der Metall(I)-Komplex ein vierfach koordinierter Cu(I)-Komplex, der mindestens einen organischen Liganden L enthält.

Der Metall(I)-Komplex gemäß der vorliegenden Erfindung kann als einziges komplexiertes Metall M ein Metall(I) ausgewählt aus der Gruppe bestehend aus Cu, Ag und Au enthalten oder kann zusätzlich ein oder mehrere weitere(s) komplexierte(s) Metall(e) enthalten.

Weitere komplexierte Metalle (bzw. Metallionen) sind hierbei bevorzugt Metall(I), stärker bevorzugt Metall(I) ausgewählt aus der Gruppe bestehend aus Cu, Ag und Au. Noch stärker bevorzugt liegen in einem Metall(I)-Komplex zwei oder mehr gleichartige komplexierte Metalle vor, wie etwa Cu(I), Ag(I) oder Au(I) (daher beispielhaft zwei Cu(I), zwei Ag(I) oder zwei Au(I)) Alternativ können in einem Metall(I)-Komplex auch zwei oder mehr verschiedenartige komplexierte Metalle ausgewählt aus etwa Cu(I), Ag(I) und Au(I) vor (daher beispielhaft Cu(I) und Ag(I), Cu(I) und Au(I), oder Ag(I) und Au(I)). Noch stärker bevorzugt liegen in einem Metall(I)-Komplex als komplexierte Metalle nur gleichartige komplexierte Metalle vor, wie etwa Cu(I), Ag(I) oder Au(I), insbesondere Cu(I).

Bevorzugt enthält der Metall(I)-Komplex als einziges komplexiertes Metall M ein Metall(I) ausgewählt aus der Gruppe bestehend aus Cu(I), Ag(I) und Au(I) oder zusätzlich ein weiteres komplexiertes Metall. Besonders bevorzugt enthält der Metall(I)-Komplex als weiteres komplexiertes Metall(I) ausgewählt aus der Gruppe bestehend aus Cu(I), Ag(I) und Au(I), wobei das weitere komplexierte Metall(I) bevorzugt das gleiche ist, wie das erste, so dass nur zwei gleichartige komplexierte Metall(I) in dem Metall(I)-Komplex enthalten sind, insbesondere zwei Cu(I). Demgemäß enthält der Metall(I)-Komplex besonders bevorzugt zwei vierfach komplexierte Cu(I).

Gemäß einer noch stärker bevorzugten Ausführungsform enthält der Metall(I)-Komplex zwei vierfach komplexierte Cu(I), wobei die Cu(I) zudem jeweils zwei Bindungen mit Halogenid eingehen. Daher liegen bevorzugt zwei verbrückende Iodid-Liganden vor. Hierbei ist das Halogenid bevorzugt ausgewählt aus Iodid, Chlorid und Bromid. Besonders bevorzugt ist das Halogenid Iodid.

Gemäß einer stärker bevorzugten Ausführungsform weist der Metall(I)-Komplex eine Struktur gemäß einer der folgenden Formeln (I) oder (II) auf: 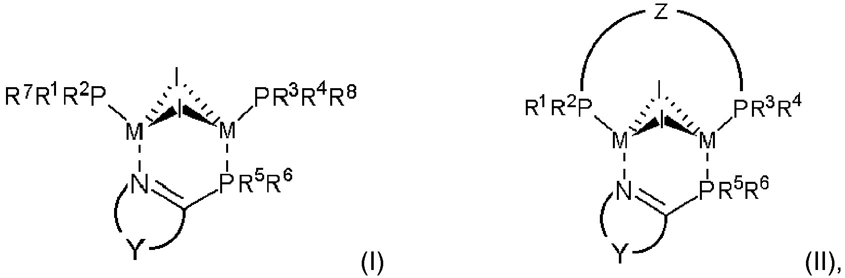 in der R¹, R², R³, R⁴, R⁵, R⁶, R⁷ und R⁸ unabhängig voneinander je einen beliebigen organischen Rest, bevorzugt einen substituierten oder unsubstituierten Arylrest, einen substituierten oder unsubstituierten Alkylarylrest, einen substituierten oder unsubstituierten Arylalkylrest oder einen substituierten oder unsubstituierten C₁₋₂₀-Alkylrest, darstellen, wobei mindestens einer der Reste R¹, R², R³, R⁴, R⁵, R⁶, R⁷ und R⁸ die ionische Gruppe enthält;
wobei M ein Metall(I), bevorzugt Cu(I), Ag(I) oder Au(I), insbesondere Cu(I) ist; in der Y eine beliebige bivalente Gruppe ist, bevorzugt eine bivalente Gruppe, die zusammen mit dem Kohlenstoffatom und dem Stickstoffatom der Struktur der Formeln (I) oder (II) ein konjugiertes π-Elektronensystem enthält, bevorzugt eine bivalente Gruppe ist, die zusammen mit dem Kohlenstofifatom und dem Stickstoffatom der Struktur der Formeln (I) oder (II) ein mono-, di-, tri- oder polyzyklisches, substituiertes oder unsubstituiertes aromatisches Ringsystem bildet; welches auch anelliert sein kann, und
wobei in der Struktur gemäß Formel (II) Z eine beliebige bivalente Gruppe ist, bevorzugt eine bivalente Gruppe ausgewählt aus der Gruppe bestehend aus -R^{a}-, -O-R^{a}-O-, -R^{a}-N=N-, -N=N-R^{a}-, -R^{a}-N=N-R^{b}-, -O-R^{a}-, -R^{a}-O-, -R^{a}-O-R^{b}-, -NR^{d}-R^{a}-, -R^{a}-NR^{d}-, -R^{a}-NR^{d}-R^{a}-, -NR^{d}-R^{a}-NR^{e}-, -R^{a}-NR^{d}-NR^{e}-, -R^{a}-N=N-, -NR^{d}-NR^{e}-R^{a}-, -N=N-R^{a}-, -R^{a}-N=N-R^{b}-,-N=CR^{d}-NR^{e}-, -R^{a}-N=CR^{d}-NR^{e}-, -R^{a}-N=CR^{d}-NR^{e}-R^{b}-, -N=CR^{d}-NR^{e}-R^{a}-, -N=CR^{d}-R^{a}-NH-, -R^{a}-N=CR^{d}-R^{b}-NR^{e}-, -N=CR^{d}-R^{a}-NR^{e}-R^{a}-, -R^{a}-N=CR^{d}-R^{b}-NR^{e}-R^{c}-, -NR^{d}-CR^{e}=N-, -R^{a}-NR^{d}-CR^{e}=N-, -NR^{d}-CR^{e}=N-R^{a}-, -R^{a}-NR^{d}-CR^{e}=N-R^{b}-, -NR^{d}-R^{a}-CR^{e}=N-, -R^{a}-NR^{d}-R^{b}-CR^{e}=N-, -NR^{d}-R^{a}-CR^{e}=N-R^{b}-, -R^{a}-NR^{d}-R^{b}-CR^{e}=N-R^{a}-, -R^{a}-N=C=N-, -N=C=N-R^{a}-,-N=CR^{d}-CR^{e}=N-, -R^{a}-N=CR^{d}-CR^{e}=N-, -N=CR^{d}-CR^{e}=N-R^{a}-, -R^{a}-N=CR^{d}-CR^{e}=N-R^{b}-,-N=CR^{d}-R^{a}-CR^{e}=N-R^{b}-, -R^{a}-N=CR^{d}-R^{b}-CR^{e}=N-, -R^{a}-N=CR^{d}-R^{b}-CR^{e}=N-R^{c}-, -O-R^{a}-NR^{d}-R^{a}-O-R^{b}-NH-, -O-R^{a}-NR^{d}-R^{b}-, -R^{a}-O-R^{b}-NR^{d}-R^{c}-, -NR^{d}-R^{a}-O-, -R^{a}-NR^{d}-R^{b}-O-, -NR^{d}-R^{a}-O-R^{b}-, -R^{a}-NR^{d}-R^{b}-O-R^{c}-, -R^{a}-CO-NR^{d}-, -CO-NR^{d}-R^{a}-, -R^{a}-CO-NR^{d}-R^{a}-, -R^{a}-NR^{d}-CO-,-NR^{d}-CO-R^{a}- oder -R^{a}-NR^{d}-CO-R^{a}-, S-R^{a}-S-, -O-R^{a}-S-, -S-R^{a}-O-, -S-R^{a}-, -R^{a}-S-, -R^{a}-S-R^{b}-, -S-R^{a}-NR^{d}-, -R^{a}-S-R^{b}-NR^{d}-, -S-R^{a}-NR^{d}-R^{b}-, -R^{a}-S-R^{b}-NR^{d}-R^{c}-, -NR^{d}-R^{a}-S-, -R^{a}-NR^{d}-R^{b}-S-, -NR^{d}-R^{a}-S-R^{b}-, -R^{a}-NR^{d}-R^{b}-S-R^{c}-, -R^{a}-CS-NR^{d}-, -CS-NR^{d}-R^{a}-, -R^{a}-CS-NR^{d}-R^{b}-,-R^{a}-NR^{d}-CS-, -NR^{d}-CS-R^{a}-, -R^{a}-NR^{d}-CS-R^{b}-, -SO-R^{a}-S-, -SO-R^{a}-SO-, -SO₂-R^{a}-SO₂-,-SO₂-R^{a}-SO-, -SO-R^{a}-SO₂-, -O-R^{a}-SO-, -O-R^{a}-SO₂-, -SO-R^{a}-O-, -SO₂-R^{a}-O-, -SO-R^{a}-,-SO₂-R^{a}-, -R^{a}-SO-, -R^{a}-SO₂-, -R^{a}-SO-R^{b}-, -R^{a}-SO₂-R^{b}-, -SO-R^{a}-NR^{d}-, -SO₂-R^{a}-NR^{d}-, -R^{a}-SO-R^{b}-NR^{d}-, -SO-R^{a}-NR^{d}-R^{b}-, -R^{a}-SO-R^{b}-NR^{d}-R^{c}-, -NR^{d}-R^{a}-SO-, -R^{a}-NR^{d}-R^{b}-SO-,-NR^{d}-R^{a}-SO-R^{b}-, -R^{a}-NR^{d}-R^{b}-SO-R^{c}-, -R^{a}-SO₂-R^{b}-NR^{d}-, -SO₂-R^{a}-NR^{d}-R^{b}-, -R^{a}-SO₂-R^{b}-NR^{d}-R^{c}-, -NR^{d}-R^{a}-SO₂-, -R^{a}-NR^{d}-R^{b}-SO₂-, -NR^{d}-R^{a}-SO₂-R^{b}- und -R^{a}-NR^{d}-R^{b}-SO₂-R^{c}-ist,
wobei R^{a}, R^{b} und R^{c} jeweils unabhängig voneinander ausgewählt sind aus der Gruppe bestehend aus substituiertem oder unsubstituiertem C₁₋₂₀-Alkylen, substituiertem oder unsubstituiertem C₂₋₂₀-Alkenylen, substituiertem oder unsubstituiertem C₆₋₂₀-Arylen, substituiertem oder unsubstituiertem C₇₋₃₂-Arylalkylen, substituiertem oder unsubstituiertem C₈₋₃₃-Alkylarylen und substituiertem oder unsubstituiertem C₈₋₃₃-Alkylarylalkylen, und
wobei R^{d} und R^{e} jeweils unabhängig voneinander ausgewählt sind aus der Gruppe bestehend aus Wasserstoff, Deuterium, einem substituierten oder unsubstituierten C₁₋₂₀-Alkylrest, einem substituierten oder unsubstituierten C₂₋₂₀-Alkenylrest, einem substituierten oder unsubstituierten C₆₋₂₀-Arylrest, einem substituierten oder unsubstituierten C₇₋₃₂-Arylalkylrest und einem substituierten oder unsubstituierten C₈₋₃₃-Alkylarylalkylrest, insbesondere wobei R^{d} und R^{e} jeweils Wasserstoff sind.

Bevorzugt umfassen die Reste R¹, R², R³, R⁴, R⁵, R⁶, R⁷ und R⁸ jeweils nicht mehr als 100 Kohlenstoffatome, stärker bevorzugt nicht mehr als 50 Kohlenstoffatome, noch stärker bevorzugt nicht mehr als 40 Kohlenstoffatome, noch stärker bevorzugt nicht mehr als 30 Kohlenstoffatome, noch stärker bevorzugt nicht mehr als 20 Kohlenstoffatome.

Wie im Zusammenhang mit der vorliegenden Erfindung verwendet, kann ein C₁₋₂₀-Alkylen jedes unverzweigte oder verzweigte Alkylen sein, das 1 bis 20 Kohlenstoffatome aufweist. Das unverzweigte oder verzweigte Alkylen kann linear oder zyklisch sein. Ein lineares Alkyenyl enthält bevorzugt 1 bis 10 Kohlenstoffatome. Ein zyklisches Alkylen enthält bevorzugt 4 bis 10 Kohlenstoffatome, stärker bevorzugt 5, 6 oder 7 Kohlenstoffatome. Bevorzugt ist das C₁₋₂₀-Alkylen ein -Methylen-, -Ethylen-, -n-Propylen-, -Isopropylen, -n-Butylen-, -Isobutylen-, 2-Methylpropylen-, -Pentylen-, - Hexylen-, -Heptylen-, -Octylen-, -Nonylen- oder -Decylen- oder -2,2-Dimethylbutylen-, - Cyclopropylen-, -Cyclopentylen-, -Cyclohexylen- oder -Cycloheptylen-Rest.

Hierbei kann der Rest mit jedem beliebigen der Kohlenstoffatome an die erfindungsgemäße Grundstruktur angebunden sein. Besonders bevorzugt ist ein endständiges Kohlenstoffatom, daher eine -Alkylen-Gruppe, an die erfindungsgemäße Grundstruktur angebunden.

Wie im Zusammenhang mit der vorliegenden Erfindung verwendet, kann ein C₁₋₂₀-Alkenylen jedes unverzweigte oder verzweigte Alkenylen sein, das 2 bis 20 Kohlenstoffatome aufweist. Das unverzweigte oder verzweigte Alkenylen kann linear oder zyklisch sein. Ein lineares Alkenylen enthält bevorzugt 2 bis 10 Kohlenstoffatome. Ein zyklisches Alkenylen enthält bevorzugt 4 bis 10 Kohlenstoffatome, stärker bevorzugt 5, 6 oder 7 Kohlenstoffatome. Bevorzugt ist das C₁₋₂₀-Alkenylen ein Ethenylen-, Propenylen-, Isopropenylen, 1-Butenylen-, 2-Butenylen-, 2-Methylenpropenylen-, Pentenylen-, Hexenylen-, Heptenylen-, Octenylen-, Nonenylen oder Decenylen-, 2,2-Dimethylenbutenylen-, Cyclopropenylen-, Cyclopentenylen-, Cyclohexenylen-, Cycloheptenylen- oder Cyclohex-2-enylen-Rest. Hierbei kann der Rest mit jedem beliebigen der Kohlenstoffatome an die erfindungsgemäße Grundstruktur angebunden sein. Besonders bevorzugt ist ein endständiges Kohlenstoffatom, daher eine -CH₂-Akylen- oder -CH=CH-Gruppe, an die erfindungsgemäße Grundstruktur angebunden. Die Doppelbindung kann an sich an jeder beliebigen Position befinden.

Substituiert können die im Zusammenhang der vorliegenden Erfindung genannten Reste mit jeglichen Substituenten sein. Beispielsweise können ein oder mehrere Wasserstoffatome durch Halogene (insbesondere F, Cl, Br oder I) substituiert sein. Die Substitution kann auch das Vorhandensein einer oder mehrerer beliebiger funktioneller Gruppen (beispielsweise ausgewählt aus der Gruppe bestehend aus -COOH, -OH, =O, -NH₂, =NH, =N, -C=N, -O-C≡N, -N=C=O, -SH, =S, -CSOH, -S-C≡N, -N=C=S, -OPO₃H₂) an dem Rest sein.

Bei den zyklischen Kohlenwasserstoffen kann alternativ oder zusätzlich auch ein Kohlenstoffatom (mit den daran gebundenen Wasserstoffatomen) durch ein Heteroatom (insbesondere Sauerstoff, Stickstoff oder Schwefel, daher etwa -CH₂- durch -O-, -NH-oder -S- und =CH- durch =N-) oder eine funktionelle Gruppe (insbesondere -O-, -CO-O-, -CO-NH-, -CN-O-, -CNR^{d}-O-, -S-, -CO-S-, -CS-O-, -CS-NH-, -CN-S-, -CNR^{d}-S-, wobei R^{d} wie oben definiert ist) ersetzt sein.

Stärker bevorzugt weist der Metall(I)-Komplex eine Struktur gemäß der Formel (I) oder (II) auf, wobei Y eine bivalente Gruppe ist, die zusammen mit dem Kohlenstoffatom und dem Stickstoffatom der Struktur der Formeln (I) oder (II) ein einkerniges oder mehrkerniges, substituiertes oder unsubstituiertes aromatisches Ringsystem bildet.

Noch stärker bevorzugt weist der Metall(I)-Komplex eine Struktur gemäß der Formeln (I) auf, wobei
Y eine bivalente Gruppe ist, die zusammen mit dem Kohlenstoffatom und dem Stickstoffatom der Struktur der Formeln (I) oder (II) ein einkerniges oder mehrkerniges, substituiertes oder unsubstituiertes aromatisches Ringsystem bildet; und
Z -R^{a}- ist, wobei R^{a} ein substituiertes oder unsubstituiertes C₁₋₂₀-Alkylen, ein substituiertes oder unsubstituiertes C₂₋₂₀-Alkenylen, ein substituiertes oder unsubstituiertes C₆₋₂₀-Arylen, ein substituiertes oder unsubstituiertes C₇₋₃₂-Arylalkylen, ein substituiertes oder unsubstituiertes C₈₋₃₃-Alkylarylalkylen ist.

Stark bevorzugt weist der Metall(I)-Komplex eine Struktur gemäß der Formel (I) auf, wobei
Y eine bivalente Gruppe ist, die zusammen mit dem Kohlenstoffatom und dem Stickstoffatom der Struktur der Formeln (I) oder (II) ein einkerniges oder mehrkerniges, substituiertes oder unsubstituiertes aromatisches Ringsystem bildet; und
Z -O-R^{a}-O- ist, wobei R^{a} ein substituiertes oder unsubstituiertes C₁₋₂₀-Alkylen, ein substituiertes oder unsubstituiertes C₂₋₂₀-Alkenylen, ein substituiertes oder unsubstituiertes C₆₋₂₀-Arylen, ein substituiertes oder unsubstituiertes C₇₋₃₂-Arylalkylen, ein substituiertes oder unsubstituiertes C₈₋₃₃-Alkylarylalkylen ist.

Stark bevorzugt weist der Metall(I)-Komplex eine Struktur gemäß Formel (I) oder (II) auf wobei R¹, R², R³, R⁴, R⁵, R⁶, R⁷ und R⁸ unabhängig voneinander je einen beliebigen organischen Rest, bevorzugt einen substituierten oder unsubstituierten Arylrest, einen substituierten oder unsubstituierten Alkylarylrest, einen substituierten oder unsubstituierten Arylalkylrest oder einen substituierten oder unsubstituierten C₁₋₂₀-Alkylrest, darstellen, wobei mindestens einer der Reste R¹, R², R³, R⁴, R⁵, R⁶, R⁷ und R⁸ die ionische Gruppe enthält;
wobei M Cu(I) ist;
wobei Y eine bivalente Gruppe ist, die zusammen mit dem Kohlenstoffatom und dem Stickstoffatom der Struktur der Formeln (I) oder (II) ein einkerniges oder mehrkerniges, substituiertes oder unsubstituiertes aromatisches Ringsystem bildet; und
wobei Z, soweit vorhanden, -R^{a}- oder -O-R^{a}-O- ist.

Gemäß einer stark bevorzugten Ausführungsform weist der Metall(I)-Komplex eine Struktur gemäß Formel (I) oder (II) auf, wobei Y zusammen mit dem Kohlenstoffatom und dem Stickstoffatom der Struktur der Formeln (I) oder (II) ein substituiertes oder unsubstituiertes aromatisches Ringsystem ausgewählt aus der Gruppe bestehend aus einem: Pyridinring, Oxadiazolring, Pyrrolring, Indolring, Isoindolring, Imidazolring, Triazolring, Benzimidazolring, Purinring, Pyrazolring, Indazolring, Oxazolring, Benzoxazolring, Isoxazolring, Benzisoxazolring, Thiazolring, Benzothiazolring, Chinolinring, Isochinolinring, Pyrazinring, Chinoxalinring, Pyrimidinring und Chinazolinring bildet, insbesondere zusammen mit dem Kohlenstoffatom und dem Stickstoffatom der Struktur der Formeln (I) oder (II) einen substituierten oder unsubstituierten Pyridin-, 1,3,4-Oxadiazol-, Imidazol- oder Benzimidazolring bildet.

Gemäß einer stark bevorzugten Ausführungsform weist der Metall(I)-Komplex eine Struktur gemäß Formel (I) auf, wobei Z-R^{a}- oder -O-R^{a}-O- ist.

Demgemäß weist gemäß einer stark bevorzugten Ausführungsform der Metall(I)-Komplex eine Struktur gemäß Formel (I) oder (II) auf, wobei
- Z: soweit vorhanden (daher im Falle einer Verbindung nach Formel (I)), -R^{a}-, -O-R^{a}-O- oder -O-R^{a} ist; und/oder
- Y: zusammen mit dem Kohlenstoffatom und dem Stickstoffatom der Struktur der Formeln (I) oder (II) ein substituiertes oder unsubstituiertes aromatisches Ringsystem ausgewählt aus der Gruppe bestehend aus einem Pyridinring, Oxadiazolring, Pyrrolring, Indolring, Isoindolring, Imidazolring, Triazolring, Benzimidazolring, Purinring, Pyrazolring, Indazolring, Oxazolring, Benzoxazolring, Isoxazolring, Benzisoxazolring, Thiazolring, Benzothiazolring, Chinolinring, Isochinolinring, Pyrazinring, Chinoxalinring, Pyrimidinring und Chinazolinring bildet, insbesondere zusammen mit dem Kohlenstoffatom und dem Stickstoffatom der Struktur der Formeln (I) oder (II) einen substituierten oder unsubstituierten Pyridin-, 1,3,4-Oxadiazol-, Imidazol- oder Benzimidazolring bildet.

Noch stärker bevorzugt weist der Metall(I)-Komplex eine Struktur gemäß Formel (I) auf, wobei
- Z: -R^{a}- oder -O-R^{a}-O- ist; und
- Y: zusammen mit dem Kohlenstoffatom und dem Stickstoffatom der Struktur der Formeln (I) oder (II) ein substituiertes oder unsubstituiertes aromatisches Ringsystem ausgewählt aus der Gruppe bestehend aus einem Pyridinring, Oxadiazolring, Pyrrolring, Indolring, Isoindolring, Imidazolring, Triazolring, Benzimidazolring, Purinring, Pyrazolring, Indazolring, Oxazolring, Benzoxazolring, Isoxazolring, Benzisoxazolring, Thiazolring, Benzothiazolring, Chinolinring, Isochinolinring, Pyrazinring, Chinoxalinring, Pyrimidinring und Chinazolinring bildet, insbesondere zusammen mit dem Kohlenstoffatom und dem Stickstoffatom der Struktur der Formeln (I) oder (II) einen substituierten oder unsubstituierten Pyridin-, 1,3,4-Oxadiazol-, Imidazol- oder Benzimidazolring bildet.

Noch stärker bevorzugt weist der Metall(I)-Komplex eine Struktur gemäß Formel (I) oder (II) auf
wobei R¹, R², R³, R⁴, R⁵, R⁶, R⁷ und R⁸ unabhängig voneinander je einen beliebigen organischen Rest, bevorzugt einen substituierten oder unsubstituierten Arylrest, einen substituierten oder unsubstituierten Alkylarylrest, einen substituierten oder unsubstituierten Arylalkylrest oder einen substituierten oder unsubstituierten C₁₋₂₀-Alkylrest, darstellen, wobei mindestens einer der Reste R¹, R², R³, R⁴, R⁵, R⁶, R⁷ und R⁸ die ionische Gruppe enthält;
wobei M Cu(I) ist; wobei Y zusammen mit dem Kohlenstoffatom und dem Stickstoffatom der Struktur der Formeln (I) oder (II) ein substituiertes oder unsubstituiertes aromatisches Ringsystem ausgewählt aus der Gruppe bestehend aus einem Pyridinring, Oxadiazolring, Pyrrolring, Indolring, Isoindolring, Imidazolring, Triazolring, Benzimidazolring, Purinring, Pyrazolring, Indazolring, Oxazolring, Benzoxazolring, Isoxazolring, Benzisoxazolring, Thiazolring, Benzothiazolring, Chinolinring, Isochinolinring, Pyrazinring, Chinoxalinring, Pyrimidinring und Chinazolinring bildet, insbesondere zusammen mit dem Kohlenstoffatom und dem Stickstoffatom der Struktur der Formeln (I) oder (II) einen substituierten oder unsubstituierten Pyridin-, 1,3,4-Oxadiazol-, Imidazol- oder Benzimidazolring bildet; und
wobei Z, soweit vorhanden, -R^{a}- oder -O-R^{a}-O- ist.

Gemäß einer stark bevorzugten Ausführungsform weist der Metall(I)-Komplex eine Struktur gemäß Formel (I) oder (II) auf, wobei
R¹ und/oder R³ unabhängig von einander mit mindestens einer ionischen Gruppe substituierte Arylreste sind, bevorzugt R¹ und R³ jeweils mit mindestens einer ionischen Gruppe substituierte Arylreste sind; und/oder
R², R⁴, R⁵, R⁶, R⁷ und R⁸ unsubstituierte Arylreste, Alkylreste, Arylalkylreste, Alkylarylreste oder Alkylarylalkylreste sind.

Stärker bevorzugt weist der Metall(I)-Komplex eine Struktur gemäß Formel (I) oder (II) auf, wobei R¹ und R³ jeweils mit mindestens einer ionischen Gruppe substituierte Arylreste sind; und R², R⁴, R⁵, R⁶, R⁷ und R⁸ unsubstituierte Arylreste, Alkylreste, Arylalkylreste, Alkylarylreste oder Alkylarylalkylreste sind.

Noch stärker bevorzugt weist der Metall(I)-Komplex eine Struktur gemäß Formel (I) oder (II) auf, wobei R¹ und R³ jeweils mit einer ionischen Gruppe substituierte Arylreste sind; und
R², R⁴, R⁵, R⁶, R⁷ und R⁸ unsubstituierte Arylreste sind.

Bevorzugt weist der Metall(I)-Komplex eine Struktur gemäß Formel (I) oder (II) auf wobei R¹ und R³ jeweils mit einer ionischen Gruppe substituierte Arylreste sind;
wobei R², R⁴, R⁵, R⁶, R⁷ und R⁸ unsubstituierte Arylreste sind;
wobei M ein Metall(I), bevorzugt Cu(I), Ag(I) oder Au(I), insbesondere Cu(I) ist;
wobei Y eine beliebige bivalente Gruppe ist, bevorzugt eine bivalente Gruppe, die zusammen mit dem Kohlenstoffatom und dem Stickstoffatom der Struktur der Formeln (I) oder (II) ein konjugiertes π-Elektronensystem enthält, bevorzugt eine bivalente Gruppe ist, die zusammen mit dem Kohlenstoffatom und dem Stickstoffatom der Struktur der Formeln (I) oder (II) ein einkerniges oder mehrkerniges, substituiertes oder unsubstituiertes aromatisches Ringsystem bildet; und
wobei Z, soweit vorhanden, -R^{a}- oder -O-R^{a}-O- ist.

Noch stärker bevorzugt weist der Metall(I)-Komplex eine Struktur gemäß Formel (I) oder (II) auf
wobei R¹ und R³ jeweils mit mindestens einer ionischen Gruppe substituierte Arylreste sind;
wobei R², R⁴, R⁵, R⁶, R⁷ und R⁸ unsubstituierte Arylreste, Alkylreste, , Alkylarylreste oder Alkylarylalkylreste sind;
wobei M Cu(I) ist;
wobei Y zusammen mit dem Kohlenstoffatom und dem Stickstoffatom der Struktur der Formeln (I) oder (II) ein substituiertes oder unsubstituiertes aromatisches Ringsystem ausgewählt aus der Gruppe bestehend aus einem Pyridinring, Oxadiazolring, Pyrrolring, Indolring, Isoindolring, Imidazolring, Triazolring, Benzimidazolring, Purinring, Pyrazolring, Indazolring, Oxazolring, Benzoxazolring, Isoxazolring, Benzisoxazolring, Thiazolring, Benzothiazolring, Chinolinring, Isochinolinring, Pyrazinring, Chinoxalinring, Pyrimidinring und Chinazolinring bildet, insbesondere zusammen mit dem Kohlenstoffatom und dem Stickstoffatom der Struktur der Formeln (I) oder (II) einen substituierten oder unsubstituierten Pyridin-, 1,3,4-Oxadiazol-, Imidazol- oder Benzimidazolring bildet; und
wobei Z, soweit vorhanden, -R^{a}- oder -O-R^{a}-O- ist.

Noch stärker bevorzugt weist der Metall(I)-Komplex eine Struktur gemäß Formel (I) oder (II) auf
wobei R¹ und R³ jeweils mit einer ionischen Gruppe substituierte Arylreste sind;
wobei R², R⁴, R⁵, R⁶, R⁷ und R⁸ unsubstituierte Arylreste sind;
wobei M Cu(I) ist;
wobei Y zusammen mit dem Kohlenstoffatom und dem Stickstoffatom der Struktur der Formeln (I) oder (II) ein substituiertes oder unsubstituiertes aromatisches Ringsystem ausgewählt aus der Gruppe bestehend aus einem: Pyridinring, Oxadiazolring, Pyrrolring, Indolring, Isoindolring, Imidazolring, Triazolring, Benzimidazolring, Purinring, Pyrazolring, Indazolring, Oxazolring, Benzoxazolring, Isoxazolring, Benzisoxazolring, Thiazolring, Benzothiazolring, Chinolinring, Isochinolinring, Pyrazinring, Chinoxalinring, Pyrimidinring und Chinazolinring bildet, insbesondere zusammen mit dem Kohlenstoffatom und dem Stickstoffatom der Struktur der Formeln (I) oder (II) einen substituierten oder unsubstituierten Pyridin-, 1,3,4-Oxadiazol-, Imidazol- oder Benzimidazolring bildet; und
wobei Z, soweit vorhanden, -R^{a}- oder -O-R^{a}-O- ist.

Besonders bevorzugt weist der Metall(I)-Komplex eine Struktur gemäß Formel (I) oder (II) auf
wobei R¹ und R³ jeweils mit einer ionischen Gruppe substituierte Arylreste sind;
wobei R², R⁴, R⁵, R⁶, R⁷ und R⁸ unsubstituierte Arylreste sind;
wobei M Cu(I) ist;
wobei Y zusammen mit dem Kohlenstoffatom und dem Stickstoffatom der Struktur der Formeln (I) oder (II) einen substituierten oder unsubstituierten Pyridin- oder 1,3,4-Oxadiazolring bildet; und
wobei Z, soweit vorhanden, -[C₁₋₁₀-Alkylen]- ist.

Besonders bevorzugt weist der Metall(I)-Komplex eine Struktur gemäß Formel (I) oder (II) auf
wobei R¹ und R³ jeweils mit einer ionischen Gruppe substituierte Arylreste sind;
wobei R², R⁴, R⁵, R⁶, R⁷ und R⁸ unsubstituierte Arylreste sind;
wobei M Cu(I) ist;
wobei Y zusammen mit dem Kohlenstoffatom und dem Stickstoffatom der Struktur der Formeln (I) oder (II) einen substituierten oder unsubstituierten Pyridin- oder 1,3,4-Oxadiazolring bildet; und wobei Z, soweit vorhanden, -O-[C₁₋₁₀-Alkylen]-O- ist.

Wie hierin verwendet, kann ein substituierter Pyridinring jeglicher beliebige substituierte Pyridinrest sein, der mit einem, zwei, drei oder vier beliebigen gleichen oder verschiedenen Substituenten substituiert ist. Bevorzugt ist ein Substituent hierbei ein unverzweigter oder verzweigter C₁₋₂₀-Alkylrest, bevorzugt ein unverzweigter oder verzweigter C₁₋₁₀-Alkylrest, insbesondere ein Methylrest, ein Ethylrest, ein Propylrest, ein Butylrest, ein Pentylrest, ein Hexylrest, ein Heptylrest, ein Octylrest, ein Nonylrest oder ein Decylrest. Bevorzugt ist der substituierte Pyridinring zweifach oder dreifach substituiert, insbesondere zweifach substituiert. Besonders bevorzugt ist der substituierte Pyridinring zusätzlich zu der Phosphingruppe an Kohlenstoffposition 4 substituiert. Insbesondere ist der der substituierte Pyridinring einfach mit einem C₁₋₂₀-Alkylrest an Kohlenstoffposition 4 substituiert.

Wie oben dargelegt, bildet Y in der Struktur der Formeln (I) oder (II) besonders bevorzugt zusammen mit dem Kohlenstoffatom und dem Stickstoffatom der Struktur der Formeln (I) oder (II) einen substituierten oder unsubstituierten Pyridin- oder 1,3,4-Oxadiazolring. Wie hierin verwendet, kann ein substituierter 1,3,4-Oxadiazolring jeglicher beliebige substituierte 1,3,4-Oxadiazolring sein, der mit einem Substituenten substituiert ist. Bevorzugt ist ein Substituent hierbei ein C₁₋₂₀-Alkylrest, insbesondere ein Methylrest, ein Ethylrest, ein Propylrest, ein Butylrest, ein Pentylrest, ein Hexylrest, ein Heptylrest, ein Octylrest, ein Nonylrest oder ein Decylrest. Wie hierin verwendet kann der Pyridinring einfach oder zweifach substituiert sein, insbesondere einfach substituiert sein. Besonders bevorzugt ist der substituierte Pyridinring an Kohlenstoffposition 4 substituiert. Insbesondere ist der der substituierte Pyridinring mit einem C₁₋₂₀-Alkylrest an Kohlenstoffposition 4 substituiert.

Beispielhaft kann der Metall(I)-Komplex ein Cu(I)-Komplex einer Struktur gemäß Formel (I) oder (II) sein, wobei R², R⁴, R⁵, R⁶, R⁷ und R⁸ jeweils ein unsubstituierter Arylrest ist und Y zusammen mit dem Kohlenstoffatom und dem Stickstoffatom der Struktur der Formel(I) einen Ring ausgewählt aus der Gruppe bestehend aus:
a) einem unsubstituierten Pyridinring,
b) einem an Position 4 Methyl-substituierten Pyridinring,
c) einem an Position 4 Ethyl-substituierten Pyridinring,
d) einem an Position 4 Propyl-substituierten Pyridinring,
e) einem an Position 4 Butyl-substituierten Pyridinring,
f) einem an Position 4 Pentyl-substituierten Pyridinring,
g) einem an Position 4 Hexyl-substituierten Pyridinring,
h) einem an Position 4 Heptyl-substituierten Pyridinring,
i) einem an Position 4 Octyl-substituierten Pyridinring,
j) einem an Position 4 Nonyl-substituierten Pyridinring und
k) einem an Position 4 Decyl-substituierten Pyridinring, bildet
und, worin die übrigen Reste, soweit vorhanden (daher Z ist nur in einer Struktur gemäß Formel (II) vorhanden) definiert sind als:

| R¹ ein Arylrest (bevorzugt in meta-Position) substituiert mit: | R³ ein Arylrest (bevorzugt in meta-Position) substituiert mit: | Z |
|---|---|---|
| -SO₃⁻ | unsubstituiert | -R^{a}- |
| -SO₃⁻ | unsubstituiert | -O-R^{a}-O- |
| -SO₃⁻ | unsubstituiert | -O-R^{a}- |
| -SO₃⁻ | unsubstituiert | -NH-R^{a}-NH- |
| -SO₃⁻ | unsubstituiert | -N=CH-NH- |
| -SO₃⁻ | unsubstituiert | -HN-CH=N- |
| -SO₃⁻ | unsubstituiert | -R^{a}-N=N- |
| -SO₃⁻ | unsubstituiert | -O-R^{a}-NH- |
| -SO₃⁻ | unsubstituiert | -NH-R^{a}-O- |
| -PO₃⁻ | unsubstituiert | -R^{a}- |
| -PO₃⁻ | unsubstituiert | -O-R^{a}-O- |
| -PO₃⁻ | unsubstituiert | -O-R^{a}- |
| -PO₃⁻ | unsubstituiert | -NH-R^{a}-NH- |
| -PO₃⁻ | unsubstituiert | -N=CH-NH- |
| -PO₃⁻ | unsubstituiert | -HN-CH=N- |
| -PO₃⁻ | unsubstituiert | -R^{a}-N=N- |
| -PO₃⁻ | unsubstituiert | -O-R^{a}-NH- |
| -PO₃⁻ | unsubstituiert | -NH-R^{a}-O- |
| -COO⁻ | unsubstituiert | -R^{a}- |
| -COO⁻ | unsubstituiert | -O-R^{a}-O- |
| -COO⁻ | unsubstituiert | -O-R^{a}- |
| -COO⁻ | unsubstituiert | -NH-R^{a}-NH- |
| -COO⁻ | -N=CH-NH- | -N=CH-NH- |
| -COO⁻ | unsubstituiert | -HN-CH=N- |
| -COO⁻ | unsubstituiert | -R^{a}-N=N- |
| -COO⁻ | unsubstituiert | -O-R^{a}-NH- |
| -COO⁻ | unsubstituiert | -NH-R^{a}-O- |
| -NH₃⁺ | unsubstituiert | -R^{a}- |
| -NH₃⁺ | unsubstituiert | -O-R^{a}-O- |
| -NH₃⁺ | unsubstituiert | -O-R^{a}- |
| -NH₃⁺ | unsubstituiert | -NH-R^{a}-NH- |
| -NH₃⁺ | unsubstituiert | -N=CH-NH- |
| -NH₃⁺ | unsubstituiert | -HN-CH=N- |
| -NH₃⁺ | unsubstituiert | -R^{a}-N=N- |
| -NH₃⁺ | unsubstituiert | -O-R^{a}-NH- |
| -NH₃⁺ | Unsubstituiert | -NH-R^{a}-O- |
| unsubstituiert | -SO₃⁻ | -R^{a}- |
| unsubstituiert | -SO₃⁻ | -O-R^{a}-O- |
| unsubstituiert | -SO₃⁻ | -O-R^{a}- |
| unsubstituiert | -SO₃⁻ | -NH-R^{a}-NH- |
| unsubstituiert | -SO₃⁻ | -N=CH-NH- |
| unsubstituiert | -SO₃⁻ | -HN-CH=N- |
| unsubstituiert | -SO₃⁻ | -R^{a}-N=N- |
| unsubstituiert | -SO₃⁻ | -O-R^{a}-NH- |
| unsubstituiert | -SO₃⁻ | -NH-R^{a}-O- |
| -SO₃⁻ | -SO₃⁻ | -R^{a}- |
| -SO₃⁻ | -SO₃⁻ | -O-R^{a}-O- |
| -SO₃⁻ | -SO₃⁻ | -O-R^{a}- |
| -SO₃⁻ | -SO₃⁻ | -NH-R^{a}-NH- |
| -SO₃⁻ | -SO₃⁻ | -N=CH-NH- |
| -SO₃⁻ | -SO₃⁻ | -HN-CH=N- |
| -SO₃⁻ | -SO₃⁻ | -R^{a}-N=N- |
| -SO₃⁻ | -SO₃⁻ | -O-R^{a}-NH- |
| -SO₃⁻ | -SO₃⁻ | -NH-R^{a}-O- |
| -PO₃⁻ | -SO₃⁻ | -R^{a}- |
| -PO₃⁻ | -SO₃⁻ | -O-R^{a}-O- |
| -PO₃⁻ | -SO₃⁻ | -O-R^{a}- |
| -PO₃⁻ | -SO₃⁻ | -NH-R^{a}-NH- |
| -PO₃⁻ | -SO₃⁻ | -N=CH-NH- |
| -PO₃⁻ | -SO₃⁻ | -HN-CH=N- |
| -PO₃⁻ | -SO₃⁻ | -R^{a}-N=N- |
| -PO₃⁻ | -SO₃⁻ | -O-R^{a}-NH- |
| -PO₃⁻ | -SO₃⁻ | -NH-R^{a}-O- |
| -COO⁻ | -SO₃⁻ | -R^{a}- |
| -COO⁻ | -SO₃⁻ | -O-R^{a}-O- |
| -COO⁻ | -SO₃⁻ | -O-R^{a}- |
| -COO⁻ | -SO₃⁻ | -NH-R^{a}-NH- |
| -COO⁻ | -SO₃⁻ | -N=CH-NH- |
| -COO⁻ | -SO₃⁻ | -HN-CH=N- |
| -COO⁻ | -SO₃⁻ | -R^{a}-N=N- |
| -COO⁻ | -SO₃⁻ | -O-R^{a}-NH- |
| -COO⁻ | -SO₃⁻ | -NH-R^{a}-O- |
| -NH₃⁺ | -SO₃⁻ | -R^{a}- |
| -NH₃⁺ | -SO₃⁻ | -O-R^{a}-O- |
| -NH₃⁺ | -SO₃⁻ | -O-R^{a}- |
| -NH₃⁺ | -SO₃⁻ | -NH-R^{a}-NH- |
| -NH₃⁺ | -SO₃⁻ | -N=CH-NH- |
| -NH₃⁺ | -SO₃⁻ | -HN-CH=N- |
| -NH₃⁺ | -SO₃⁻ | -R^{a}-N=N- |
| -NH₃⁺ | -SO₃⁻ | -O-R^{a}-NH- |
| -NH₃⁺ | -SO₃⁻ | -NH-R^{a}-O- |
| unsubstituiert | -SO₃⁻ | -R^{a}- |
| unsubstituiert | -SO₃⁻ | -O-R^{a}-O- |
| unsubstituiert | -SO₃⁻ | -O-R^{a}- |
| unsubstituiert | -SO₃⁻ | -NH-R^{a}-NH- |
| unsubstituiert | -SO₃⁻ | -N=CH-NH- |
| unsubstituiert | -SO₃⁻ | -HN-CH=N- |
| unsubstituiert | -SO₃⁻ | -R^{a}-N=N- |
| unsubstituiert | -SO₃⁻ | -O-R^{a}-NH- |
| unsubstituiert | -SO₃⁻ | -NH-R^{a}-O- |
| -SO₃⁻ | -PO₃⁻ | -R^{a}- |
| -SO₃⁻ | -PO₃⁻ | -O-R^{a}-O- |
| -SO₃⁻ | -PO₃⁻ | -O-R^{a}- |
| -SO₃⁻ | -PO₃⁻ | -NH-R^{a}-NH- |
| -SO₃⁻ | -PO₃⁻ | -N=CH-NH- |
| -SO₃⁻ | -PO₃⁻ | -HN-CH=N- |
| -SO₃⁻ | -PO₃⁻ | -R^{a}-N=N- |
| -SO₃⁻ | -PO₃⁻ | -O-R^{a}-NH- |
| -SO₃⁻ | -PO₃⁻ | -NH-R^{a}-O- |
| -PO₃⁻ | -PO₃⁻ | -R^{a}- |
| -PO₃⁻ | -PO₃⁻ | -O-R^{a}-O- |
| -PO₃⁻ | -PO₃⁻ | -O-R^{a}- |
| -PO₃⁻ | -PO₃⁻ | -NH-R^{a}-NH- |
| -PO₃⁻ | -PO₃⁻ | -N=CH-NH- |
| -PO₃⁻ | -PO₃⁻ | -HN-CH=N- |
| -PO₃⁻ | -PO₃⁻ | -Ra-N=N- |
| -PO₃⁻ | -PO₃⁻ | -O-R^{a}-NH- |
| -PO₃⁻ | -PO₃⁻ | -NH-R^{a}-O- |
| -COO⁻ | -PO₃⁻ | -R^{a}- |
| -COO⁻ | -PO₃⁻ | -O-R^{a}-O- |
| -COO⁻ | -PO₃⁻ | -O-R^{a}- |
| -COO⁻ | -PO₃⁻ | -NH-R^{a}-NH- |
| -COO⁻ | -PO₃⁻ | -N=CH-NH- |
| -COO⁻ | -PO₃⁻ | -HN-CH=N- |
| -COO⁻ | -PO₃⁻ | -R^{a}-N=N- |
| -COO⁻ | -PO₃⁻ | -O-R^{a}-NH- |
| -COO⁻ | -PO₃⁻ | -NH-R^{a}-O- |
| -NH₃⁺ | -PO₃⁻ | -R^{a}- |
| -NH₃⁺ | -PO₃⁻ | -O-R^{a}-O- |
| -NH₃⁺ | -PO₃⁻ | -O-R^{a}- |
| -NH₃⁺ | -PO₃⁻ | -NH-R^{a}-NH- |
| -NH₃⁺ | -PO₃⁻ | -N=CH-NH- |
| -NH₃⁺ | -PO₃⁻ | -HN-CH=N- |
| -NH₃⁺ | -PO₃⁻ | -R^{a}-N=N- |
| -NH₃⁺ | -PO₃⁻ | -O-R^{a}-NH- |
| -NH₃⁺ | -PO₃⁻ | -NH-R^{a}-O- |
| unsubstituiert | -SO₃⁻ | -R^{a}- |
| unsubstituiert | -SO₃⁻ | -O-R^{a}-O- |
| unsubstituiert | -SO₃⁻ | -O-R^{a}- |
| unsubstituiert | -SO₃⁻ | -NH-R^{a}-NH- |
| unsubstituiert | -SO₃⁻ | -N=CH-NH- |
| unsubstituiert | -SO₃⁻ | -HN-CH=N- |
| unsubstituiert | -SO₃⁻ | -R^{a}-N=N- |
| unsubstituiert | -SO₃⁻ | -O-R^{a}-NH- |
| unsubstituiert | -SO₃⁻ | -NH-R^{a}-O- |
| -SO₃⁻ | -COO⁻ | -R^{a}- |
| -SO₃⁻ | -COO⁻ | -O-R^{a}-O- |
| -SO₃⁻ | -COO⁻ | -O-R^{a}- |
| -SO₃⁻ | -COO⁻ | -NH-R^{a}-NH- |
| -SO₃⁻ | -COO⁻ | -N=CH-NH- |
| -SO₃⁻ | -COO⁻ | -HN-CH=N- |
| -SO₃⁻ | -COO⁻ | -R^{a}-N=N- |
| -SO₃⁻ | -COO⁻ | -O-R^{a}-NH- |
| -SO₃⁻ | -COO⁻ | -NH-R^{a}-O- |
| -PO₃⁻ | -COO⁻ | -R^{a}- |
| -PO₃⁻ | -COO⁻ | -O-R^{a}-O- |
| -PO₃⁻ | -COO⁻ | -O-R^{a}- |
| -PO₃⁻ | -COO⁻ | -NH-R^{a}-NH- |
| -PO₃⁻ | -COO⁻ | -N=CH-NH- |
| -PO₃⁻ | -COO⁻ | -HN-CH=N- |
| -PO₃⁻ | -COO⁻ | -R^{a}-N=N- |
| -PO₃⁻ | -COO⁻ | -O-R^{a}-NH- |
| -PO₃⁻ | -COO⁻ | -NH-R^{a}-O- |
| -COO⁻ | -COO⁻ | -R^{a}- |
| -COO⁻ | -COO⁻ | -O-R^{a}-O- |
| -COO⁻ | -COO⁻ | -O-R^{a}- |
| -COO⁻ | -COO⁻ | -NH-R^{a}-NH- |
| -COO⁻ | -COO⁻ | -N=CH-NH- |
| -COO⁻ | -COO⁻ | -HN-CH=N- |
| -COO⁻ | -COO⁻ | -R^{a}-N=N- |
| -COO⁻ | -COO⁻ | -O-R^{a}-NH- |
| -COO⁻ | -COO⁻ | -NH-R^{a}-O- |
| -NH₃⁺ | -COO⁻ | -R^{a}- |
| -NH₃⁺ | -COO⁻ | -O-R^{a}-O- |
| -NH₃⁺ | -COO⁻ | -O-R^{a}- |
| -NH₃⁺ | -COO⁻ | -NH-R^{a}-NH- |
| -NH₃⁺ | -COO⁻ | -N=CH-NH- |
| -NH₃⁺ | -COO⁻ | -HN-CH=N- |
| -NH₃⁺ | -COO⁻ | -R^{a}-N=N- |
| -NH₃⁺ | -COO⁻ | -O-R^{a}-NH- |
| -NH₃⁺ | -COO⁻ | -NH-R^{a}-O- |
| unsubstituiert | -SO₃⁻ | -R^{a}- |
| unsubstituiert | -SO₃⁻ | -O-R^{a}-O- |
| unsubstituiert | -SO₃⁻ | -O-R^{a}- |
| unsubstituiert | -SO₃⁻ | -NH-R^{a}-NH- |
| unsubstituiert | -SO₃⁻ | -N=CH-NH- |
| unsubstituiert | -SO₃⁻ | -HN-CH=N- |
| unsubstituiert | -SO₃⁻ | -R^{a}-N=N- |
| unsubstituiert | -SO₃⁻ | -O-R^{a}-NH- |
| unsubstituiert | -SO₃⁻ | -NH-R^{a}-O- |
| -SO₃⁻ | -NH₃⁺ | -R^{a}- |
| -SO₃⁻ | -NH₃⁺ | -O-R^{a}-O- |
| -SO₃⁻ | -NH₃⁺ | -O-R^{a}- |
| -SO₃⁻ | -NH₃⁺ | -NH-R^{a}-NH- |
| -SO₃⁻ | -NH₃⁺ | -N=CH-NH- |
| -SO₃⁻ | -NH₃⁺ | -HN-CH=N- |
| -SO₃⁻ | -NH₃⁺ | -R^{a}-N=N- |
| -SO₃⁻ | -NH₃⁺ | -O-R^{a}-NH- |
| -SO₃⁻ | -NH₃⁺ | -NH-R^{a}-O- |
| -PO₃⁻ | -NH₃⁺ | -R^{a}- |
| -PO₃⁻ | -NH₃⁺ | -O-R^{a}-O- |
| -PO₃⁻ | -NH₃⁺ | -O-R^{a}- |
| -PO₃⁻ | -NH₃⁺ | -NH-R^{a}-NH- |
| -PO₃⁻ | -NH₃⁺ | -N=CH-NH- |
| -PO₃⁻ | -NH₃⁺ | -HN-CH=N- |
| -PO₃⁻ | -NH₃⁺ | -R^{a}-N=N- |
| -PO₃⁻ | -NH₃⁺ | -O-R^{a}-NH- |
| -PO₃⁻ | -NH₃⁺ | -NH-R^{a}-O- |
| -COO⁻ | -NH₃⁺ | -R^{a}- |
| -COO⁻ | -NH₃⁺ | -O-R^{a}-O- |
| -COO⁻ | -NH₃⁺ | -O-R^{a}- |
| -COO⁻ | -NH₃⁺ | -NH-R^{a}-NH- |
| -COO⁻ | -NH₃⁺ | -N=CH-NH- |
| -COO⁻ | -NH₃⁺ | -HN-CH=N- |
| -COO⁻ | -NH₃⁺ | -R^{a}-N=N- |
| -COO⁻ | -NH₃⁺ | -O-R^{a}-NH- |
| -COO⁻ | -NH₃⁺ | -NH-R^{a}-O- |
| -NH₃⁺ | -NH₃⁺ | -R^{a}- |
| -NH₃⁺ | -NH₃⁺ | -O-R^{a}-O- |
| -NH₃⁺ | -NH₃⁺ | -O-R^{a}- |
| -NH₃⁺ | -NH₃⁺ | -NH-R^{a}-NH- |
| -NH₃⁺ | -NH₃⁺ | -N=CH-NH- |
| -NH₃⁺ | -NH₃⁺ | -HN-CH=N- |
| -NH₃⁺ | -NH₃⁺ | -R^{a}-N=N- |
| -NH₃⁺ | -NH₃⁺ | -O-R^{a}-NH- |
| -NH₃⁺ | -NH₃⁺ | -NH-R^{a}-O- |

Hier bei ist R^{a} wie oben definiert, bevorzugt ein unsubstituiertes C₄₋₇-Alkylen, oder ein - O-C₆-Aryl-O-, bei dem die -O-Gruppen in Paraposition zueinander stehen, ist, insbesondere Pentylen, Hexylen oder -O-C₆-Aryl-O-, bei dem die -O-Gruppen in Paraposition zueinander stehen.

Gemäß einer noch stärker bevorzugten Ausführungsform weist der Metall(I)-Komplex eine Struktur gemäß einer der folgenden Formeln (III) oder (IV) auf: 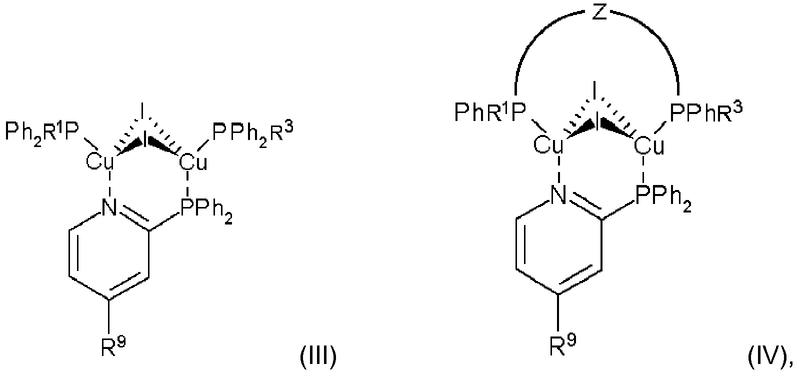 wobei Z wie oben definiert ist, insbesondere wobei Z ein unsubstitutierter C₄-₇-Alkylrest oder -O-Aryl-O- ist;
wobei R¹ und R³ jeweils mit mindestens einer ionischen Gruppe substituierte Arylreste sind; und
wobei R⁹ ein beliebiger Rest ist, bevorzugt wobei R⁹ ein C₁₋₂₀-Alkyl oder H ist, insbesondere wobei R⁹ ein C₁₋₁₀-Alkyl ist.

Die ionische Gruppe kann hierbei wie oben ausgeführt definiert sein.

Gemäß einer bevorzugten Ausführungsform sind die ionischen Gruppen hierbei unabhängig von einander ausgewählt aus der Gruppe bestehend aus -SO₃⁻, -PO₃⁻,-COO⁻, -NH₃⁺, einer am Liganden L gebundenen Guanidiniumgruppe oder einer am Liganden L gebundenen Imidazoiliumgruppe.

Besonders bevorzugt ist die ionische Gruppe hierbei eine -SO₃⁻-Gruppe, insbesondere wobei die -SO₃⁻-Gruppe als Alkalimetall- oder Erdalkalimetallsalz vorliegt.

Beispielshaft werden oben weitere Kationen und Anionen aufgeführt, die als Gegenion des Salzes dienen können.

Bevorzugt sind R¹ und R³ jeweils mit mindestens einer -SO₃⁻-Gruppe substituiert und R⁹ ist ein C₁₋₁₀-Alkyl.

Noch stärker bevorzugt weist der Metall(I)-Komplex eine Struktur gemäß Formel (IV) auf,
wobei Z ein unsubstitutierter C₄-₇-Alkylrest oder -O-Aryl-O- ist;
wobei R¹ und R³ jeweils mit mindestens einer -SO₃⁻-Gruppe substituiert sind; und wobei R⁹ ein C₁₋₁₀-Alkyl ist.

Noch stärker bevorzugt weist der Metall(I)-Komplex eine Struktur gemäß Formel (IV) auf,
wobei Z ein unsubstitutierter C₄-₇-Alkylrest oder -O-Aryl-O- ist;
wobei R¹ und R³ jeweils in meta-Position mit mindestens einer -SO₃⁻-Gruppe substituiert sind; und wobei R⁹ ein C₁₋₁₀-Alkyl ist.

Gemäß einer ganz besonders bevorzugten Ausführungsform weist der Metall(I)-Komplex eine Struktur gemäß einer der folgenden Formel (V) auf: 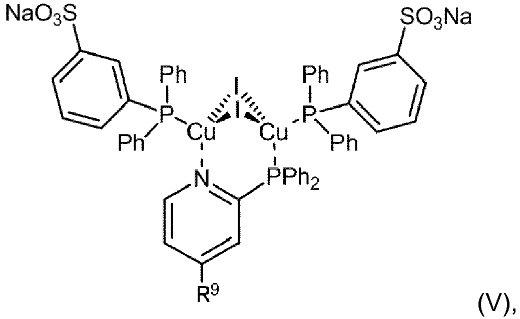 wobei R⁹ ein beliebiger Rest ist, bevorzugt wobei R⁹ ein C₁₋₂₀-Alkyl oder H ist, insbesondere wobei R⁹ ein C₁₋₁₀-Alkyl oder H ist.

Der erfindungsgemäße Metall(I)-Komplex kann als lichtemittierende Verbindung und/oder als lichtabsorbierende, ladungstrennende Verbindung verwendet werden, insbesondere als lichtemittierende Verbindung. Da der Metall(I)-Komplex in der Lage ist unter geeigneten Bedingungen Licht zu emittieren, kann er im Kontext der vorliegenden Erfindung auch als Emitterverbindung E bezeichnet werden. Im Sinne der vorliegenden Erfindung ist eine derartige Emitterverbindung E im weitesten Sinne zu verstehen als jede Verbindung, die in der Lage ist, unter bestimmten Bedingungen in einer opto-elektronischen Vorrichtung Licht zu emittieren.

Die Emitterverbindung E kann demnach tatsächlich verwendet werden, um Licht zu erzeugen. Sie kann aber auch anders verwendet werden, etwa um Licht zu absorbieren und in elektrische Energie (Ladungstrennung und/oder Stromfluss) umzuwandeln.

Der Metall(I)-Komplex kann folglich als Emitterverbindung E in einer Emitterschicht B eingesetzt werden. Dazu kann die Verbindung zusammen mit anderen Verbindungen in einer Zusammensetzung verwendet werden.

Eine Emitterschicht B im Sinne der vorliegenden Erfindung ist im weitesten Sinne zu verstehen als jede Schicht, die in der Lage ist, unter bestimmten Bedingungen in einer opto-elektronischen Vorrichtung Licht zu emittieren. Die Emitterschicht B kann demnach tatsächlich verwendet werden, um Licht zu erzeugen. Sie kann aber auch anders verwendet werden, etwa um Licht zu absorbieren und in elektrische Energie umzuwandeln. Ganz besonders bevorzugt ist die Emitterschicht B eine lichtemittierende Schicht in einer lichtemittierenden elektrochemischen Zelle.

Daher betrifft ein weiterer Aspekt der vorliegenden Erfindung ein Zusammensetzung Z enthaltend:
(a) mindestens einen Metall(I)-Komplex gemäß der vorliegenden Erfindung; und
(b) eine ionische Flüssigkeit, ein oder mehrere Salze und/oder ein oder mehrere polymere Komponent(en).

So kann die Zusammensetzung Z etwa zusätzlich ein Salz enthalten. Beispielsweise können die in der Zusammensetzung Z enthaltenen Salze auf einem oder mehreren der folgenden Anionen basieren: Halogeniden (z.B. Chlorid, Iodid, Bromid, Fluorid), Cyanaten, losothiocyanaten, BF₄⁻, Isocyanaten, Phosphaten, Hydrogenphosphaten, Sulfaten, Boraten, Perchloraten, Interhalogeniden (beispielsweisewie IBr₂⁻), Aluminaten, Wolframaten, Molybdaten oder organischen Anionen (z.B. ein R*-COO-, R*-SO₃⁻ usw.), wobei R* Wasserstoff, ein beliebiger unverzweigter oder verzweigter, optional substituierter C₁₋₂₀-Alkylrest, ein beliebiger unverzweigter oder verzweigter, optional substituierter C₂₋₂₀-Alkenylrest, ein beliebiger unverzweigter oder verzweigter, optional substituierter C₂₋₂₀-Alkinylrest, ein beliebiger optional substituierter aliphatischer oder aromatischer C₅₋₂₀-Zyklus sein kann.

Beispielsweise können die in der Zusammensetzung Z enthaltenen Salze auf einem oder mehreren der folgenden Kationen basieren: Alkalimetallionnen (z.B. Na⁺, K⁺, Li⁺, Rb⁺, Cs⁺), Erdalkalimetallionen (z.B. Mg²⁺, Ca²⁺, Sr²⁺, Ba²⁺, Be²⁺), Zn²⁺, Cd²⁺, NR*₄⁺, [R*-(CN₃H₅)]⁺ (Guanidinium), einer positiv geladenen substituierten oder unsubstituierten, aliphatischen oder aromatischen C₂₋₂₀-mono-, di- oder trizyklischen Verbindung und einer positiv geladenen substituierten oder unsubstituierten, aliphatischen oder aromatischen Heterozyklus (z.B. einem Imidazoliumion, Oxoniumkation, Phosphoniumkation),
wobei R* Wasserstoff, ein beliebiger unverzweigter oder verzweigter, optional substituierter C₁₋₂₀-Alkylrest, ein beliebiger unverzweigter oder verzweigter, optional substituierter C₂₋₂₀-Alkenylrest, ein beliebiger unverzweigter oder verzweigter, optional substituierter C₂₋₂₀-Alkinylrest, ein beliebiger optional substituierter aliphatischer oder aromatischer C₅₋₂₀-Zyklus sein kann.

Beispielsweise kann die Zusammensetzung NaCl, KCl, MgCl₂, CaCl₂, LiCl, NH₄Cl, NaBr, KBr, MgBr₂, CaBr₂, LiBr, NH₄Br, Nal, KI, MgI₂, CaI₂, NH₄I, NaCN, KCN, Mg(CN)₂, Ca(CN)₂, LiCN, NaSCN, KSCN, Mg(SCN)₂, Ca(SCN)₂, NH₄SCN und/oder LiI enthalten.

Ferner betrifft ein Aspekt der vorliegenden Erfindung eine Emitterschicht B enthaltend einen Metall(I)-Komplex oder eine Zusammensetzung gemäß der vorliegenden Erfindung.

Bei der Emitterschicht B handelt es sich bevorzugt um eine organische lichtemittierende Schicht, die überwiegend aus organischen Werkstoffen besteht, die mit Heteroatomen wie Stickstoff, Phosphor, Sauerstoff und/oder Halogenen substituiert sein können. Mindestens einer der organischen Werkstoffe stellt einen Ligand L des Metall(I)-Komplexes im Sinne der vorliegenden Erfindung dar. Optional kann die Emitterschicht B zudem fluoreszente Polymere (z.B. Superyellow (SY)), photolumineszierende Nanopartikel (etwa aus Silizium), Quantenpunkte (engl. "quantum dots"), Cadmiumselenid und/oder Exciplexe, optional verdünnt mit Wirtsmolekülen (engl. "hosts"), enthalten. Es können beispielhaft solche wie in WO 2013/007709 oder WO 2013/007710 beschriebene Wirtsmoleküle W verwendet werden, die auch unkonjugiert vorliegen können. Insbesondere zur Herstellung von LECs können auch Guanidium-Verbindungen wie in WO 2012/130571 beschrieben und/oder Polyethylenoxid verwendet werden.

Unter einer Schicht im Sinne der vorliegenden Erfindung ist bevorzugt eine weitgehend planare Geometrie zu verstehen. Die Emitterschicht B ist bevorzugt nicht dicker als 200 µm, stärker bevorzugt nicht dicker als 100 µm, nicht dicker als 10 µm oder nicht dicker als 5 µm, noch stärker bevorzugt nicht dicker als 3 µm, insbesondere nicht dicker als 2 µm.

Zur Erzeugung von Licht der Emitterschicht B, die in ein Teil einer opto-elektronischen Vorrichtung darstellt, wird typischerweise elektrisch Energie zugeführt. Zur Zuführung von Energie kann Strom angeschlossen werden, wobei der Stromfluss durch die Emitterschicht B die darin enthaltenen Emitterverbindungen E so anregt, dass sogenannte Exzitone entstehen, die unter Abstrahlung von Licht in den Grundzustand relaxieren können.

Der Aufbau von möglichen opto-elektronischen Vorrichtungen ist dem Fachmann wohlbekannt und ist zudem unten stehend beispielhaft erläutert.

Der Anteil an Metall(I)-Komplex in der Emitterschicht B kann bei 0,1 bis 100 Gew.-% liegen. Demnach kann die Emitterschicht B vollständig oder weitgehend aus dem Metall(I)-Komplex bestehen oder aber den Metall(I)-Komplex nur als kleinen oder großen Anteil neben anderen Verbindungen einem oder mehreren Wirtsmolekülen W (engl. "hosts") enthalten. Bei LECs etwa liegt der Anteil an Metall(I)-Komplex in der Emitterschicht B bevorzugt bei 0,1 bis 100 Gew.-%.

Bei vielen opto-elektronischen Vorrichtungen, wie etwa LECs, liegt der Anteil an Metall(I)-Komplex in der Emitterschicht B bevorzugt bei mehr als 30 Gew.-%, mehr als 40 Gew.-%, mehr als 50 Gew.-%, mehr als 60 Gew.-%, mehr als 70 Gew.-%, mehr als 80 Gew.-% oder mehr als 90 Gew.-%.

Die Emitterschicht B kann zusätzlich einen Farbstoff F enthalten. Hierbei kann jeder gewünschte Farbstoff F oder auch eine Farbstoffkombination eingesetzt werden. Der Farbstoff F kann auch ein fluoreszenter und/oder phosphoreszenter Farbstoff F sein, der das Emissions- und/oder Absorptionsspektrum der Emitterschicht B verschieben kann. Optional können auch Diphoton-Effekte genutzt werden, daher das Absorbieren zweier Photonen mit der Hälfte der Energie des Absorptionsmaximums. Durch einen fluoreszenten und/oder phosphoreszenten Farbstoff F wird meist ein bathochromer Effekt erzielt (etwa durch Wärmeverluste). Es kann jedoch auch ein hypsochromer Effekt erzielt werden (etwa durch Diphoton-Effekte).

Die Emitterschicht B kann zusätzlich, besonders wenn es sich bei der opto-elektronischen Vorrichtung um eine LEC handelt, eine ionische Flüssigkeit oder eine Kombination von zwei oder mehr ionischen Flüssigkeiten enthalten. Beispielsweise kann eine solche ionische Flüssigkeit oder Kombination von zwei oder mehr ionischen Flüssigkeiten ausgewählt sein aus der Gruppe bestehend aus:
Methyl-imidazoliumhexafluorophosphaten (z.B. 1-Alkyl-3-methyl-imidazoliumhexafluorophosphat wie beispielsweise 1-Methyl-3-methyl-imidazoliumhexafluorophosphat, 1-Ethyl-3-methyl-imidazoliumhexafluorophosphat, 1-Propyl-3-methyl-imidazoliumhexafluorophosphat, 1-Butyl-3-methyl-imidazoliumhexafluorophosphat, 1-Benzyl-3-methylimidazolinium-Hexafluorophosphat), Dimethyl-imidazoliumhexafluorophosphaten (z.B. 1-Alkyl-2,3-dimethyl-imidazoliumhexafluorophosphate wie beispielsweise 1-Butyl-2,3-dimethyl-imidazoliumhexafluorophosphat), 3-Methyl-imidazoliumhexafluorophosphaten (z.B. 1-Alkyl-methyl-imidazoliumhexafluorophosphate wie beispielsweise 1-Methyl-3-methyl-imidazoliumhexafluorophosphat, 1-Ethyl-3-methyl-imidazoliumhexafluorophosphat, 1-Propyl-3-methyl-imidazoliumhexafluorophosphat, 1-Butyl-3-Methyl-imidazoliumhexafluorophosphat, 1-Pentyl-3-methyl-imidazoliumhexafluorophosphat, 1-Hexyl-3-methyl-imidazoliumhexafluorophosphat), 1-Butyl-1-(3,3,4,4,5,5,6,6,7,7,8,8,8-tridecafluorooctyl)-imidazoliumhexafluorophosphat, 1-Methyl-3-(3,3,4,4,5,5,6,6,7,7,8,8,8-tridecafluorooctyl)-imidazoliumhexafluorophosphat, 1-Methyl-3-octyl-imidazoliumhexafluorophosphat, Methyl-imidazoliumtetrafluoroboraten (z.B. 1,3-Dimethyl-imidazoliumtetrafluoroborat, 1-Ethyl-3-methyl-imidazoliumtetrafluoroborat, 1-Propyl-3-methyl-imidazoliumtetrafluoroborat, 1-Butyl-3-methyl-imidazoliumtetrafluoroborat), 1-Butyl-2,3-dimethyl-imidazoliumtetrafluoroborat, 1-Hexyl-3-methyl-imidazoliumtetrafluoroborat, 1-Methyl-3-octyl-imidazoliumtetrafluoroborat, Methy-limidazoliumtrifluoromethanesulfonaten (z.B. 1-Methyl-3-methyl-imidazoliumtrifluoromethanesulfonat, 1-Ethyl-3-methyl-imidazoliumtrifluoromethanesulfonat, 1-Propyl-3-methyl-imidazoliumtrifluoromethanesulfonat, 1-Butyl-3-methy-limidazoliumtrifluoromethanesulfonat), 1,2,3-Trimethyl-imidazoliumtrifluoromethanesulfonat, 1-Ethyl-3-methyl-imidazolium-bis(pentafluoroethylsulfonyl)imid, 1-Butyl-3-methylimidazolium-bis(trifluoromethylsulfonyl)imid, 1-Butyl-3-methyl-imidazoliummethanesulfonat, Tetrabutyl-ammonium-bis-trifluoromethanesulfonimidat, Tetrabutylammoniummethanesulfonat, Tetrabutyl-ammonium nonafluorobutanesulfonate Tetrabutyl-ammoniumheptadecafluorooetanesulfonat, Tetrahexyl-ammonium tetrafluoroborat, Tetrabutyl-ammoniumtrifluoromethanesulfonat, Tetrabutylammoniumbenzoate, Tetrabutyl-ammoniumhalogenide (z.B. Tetrabutyl-ammoniumchlorid, Tetrabutyl-ammoniumbromid), 1-Benzyl-3-methyl-imidazoliumtetrafluoroborat, Trihexyl-tetradecylphosphoniumhexafluorophosphate, Tetrabutyl-phosphoniummethanesulfonate,Tetrabutyl-phosphoniumtetrafluoroborate,Tetrabutyl-phosphoniumbromid,1-Butyl-3-methylpyridinium-bis(trifluormethylsulfonyl)imid, 1-Butyl-4-methylpyridiniumhexafluorophosphat, 1-Butyl-4-methylpyridiniumtetrafluoroborat, Natriumtetraphenylborat, Tetrabutyl-ammoniumtetraphenylborat, Natriumtetrakis(1-imidazolyl)borat und Cäsiumtetraphenylborat.

Zusätzlich oder alternativ kann die Emitterschicht B einen oder mehrere Elektrolyten, wie beispielsweise eines oder eine Kombination mehrerer der oben genannten Salze enthalten. Beispielsweise kann KCF₃SO₃ verwendet werden.

Die Emitterschicht B kann optional durch Aufbringen des Metall(I)-Komplexes oder einer diesen enthaltenden Zusammensetzung Z auf ein Substrat (daher die Oberfläche eines Bauteils T einer opto-elektronischen Vorrichtung) erfolgen. Dies kann mittels eines beliebigen Verfahrens erfolgen. Bevorzugt wird die Zusammensetzung zur Herstellung einer Emitterschicht B nasschemisch auf ein Substrat (daher die Oberfläche eines Bauteils T) aufgebracht wie beispielsweise durch Rotationsbeschichtung (engl. "spin coating"), Dropcasting, Schlitzguss, Vorhangguß, einem Walzverfahren oder einem Druckverfahren (z.B. Tintenstrahldruck (engl. "inkjet printing"), Tiefdruck oder Rakeln) erfolgen.

Hierbei kann der Metall(I)-Komplex bzw. die Zusammensetzung Z in einem verdampfbaren Lösungsmittel gelöst sein wie beispielsweise einem Lösungsmittel ausgewählt aus der Gruppe bestehend aus Wasser, Ethanol, Methanol, Acetonitril, Dioxan, Tetrahydrofuran, Dioxan, Chlorbenzol, Diethylenglykoldiethylether, Diethylenglykolmonoethylether, gamma-Butyrolacton, Ethoxyethanol, Xylol, Toluol, Anisol, Phenetol, Polyethylenglycol, Polyethylenoxid, und PGMEA (Propylenglykol-Monoethyletheracetat). Es können auch Kombinationen aus zwei oder mehr Lösungsmitteln verwendet werden.

Optional können der auf die Oberfläche aufzubringenden flüssigen Zusammensetzung Mittel zur Verbesserung der Flusseigenschaften oder Verdünner beigemischt werden. Derartige Mittel sind dem Fachmann wohlbekannt. Beispielsweise kann ein solches Mittel ausgewählt sein aus der Gruppe bestehend aus Polyethyloxiden ( Polyethylenglykolen), Polyethylendiaminen, Polyacrylaten (z.B. Polymethylmethacrylat (PMMA), Polyacrylsäure und deren Salze), substituierten oder unsubstituierten Polystyrolen (z.B. Polyphydroxystyrol), Polyvinylalkoholen, Polyestern oder Polyurethanen, Polyvinylcarbazolen, Polytriaryaminen, Polythiophenen und Polyvinylidenphenylenen. Es können auch Kombinationen aus zwei oder mehr Mitteln verwendet werden.

Insbesondere wenn eine OLED und/oder eine LEC hergestellt werden soll, kann durch das Aufbringen der Zusammensetzung Z in flüssiger Phase eine den Metall(I)-Komplex bzw. die Zusammensetzung Z enthaltende Nassphase erhalten werden, die hernach mit üblichen, im Stand der Technik wohlbekannten Verfahren getrocknet und/oder ausgehärtet werden kann.

Insbesondere wenn eine LEC hergestellt werden soll, kann es in einer Ausführungsform bevorzugt sein, dass geringe Rest an Lösungsmitteln in der Emitterschicht B verbleiben können, bspw. (sub-)ppm Lösungsmittelreste in der Emitterschicht B.

Die vorliegende Erfindung umfasst auch die Herstellung eines erfindungsgemäßen Metall(I)-Komplexes.

Daher betrifft ein weiterer Aspekt der vorliegenden Erfindung ein Verfahren zur Herstellung eines Metall(I)-Komplexes gemäß der vorliegenden Erfindung umfassend die Schritte:
(i) Bereitstellen einer Lösung enthaltend die Verbindung gemäß der Formel (vi) 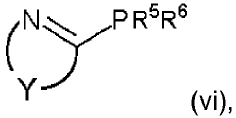 PR¹R²R⁷, PR³R⁴R⁹ und mindestens ein Metall(I)-Halogenidsalz in einem geeignete Lösungsmittel,
   wobei die R¹, R², R³, R⁴, R⁵, R⁶, R⁷, R⁸, Y, das Metall(I) und das Halogen wie oben im Zusammenhang mit den Metall-Komplexen erläutert definiert sind;
(ii) Inkubieren des Ansatzes unter Rühren;
(iii) optional Waschen des Metall(I)-Komplexes mit einer Flüssigkeit, in dem der Metall(I)-Komplex nicht oder kaum löslich ist; und
(iv) Isolieren des Metall(I)-Komplexes von dem Reaktionsansatz.

Der Schritt (i) des Bereitstellens einer Lösung kann das Lösen in einem Lösungsmittel wie beispielsweise einem koordinierenden Lösungsmittel umfassen. Das koordinierende Lösungsmittel ist hierbei bevorzugt ein polares Lösungsmittel wie beispielhaft ein solches ausgewählt aus der Gruppe bestehend aus Ethanol, Methanol, Acetonitril, Wasser oder Dioxan. Alternativ kann beispielhaft auch Toluol oder Tetrahydrothiophen eingesetzt werden. Es können auch Kombinationen verschiedener Lösungsmittel verwendet werden.

Das Metallhalogenidsalz kann beispielsweise ein Salz wie oben beschrieben sein.

Der Schritt (ii) des Inkubierens des Ansatzes unter Rühren kann kurz oder lang erfolgen, daher nur wenige Sekunden lang, einige Minuten lang oder für mehrere Stunden. Es kann optional geheizt oder gekühlt werden.

Eine Verbindung nach Formel (vi) kann beispielsweise wie in WO 2013/007710 beschrieben erhalten werden.

Wie oben dargelegt, kann die Zusammensetzung der vorliegenden Erfindung verwendet werden, um eine opto-elektronische Vorrichtung herzustellen.

Ein weiterer Aspekt der Erfindung betrifft eine opto-elektronische Vorrichtung enthaltend mindestens einen Metall(I)-Komplex oder eine Zusammensetzung Z gemäß der vorliegenden Erfindung.

Eine opto-elektronische Vorrichtung kann hierbei jede opto-elektronische Vorrichtung sein und sollte im weitesten Sinne verstanden werden. Bei einer opto-elektronische Vorrichtung handelt es sich erfindungsgemäße bevorzugt um eine organische opto-elektronische Vorrichtung, bei der die Emitterschicht B zumindest überwiegend aus organischen Werkstoffen, d.h. aus Kohlenwasserstoffverbindungen besteht, wobei die Kohlenwasserstoffverbindungen mit Heteroatomen wie Stickstoff, Phosphor, Sauerstoff und/oder Halogenen substituiert sein können.

Die opto-elektronische Vorrichtung kann (einseitig oder mehrseitig) intransparent, semitransparent oder (weitgehend) transparent sein. Gemäß einer bevorzugten Ausführungsform ist die opto-elektronische Vorrichtung eine lichtemittierende elektrochemische Zelle (LEC), eine organische Leuchtdiode (OLED), ein organischer Laser, eine organische Solarzelle (OSC) oder ein optischer Sensor.

Bevorzugt umfasst eine opto-elektronische Vorrichtung, zumindest folgende Schichten:
A) eine Anodenschicht A, bevorzugt umfassend Indium-Zinn-Oxid, Indium-Zink-Oxid, PbO, SnO, Grafit, dotiertes Si, dotiertes Ge, dotiertes GaAs, dotiertes Polyanilin, dotiertes Polypyrrol und/oder dotiertes Polythiophen;
B) eine Emitterschicht B gemäß der vorliegenden Erfindung; und
C) eine Kathodenschicht C, bevorzugt umfassend Al, Ca, Au, Ag, Pt, Cu, Zn, Ni, Fe, Pb, In, W, Pd und/oder Mischungen oder Legierungen aus zwei oder mehr dieser Metalle,
   bevorzugt in der Anordnung A) - B) - C).

Eine organische Solarzelle (OSC) kann auch als organische photovoltaische Vorrichtung (OPV) bezeichnet werden.

Gerade wenn die opto-elektronische Vorrichtung eine organische Leuchtdiode (OLED), eine lichtemittierende elektrochemische Zelle (LEC), eine organische Solarzelle (OSC) oder ein optischer Sensor ist, kann die opto-elektronische Vorrichtung optional auch als dünne Schicht ausgestaltet sein, die insgesamt nicht dicker als 5 mm, 2 mm, 1 mm, 0,5 mm, 0,25 mm, 100 µm oder 10 µm ist. Die opto-elektronische Vorrichtung kann auch eine Dicke im Bereich von 8-9 µm, 7-8 µm, 6-7 µm, 5-6 µm, 4-5 µm, 3-4 µm, 2-3 µm, 1-2 µm oder weniger als 1 µm aufweisen.

Stärker bevorzugt ist die opto-elektronische Vorrichtung eine lichtemittierende elektrochemische Zelle (LEC), eine organische Leuchtdiode (OLED), ein organischer Laser, eine organische Solarzelle (OSC) oder ein optischer Sensor, die den Metall(I)-Komplex oder die Zusammensetzung Z in der Emitterschicht B enthält.

OLEDs sind bekanntlich aus mehreren Schichten aufgebaut. Meist befindet sich auf einem Substrat eine Anodenschicht A. Das Substrat kann aus einem beliebigen Material oder einer Kombination von Materialien bestehen. Am häufigsten werden Glasplatten verwendet. Bevorzugt ist die Anodenschicht A (nahezu) vollständig transparent. Alternativ können jedoch auch dünne Metallfolien (beispielsweise Kupfer-, Gold-, Silber- oder Aluminiumfolien) oder Kunststoffe verwendet werden, was eine höhere Biegsamkeit der OLED ermöglicht.

In der Anodenschicht A werden als Anodenmaterialien häufig transparente Stoffe verwendet. Da mindestens eine der Elektroden transparent sein muss, um das in der OLED erzeugte Licht auskoppeln zu können, muss entweder die Anodenschicht A oder die Kathodenschicht C weitgehend, bevorzugt (nahezu) vollständig transparent für das auszukoppelnde Licht sein. Typischerweise ist dies die Anodenschicht A. Die Anodenschicht A besteht meist zu großen Teilen oder (nahezu) vollständig aus einem oder mehreren (weitgehend) transparenten, leitfähigen Oxiden (engl. "transparent conductive oxides", TCOs). Eine derartige Anodenschicht A kann beispielsweise Indium-Zinn-Oxid (ITO), Aluminium-Zink-Oxid, Fluor-Zinn-Oxid, Indium-Zink-Oxid, PbO, SnO, Zirkoniumoxid, Molybdänoxid, Vanadiumoxid, Wolframoxid, Grafit, dotiertes Si, dotiertes Ge, dotiertes GaAs, dotiertes Polyanilin, dotiertes Polypyrrol und/oder dotiertes Polythiophen enthalten. Die Anodenschicht A kann auch aus einem oder mehreren der vorgenannten Materialen bestehen. Besonders bevorzugt besteht die Anode aus Indium-Zinn-Oxid (ITO) (meist (InO₃)_{0,9}(SnO₂)_{0,1}).

Die Rauigkeit der in der Anodenschicht A verwendeten transparenten, leitfähigen Oxide kann durch den Einsatz einer zusätzlichen Lochinjektionsschicht (engl. "hole injection layer", HIL) ausgeglichen werden. Ferner kann die Lochinjektionsschicht die Injektion von positiven Quasiladungsträgern (daher Elektronenlöchern, somit der Abwesenheit eines Elektrons) erleichtern, indem der Ladungsträgerübertritt vom transparenten, leitfähigen Oxid zur Lochleitungsschicht erleichtert wird. In der Lochinjektionsschicht kann Poly-3,4-ethylendioxythiophen (PEDOT), Polystyrolsulfonat (PSS), MoO₂, V₂O₅ oder CuI, besonders eine Mischung aus PEDOT und PSS, eingesetzt werden. Diese Schicht kann auch die Eindiffusion von Metallen aus der Anodenschicht A in den Übergang in der Lochleitungsschicht verhindern.

Auf der Anodenschicht A oder Lochinjektionsschicht ist typischerweise eine Lochleitungsschicht (engl. "hole transport layer", HTL) angeordnet. Hier kann ein beliebiger Lochleiter eingesetzt werden. Beispielsweise können elektronenreiche Heteroaromaten wie Triarylamine oder Carbazole als Lochleiter eingesetzt werden. Auch die Lochleitungsschicht kann eine nivellierende Funktion erfüllen und die Energiebarriere zu der Emitterschicht B (engl. "emitting layer", EML, oder "light emitting layer", LEL) überbrücken. Die Lochleitungsschicht kann auch als Elektronenblockierschicht (engl. "electron blocking layer", EBL) bezeichnet werden. Bevorzugt weisen die Lochleiter hohe Triplett-Energien auf. Beispielsweise kann die Lochleitungsschicht als Lochleiter einen sternförmigen Heterozyklus wie Tris(4-carbazoyl-9-ylphenyl)amin (TCTA) enthalten. Als Elektronentransportermaterialien können optional auch Verbindungen eingesetzt werden wie sie in WO 2012/130571 offenbart sind.

Auf der Lochleitungsschicht ist in aller Regel die Emitterschicht B aufgebracht, die im Zusammenhang mit der vorliegenden Erfindung mindestens einen Metall(I)-Komplex und mindestens einen Ligand L enthält. Optional kann die Emitterschicht B auch aus diesem Metall(I)-Komplex bestehen. Die Zusammensetzung einer Emitterschicht B wird im Detail oben beschrieben.

Auf der Emitterschicht B kann abschließend eine Elektronenleitungsschicht (engl. "electron transport layer", ETL) aufgebracht werden. Hier kann ein beliebiger Elektronenleiter eingesetzt werden. Beispielsweise können hierin elektronenarme Verbindungen wie Benzimidazole, Pyridine, Triazole, Oxadiazole (beispielsweise 1,3,4-Oxadiazol), Phosphinoxide und Sulfone verwendet werden. Beispielsweise kann die Elektronenleitungsschicht als Elektronenleiter einen sternförmigen Heterozyklus wie 1,3,5-Tri(1-phenyl-1H-benzo[d]imidazol-2-yl)phenyl (TPBi) enthalten. Die Elektronentransportschicht kann zur energetischen Nivellierung zwischen Kathodenschicht C und Emitterschicht B dienen und Löcher blocken.

Auf die Elektronenleitungsschicht wird typischerweise eine Kathodenschicht C aufgebracht. Diese kann beispielsweise aus einem Metall oder einer Metalllegierung bestehen. Diese kann beispielsweise Al, Au, Ag, Pt, Cu, Zn, Ni, Fe, Pb, In, W, Pd und/oder Mischungen oder Legierungen aus zwei oder mehr dieser Metalle umfassen. Aus praktischen Gründen kann die Kathodenschicht C aus weitgehend optisch intransparenten Metallen wie Mg, Ca oder Al bestehen. In diesem Fall sollte die Anodenschicht A möglichst transparent sein. Alternativ kann die Kathodenschicht C auch weitgehend aus semitransparenten Materialen wie beispielsweise nanoskaligen Silberdrähten bestehen. Die Kathodenschicht kann beispielsweise im Hochvakuum aufgedampft werden.

Als Schutzschicht und zur Verringerung der Injektionsbarriere für Elektronen kann zwischen Kathodenschicht C und der ETL gegebenenfalls noch eine dünne Schutzschicht aufgebracht werden. Diese kann beispielsweise Lithiumfluorid, Cäsiumfluorid und/oder Silber enthalten und kann optional aufgedampft werden.

OLEDs lassen sich beispielsweise auch als Leuchtfolien, als leuchtende Etiketten in intelligenten Verpackungen (engl. I. "smart packaging") oder als innovative Designelemente herstellen. Weiterhin ist der Einsatz in der Zellerkennung und-untersuchung (engl. bio labelling") möglich.

Bevorzugt umfasst eine OLED, aber auch eine LEC, zumindest folgende Schichten:
A) eine Anodenschicht A, bevorzugt umfassend Indium-Zinn-Oxid, Indium-Zink-Oxid, PbO, SnO, Grafit, dotiertes Si, dotiertes Ge, dotiertes GaAs, dotiertes Polyanilin, dotiertes Polypyrrol und/oder dotiertes Polythiophen;
B) eine Emitterschicht B gemäß der vorliegenden Erfindung; und
C) eine Kathodenschicht C, bevorzugt umfassend Al, Ca, Au, Ag, Pt, Cu, Zn, Ni, Fe, Pb, In, W, Pd und/oder Mischungen oder Legierungen aus zwei oder mehr dieser Metalle,
   bevorzugt in der Anordnung A) - B) - C).

Stärker bevorzugt umfasst eine OLED zumindest folgende Schichten:
A) eine Anodenschicht A, insbesondere eine solche umfassend Indium-Zinn-Oxid; HTL) eine Lochleitungsschicht;
B) eine Emitterschicht B gemäß der vorliegenden Erfindung; ETL) eine Elektronenleitungsschicht;
C) eine Kathodenschicht C, bevorzugt umfassend Al, Ca oder Mg.
   bevorzugt in der Anordnung A) - HTL) - B) - ETL) - C).

Weitere bevorzugte Beispiele sind im untenstehenden experimentellen Beispielteil dargestellt.

In der OLED wandern die Elektronen (daher negative Ladungsträger) im Betrieb von der Kathode in Richtung Anode, welche die Löcher (daher positive Quasiladungsträger) bereitstellt. Löcher und Elektronen treffen sich im Idealfall in der Emitterschicht B, weshalb diese auch als Rekombinationsschicht bezeichnet werden kann. Aufeinandertreffende Elektronen und Löcher bilden einen gebundenen Zustand (Exziton). Von einem Exziton kann durch Energieübertrag ein Metall(I)-Komplex, der wie hierin beschrieben als Emitterverbindung dient, angeregt werden. Dieser Metall(I)-Komplex kann in den Grundzustand relaxieren und dabei ein Photon emittieren. Die Farbe des ausgesendeten Lichts hängt dabei vom Energieabstand ΔE zwischen dem angeregten und dem Grundzustand ab und kann durch Variation des Metall(I)-Komplexes bzw. des/der Ligand L gezielt variiert werden.

Wenn es sich bei der erfindungsgemäßen opto-elektronischen Vorrichtung um eine organische Solarzelle (OSC) handelt, ist es bevorzugt, dass die Vorrichtung den erfindungsgemäßen Metall(I)-Komplex als Bestandteil einer Absorberschicht S umfasst, wobei der Anteil an Metall(I)-Komplex in der Absorberschicht bevorzugt zwischen 30 und 100 Gew.-% beträgt. Wie bei OLEDs und LECs sind auch bei OSCs zwei Elektroden vorgesehen. Zwischen diesen ist die Absorberschicht angeordnet, in welcher der in der vorliegenden Anmeldung beschriebene Metall(I)-Komplex zum Einsatz kommt.

Ist die opto-elektronische Vorrichtung eine OSC, kann eine Einschicht- oder eine Mehrschicht-OSC sein. Eine Einschicht-OSC kann beispielsweise folgende Schichten aufweisen:
A) eine erste Elektrodenschicht zu großen Teilen oder (nahezu) vollständig bestehend aus einem oder mehreren (weitgehend) transparenten, leitfähigen Oxiden (engl. "transparent conductive oxides", TCOs), beispielsweise Indium-Zinn-Oxid, Aluminium-Zink-Oxid, Fluor-Zinn-Oxid, Indium-Zink-Oxid, PbO, SnO, Grafit, dotiertes Si, dotiertes Ge, dotiertes GaAs, dotiertes Polyanilin, dotiertes Polypyrrol und/oder dotiertes Polythiophen, insbesondere Indium-Zinn-Oxid (ITO) (z.B.(InO₃)_{0,9}(SnO₂)_{0,1}),
B) eine Absorberschicht S (entsprechend der Emitterschicht B bei OLEDs) enthaltend mindestens einen Metall(I)-Komplex aus mindestens einem Metall M und mindestens einem Liganden L enthält; und
C) Eine zweite Elektrodenschicht aus einem Metall oder einer Metalllegierung, wie beispielsweise Al, Au, Ag, Pt, Cu, Zn, Ni, Fe, Pb, In, W, Pd und/oder Mischungen oder Legierungen aus zwei oder mehr dieser Metalle, Kohlenstoffnanoröhren (engl. I. "carbon nanotubes", CNTs) und/oder nanoskaligen Silberdrähten, insbesondere Mg, Ca oder Al,
wobei die Einschicht-OSC in der Regel auf ein Substrat aufgebracht ist (etwa mit der ersten Elektrodenschicht) und auf der anderen Außenseite mit einer Schutzschicht geschützt werden kann.

Eine Mehrschicht-OSC kann entsprechend einer OLED aufgebaut sein, wobei die Schicht S bei der OSC als Absorberschicht S bezeichnet wird, ansonsten aber der Emitterschicht B einer OLED entsprechen kann und somit auch in der Lage ist unter geeigneten Bedingungen Licht zu emittieren.

Ein optischer Sensor kann beispielsweise ein optischer Sensor sein, der die Lichtintensität misst. Auch kann der optische Sensor optional die Lichtintensität von Licht eines bestimmten Wellenlängenbereichs bestimmen. Ein optischer Sensor kann auch Teil einer Anordnung von optischen Sensoren (daher eines Arrays), wie dies beispielsweise als Bildsensor in einer Digitalkamera zum Einsatz kommt.

Wie bereits erwähnt, kann der vorstehend beschriebene Metall(I)-Komplex Licht emittieren, daher als Emitterverbindung E dienen. Durch Variation des/der Ligand L und/oder des Cu(I) kann dabei der ΔE-Abstand zwischen dem untersten TriplettZustand dem darüber liegenden Singulett-Zustand variieren, so dass es möglich ist, die Wellenlänge des emittierten Lichtes zu variieren.

Entsprechend umfasst ein weiterer Aspekt der Erfindung ein Verfahren zur Erzeugung von Licht einer bestimmten Wellenlänge, umfassend den Schritt der Bereitstellung einer opto-elektronischen Vorrichtung gemäß der vorliegenden Erfindung. Eine OLED, eine LEC und ein organischer Laser können bestimmungsgemäß verwendet werden, um Licht einer bestimmten Wellenlänge zu erzeugen.

Gemäß einer besonders bevorzugten Ausführungsform ist die opto-elektronische Vorrichtung eine lichtemittierende elektrochemische Zelle und enthält den Metall(I)-Komplex oder die Zusammensetzung Z in der Emitterschicht B.

Gemäß einer ganz besonders bevorzugten Ausführungsform ist die opto-elektronische Vorrichtung eine lichtemittierende elektrochemische Zelle, die folgende Schichten umfasst:
A) eine Anodenschicht A, bevorzugt umfassend Indium-Zinn-Oxid, Indium-Zink-Oxid, PbO, SnO, Grafit, dotiertes Si, dotiertes Ge, dotiertes GaAs, dotiertes Polyanilin, dotiertes Polypyrrol und/oder dotiertes Polythiophen;
B) eine Emitterschicht B enthaltend einen Metall(I)-Komplex oder eine Zusammensetzung Z gemäß der vorliegenden Erfindung; und
C) eine Kathodenschicht C, bevorzugt umfassend Al, Au, Ag, Pt, Cu, Zn, Ni, Fe, Pb, In, W, Pd und/oder Mischungen oder Legierungen aus zwei oder mehr dieser Metalle.

Eine OLED, eine LEC und ein organischer Laser können bestimmungsgemäß verwendet werden, um Licht einer bestimmten Wellenlänge zu erzeugen.

Daher betrifft ein weiterer Aspekt der vorliegenden Erfindung ein Verfahren zur Erzeugung von Licht einer bestimmten Wellenlänge, umfassend den Schritt der Bereitstellung eines Metall(I)-Komplexes gemäß oder einer Zusammensetzung Z gemäß der vorliegenden Erfindung in der Emitterschicht B einer erfindungsgemäßen opto-elektronischen Vorrichtung.

Bevorzugt umfasst das in Verfahren zur Erzeugung von Licht einer bestimmten Wellenlänge zudem den verfahrensschritt des anlegend einer elektroschen Spannung und in der Regel auch eines elektrischen Stromes, an die Emitterschicht B einer erfindungsgemäßen opto-elektronischen Vorrichtung der vorliegenden Erfindung.

Hierbei ist die opto-elektronische Vorrichtung bevorzugt eine lichtemittierende elektrochemische Zelle (LEC).

Beispielsweise kann die Wellenlänge des emittierten Lichts auch auf kurzwellige Emission eingestellt werden, so dass blaues Licht emittiert wird. Entsprechend umfasst die vorliegende Erfindung auch ein Verfahren zur Erzeugung von blauer, grüner, gelber, orangener oder roter Emission.

Beispielhaft kann daher Licht im Bereich von 400-800 nm emittiert werden, so etwa im Bereich von 400-500 nm, von 450-550 nm, von 500-600 nm, von 550-650 nm, von 600-700 nm, von 650-750 nm und/oder von 700-800 nm.

Ist die opto-elektronische Vorrichtung gemäß der vorliegenden Erfindung eine OLED, kann sie beispielsweise auch als großflächiges Leuchtmittel, als leuchtende Tapete, leuchtendes Fenster, selbstleuchtendes Etikett, selbstleuchtendes Plakat oder biegsamer Bildschirm verwendet werden.

Ist die opto-elektronische Vorrichtung gemäß der vorliegenden Erfindung eine OSC, kann sie beispielsweise auch als aufrollbare Solarzelle (etwa für mobile Anwendungen wie z.B. Smartphones, Laptops, Tablets, etc.), als Architekturelement (z.B. Wand- oder Dach-Verkleidungselement) oder als Bauelement im verkehrstechnischen Bereich (z.B. im Automobil-, Flugzeug-, Zug-, und/oder Schiffsbereich) verwendet werden. Auch derartige Produkte, die die erfindungsgemäße opto-elektronische Vorrichtung enthalten, sind Gegenstand der vorliegenden Erfindung.

Ein weiterer Aspekt der Erfindung betrifft eine Zusammensetzung enthaltend einen Cu(I)-Komplex, der eine Struktur gemäß einer der folgenden Formeln A oder A' aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für entsprechende Komplexe ohne nicht-komplexierte ionische Gruppen sind auch in WO 2013/007707 (siehe beispielsweise Beispiele 1-6 hieraus) 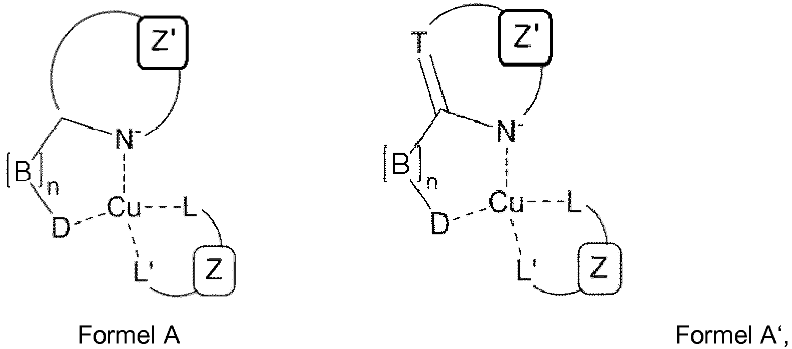 bei der der L, L' und Z umfassende Ligand (L^L') ein optional neutraler, zweizähniger Ligand ist, der über nicht-ionische Gruppen an das Cu gebunden ist;
bei der der D, [B]ₙ, Z' und N⁻ umfassende Ligand (D^N⁻) über eine anionische Gruppe an das Cu gebunden ist;
bei der D ein Rest ist, der mindestens einen Substituenten D* ausgewählt aus der Gruppe bestehend aus einem divalenten Carben C*, N, O, P, S, As und Sb aufweist oder aus D* besteht, wobei D* eine Bindung zu Cu eingeht,
wobei D darüber hinaus einen Rest mit bis zu 40 Kohlenstoffatomen ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest enthalten kann, der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern, und CF₃-Gruppen, substituiert sein kann, wobei die Substituenten miteinander und/oder mit dem Rest D optional eine zyklisierte und/oder anellierte Struktur ausbilden können;
bei der N⁻ anionische Stickstoff ist;
bei der Z' -R^{u}-, -R^{u}-NR^{u"}-, -NR^{u"}-R^{u}-, -R^{u}-NR^{u"}-R^{u'}-, -R^{u}-SiR^{u"}R^{u"},-R^{u'},-, -R^{u}-SiR^{u"}R^{u"'}-, - SiR^{u"}R^{u"'}-, -R^{u}-GeR^{u"}R^{u"'}-R^{u'}-, -R^{u}-GeR^{u"}R^{u"'}-, -GeR^{u"}R^{u"'}-, R^{u}-, -R^{u}-O-R^{u'}-, -R^{u}-CO-R^{u'}-, - R^{u}-CO-O-R^{u'}-, -R^{u}-O-CO-O-R^{u'}-, -R^{u}-O-CO-R^{u'}-, -O-R^{u'}-, -R^{u}-CS-R^{u'}-, -R^{u}-CO-S-R^{u'}-, -R^{u}-S-CO-R^{u'}-, -R^{u}-CO-NH-R^{u'}-, -R^{u}-NH-CO-R^{u'}-, -R^{u}-O-, -R^{u}-S-R^{u'}-, -S-R^{u'}-, -R^{u}-S-, -R^{u}-SO-R^{u'}-, -SO-R^{u'}-, -R^{u}-SO-, -R^{u}-SO₂-R^{u'}-, -SO₂-R^{u'}- oder -R^{u}-SO₂- ist,
wobei R^{u} und R^{u'} unabhängig voneinander jeweils ein Rest mit bis zu 40 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander und/oder mit dem Rest D optional eine zyklisierte und/oder anellierte Struktur ausbilden können,
wobei R^{u"} und R^{u"'} unabhängig voneinander jeweils ein Rest mit bis zu 40 Kohlenstoffatomen sind, unabhängig voneinander ausgewählt aus der Gruppe bestehend aus Wasserstoff, Halogen, -R^{t}, -OC(O)R^{t}, -COOH, -OR^{t}, -NR^{t}R^{t'}, -SiR^{t}R^{t'}R^{t"}, - GeR^{t}R^{t'}R^{t"}, -SR^{t}, -SOR^{t}, -SO₂R^{t} und weiteren Donor- und Akzeptor-Gruppen, wie beispielsweise Carboxylaten und deren Estern und CF₃-Gruppen,
wobei R^{t}, R^{t'} und R^{t"} unabhängig von einander ausgewählt sind aus der Gruppe bestehend aus H, OH, NH₂, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{t}, R^{t'}, R^{t"}, R^{u}, R^{u'}, R^{u"} und R^{u'"} optional auch zu anellierten Ringsystemen führen können;
bei der jedes B eine divalente organische Brücke unabhängig voneinander ausgewählt aus der Gruppe bestehend aus =CR^{z}-, -CR^{z}R^{y}-, -NR^{z}-, -O-, -SiR^{z}R^{y}-, -GeR^{z}R^{y}-, -S-, - S(O)- und -S(O)₂- ist oder eine Bindung ist,
wobei R^{z} und R^{y} unabhängig voneinander ausgewählt sind aus der Gruppe bestehend aus Wasserstoff, Halogen -OR^{x}, -O-C(O)-R^{x}, -NR^{x}R^{x}, -SiR^{x}R^{x'}R^{x"}, -GeR^{x}R^{x'}R^{x"}, -SR^{x}, - SOR^{x} und -SO₂R^{x},
wobei R^{x}, R^{x'} und R^{x"} unabhängig von einander ausgewählt sind aus H, OH, NH₂, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{x}, R^{y} und R^{z} optional auch zu anellierten Ringsystemen führen können, wobei beispielhaft B Bestandteil einer Phenyl- und/oder substituierten Phenyleinheiten sein kann/können,
wobei mehrere B sowohl gleich als auch verschieden sein können,
wobei sich zwischen N⁻ und D* mindestens ein Kohlenstoffatom befindet,
wobei ein oder mehrere Substituenten von D und/oder von N⁻ mit B optional zyklische, aliphatische, konjugierte, aromatische und/oder anellierte Systeme ausbilden können;
bei der T CR^{w} oder Stickstoff ist,
wobei R^{w} ein Rest, ausgewählt aus der Gruppe bestehend aus Wasserstoff, Halogen, - R^{v}, -OC(O)R^{v}, -COOH, -OR^{v}, -NR^{v}R^{v'}, -SiR^{v}R^{v'}R^{v"}, -GeR^{v}R^{v'}R^{v"}, -SR^{v}, -SOR^{v}, -SO₂R^{v} und weiteren Donor- und Akzeptor-Gruppen, wie beispielsweise Carboxylaten und deren Estern und CF₃-Gruppen,
wobei R^{v}, R^{v'} und R^{v"} unabhängig von einander ausgewählt sind aus der Gruppe bestehend aus H, OH, NH₂, NHR^{v"'}, NHR^{v"'}R^{v""}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest.
wobei R^{v"'} und R^{v""} unabhängig von einander ausgewählt sind aus der Gruppe bestehend aus OH, NH₂, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest.
wobei zwei oder mehr der Reste R^{v}, R^{v"}, R^{v'"} und R^{w} optional auch ein oder mehr anellierte Ringsysteme bilden können,
wobei T optional mit einem oder mehreren B ein oder mehrere Ringsysteme ausbilden kann;
bei der n für die ganzen Zahlen von 1 bis 9 steht;
bei der L und L' unabhängig voneinander jeweils ein an das Cu gebundener Substituent sind,
wobei L einen Substituenten L* enthält und L' einen Substituenten L'*enthält, wobei L* und L'* unabhängig voneinander ausgewählt sind aus der Gruppe bestehend aus einem divalenten Carben C*, N, O, P, S, As und Sb und L* und L'* jeweils eine Bindung zu dem Cu eingehen,
wobei L ein oder mehr, bevorzugt drei, Substituenten enthält, die an L* gebunden sind und wobei L' ein oder mehr, bevorzugt drei, Substituenten enthält, die an L*' gebunden sind,
wobei die an L* und L'* gebundenen Substituenten unabhängig voneinander jeweils ein Substituent mit bis zu 40 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander optional eine zyklisierte und/oder anellierte Struktur ausbilden können,
wobei jeweils ein an L* gebundener Substituent und ein an L'* gebundener Substituent über Z miteinander verbunden sein können, insbesondere wobei die übrigen an L* und L'* gebundenen Substituenten jeweils Arylreste sind,
bei der Z -O-, eine Bindung, -R^{ub}- -R^{ub}-NR^{ub"}-, -NR^{ub"}-R^{ub}-, -R^{ub}-NR^{ub"}-R^{ub'}-, -R^{ub}-SiR^{ub"}R^{ub"'}-R^{ub'}-, -R^{ub}-SiR^{ub"}R^{ub"'}-, -SiR^{ub"}R^{ub"'}-R^{ub}-, -R^{ub}-GeR^{ub"}R^{ub"'}-R^{ub'}-, -R^{ub}-GeR^{ub"}R^{ub"'}-, -GeR^{ub"}R^{ub"'}-R^{ub}-, -R^{ub}-O-R^{ub'}-, -R^{ub}-CO-R^{ub'}-, -R^{ub}-CO-O-R^{ub'}-, -R^{ub}-O-CO-O-R^{ub'}-, -R^{ub}-O-CO-R^{ub'}-, -O-R^{ub'}, -R^{ub}-CS-R^{ub'}-, -R^{ub}-CO-S-R^{ub'}-, -R^{ub}-S-CO-R^{ub'}-, -R^{ub}-CO-NH-R^{ub'}-, -R^{ub}-NH-CO-R^{ub'}-, -R^{ub}-CO-NR^{v"'}-R^{ub'}-, -R^{ub}-NR^{v"'}-CO-R^{ub'}-, -R^{ub}-O-, -R^{ub}-S-R^{ub'}-, -S-R^{ub'}, -R^{ub}-S-, -R^{ub}-SO-R^{ub'}-, -SO-R^{ub}, -R^{ub}-SO-, -R^{ub}-SO₂-R^{ub'}-, -SO₂-R^{ub'} oder -R^{ub}-SO₂- ist oder Z fehlt und somit keine Bindung zwischen L und L' vorliegt,
wobei R^{ub} und R^{ub'} unabhängig voneinander jeweils ein Rest mit bis zu 40 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander optional eine zyklisierte und/oder anellierte Struktur ausbilden können,
wobei R^{ub"} und R^{ub"'} unabhängig voneinander jeweils ein Rest mit bis zu 40 Kohlenstoffatomen sind, unabhängig voneinander ausgewählt aus der Gruppe bestehend aus Wasserstoff, Halogen, -R^{t"'}, -OC(O)R^{t'"}, -COOH, -OR^{t"'}, -NR^{t"'}R^{t"'}, - SiR^{t"'}R^{t"''}R^{t'""}, -GeR^{t'"}R^{t'"'}R^{t'""} -SR^{t'"}, -SOR^{t'"}, -SO₂R^{t'"} und weiteren Donor- und Akzeptor-Gruppen, wie beispielsweise Carboxylaten und deren Estern und CF₃-Gruppen,
wobei R^{t'"}, R^{t'"'} und R^{t""'} unabhängig von einander ausgewählt sind aus der Gruppe bestehend aus H, OH, NH₂, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{t'"}, R^{t'"'}, R^{t'""}, R^{ub}, R^{ub'}, R^{ub"} und R^{ub"'} optional auch zu anellierten Ringsystemen führen können; und
wobei mindestens einer der Liganden L^L' und/oder D^N⁻ (daher L, L', Z, D und/oder [B]ₙ) mindestens eine nicht-komplexierte ionische Gruppe trägt, insbesondere eine ionische Gruppe ausgewählt aus der Gruppe bestehend aus der Gruppe bestehend aus -SO₃⁻, -PO₃⁻, -COO⁻ und -NH₃⁺, insbesondere wobei die ionische Gruppe eine SO₃⁻ ist.

Alternativ können auch zwei oder mehr Z L und L' mit einander verbinden.
Z kann auch fehlen, so dass L und L' jeweils unabhängig voneinander an das Cu gebunden sind.

In einer Ausführungsform bildet N⁻ zusammen mit Z' der Formel A oder A' für ein Anion einer ungesättigten oder aromatischen N-heterozyklischen Einheit mit 5 bis 14 Ring-Atomen, die nach N-Deprotonierung eines Rests ausgewählt aus der Gruppe bestehend aus Purinyl, Pyrryl, Indyl, Carbazolyl, Triazolyl, Benzotriazolyl, Pyrazolyl, Benzopyrazolyl, Imidazolyl, Benzimidazolyl, und Tetrazolyl erhalten werden kann und die optional weiter substituiert sein kann.

In einer Ausführungsform ist der Rest D des D, [B]ₙ, Z' und N⁻ umfassenden Liganden (N⁻^D) der Formel A oder A' ausgewählt aus der Gruppe bestehend aus (wobei der Ligand nicht mehr als 20 Kohlenstoffatome aufweist):
(i) einem Carben C*, das Teil eines Carbenliganden ist, ausgewählt aus der Gruppe bestehend aus: 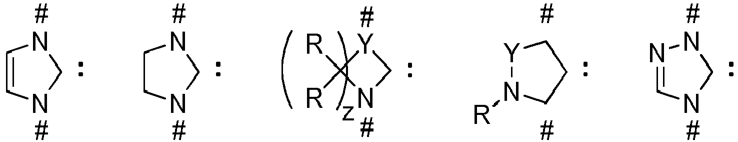 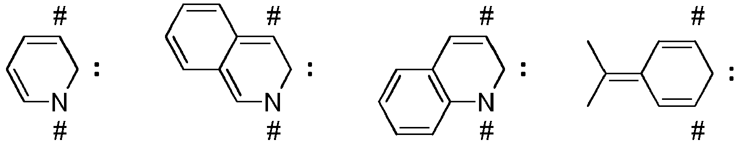 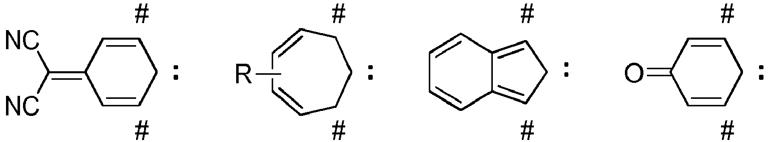 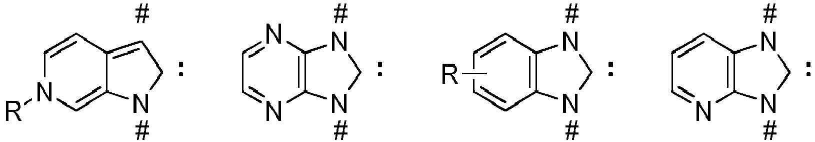 wobei die zwei Punkte ":" für ein divalentes Carben stehen, das an das Cu-Atom koordiniert, und die Verknüpfung zu B an einer der mit # gekennzeichneten Stellen stattfindet;
   wobei die andere die andere mit #- gekennzeichnete Bildungsstelle dann mit einem Rest ausgewählt aus der Gruppe bestehend aus Wasserstoff, Deuterium, Halogen -OR^{s}, -O-C(O)-R^{s}, -NR^{s}R^{s'}, -SiR^{s}R^{s'}R^{s"}, -GeR^{s}R^{s'}R^{s"}, -SR^{s}, -SOR^{s} und - SO₂R^{s} verbunden sein kann
   wobei R jeweils unabhängig ausgewählt ist aus der Gruppe bestehend aus Wasserstoff, Deuterium, Halogen, -R^{s} -OR^{s}, -O-C(O)-R^{s}, -NR^{s}R^{s'}, -SiR^{s}R^{s'}R^{s"},-GeR^{s}R^{s'}R^{s"}, -SR^{s}, -SOR^{s} und -SO₂R^{s},
   wobei R^{s}, R^{s'} und R^{s"} unabhängig von einander ausgewählt sind aus Wasserstoff, Deuterium, OH, NH₂, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
   wobei die Reste R, R^{s}, R^{s'} und R^{s"} optional auch zu anellierten Ringsystemen führen können;
   wobei Y Stickstoff oder CR^{r} ist,
   wobei R^{r} ein Rest, ausgewählt aus der Gruppe bestehend aus Wasserstoff, Deuterium, Halogen, -R^{q}, -OC(O)R^{q}, -COOH, -OR^{q}, -NR^{q}R^{q'}, -SiR^{q}R^{q'}R^{q"}, - GeR^{q}R^{q'}R^{q"}, -SR^{q}, -SOR^{q}, -SO₂R^{q} und weiteren Donor- und Akzeptor-Gruppen, wie beispielsweise Carboxylaten und deren Estern und CF₃-Gruppen,
   wobei R^{q}, R^{q'} und R^{q"} unabhängig von einander ausgewählt sind aus der Gruppe bestehend aus H, OH, NH₂, NR^{s}R^{s'}, NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
   wobei zwei oder mehr der Reste R^{q}, R^{q'}, R^{q"} und R^{r} optional auch zu anellierten Ringsystemen führen können,
   wobei hierbei z für die ganzen Zahlen 1, 2, 3 oder 4 steht;
(ii) einer ungesättigten oder aromatischen N-heterozyklischen Einheit mit 4 bis 8 Ring-Atomen, wobei die Koordination an das Cu-Atom über ein Stickstoffatom der N-heterozyklischen Einheit stattfindet, die ausgewählt ist aus der Gruppe bestehend aus Pyridyl, Pyrimidyl, Pyridazyl, Pyrazyl, Pyranyl, Cumaryl, Pteridyl, Thiophenyl, Benzothiophenyl, Furyl, Benzofuryl, Oxazolyl, Thiazolyl, Imidazolyl, Pyrazolyl, Thienothienyl, Dithiaindacenyl, Chinolyl, Isochinolyl, Chinoxalyl, Acridyl, Azanaphthyl, Phenanthrolyl, Triazinyl, Thienyl, Thiadiazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl und 1,2,3,4-Thiatriazolyl, die optional weiter substituiert und/oder anelliert sind, und einer N-heterozyklischen Einheit ausgewählt aus der Gruppe bestehend aus: 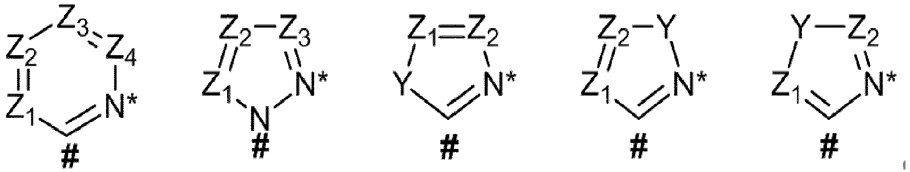 wobei die Verknüpfung zu B an der mit # gekennzeichneten Stelle stattfindet und * das Atom kennzeichnet, das die Komplexbindung eingeht,
   wobei Z₁, Z₂, Z₃ und Z₄ jeweils unabhängig voneinander ausgewählt CR^{l} oder Stickstoff sind,
   wobei R^{l} ein Rest, ausgewählt aus der Gruppe bestehend aus Wasserstoff, Deuterium, Halogen, -R^{k}, -OC(O)R^{k}, -COOH, -OR^{k}, -NR^{k}R^{k'}, -SiR^{k}R^{k'}R^{k"}, - GeR^{k}R^{k'}R^{k"}, -SR^{k}, -SOR^{k}, -SO₂R^{k} und weiteren Donor- und Akzeptor-Gruppen, wie beispielsweise Carboxylaten und deren Estern und CF₃-Gruppen, wobei R^{k}, R^{k'} und R^{k"} unabhängig von einander ausgewählt sind aus der Gruppe bestehend aus H, OH, NH₂, NR^{s}R^{s'}, NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
   wobei der/die Reste R^{k}, R^{k'}, R^{k"} und R^{l} optional auch zu anellierten Ringsystemen führen können,
(iii) einer Phosphanyl-, Arsenyl- oder Antimonyleinheit der Form -ERⁱR^{j},
   wobei E ausgewählt ist aus der Gruppe bestehend aus P, As und Sb, die an das Cu-Atom koordinieren,
   wobei Rⁱ und R^{j} unabhängig von einander jeweils ein Rest ausgewählt aus der Gruppe bestehend aus Wasserstoff, Deuterium, Halogen, -R^{k}, -OC(O)R^{k},-COOH, -OR^{k}, -NR^{k}R^{k'}, -SiR^{k}R^{k'}R^{k"}, -GeR^{k}R^{k'}R^{k}", -SR^{k}, -SOR^{k}, -SO₂R^{k} und weiteren Donor- und Akzeptor-Gruppen, wie beispielsweise Carboxylaten und deren Estern und CF₃-Gruppen, sind,
   wobei R^{k}, R^{k'} und R^{k"} unabhängig von einander ausgewählt sind aus der Gruppe bestehend aus H, OH, NH₂, NR^{s}R^{s'}, NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
   wobei der/die Reste R^{h}, R^{h'}, R^{h"}, Rⁱ und R^{j} optional auch zu anellierten Ringsystemen führen können,

In einer Ausführungsform ist das Carben C* des D, [B]ₙ, Z' und N⁻ umfassenden Liganden (N⁻^D) der Formel A oder A' Teil einer Struktur ausgewählt aus der Gruppe bestehend aus: 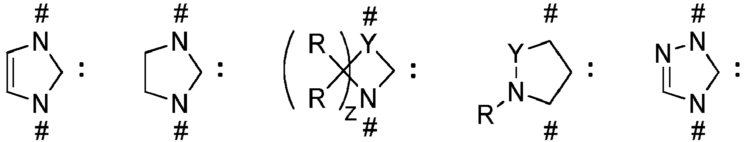 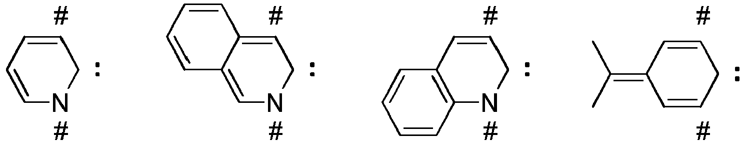 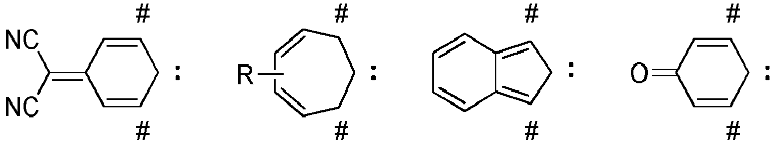 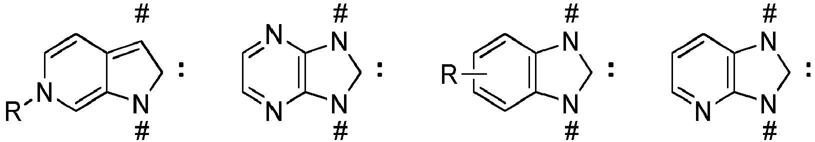 wobei die zwei Punkte ":" für ein divalentes Carben stehen, das an das Cu-Atom koordiniert, und die Struktur mit einer der mit # gekennzeichneten Stellen mit B verknüpft ist;
wobei die andere die andere mit # gekennzeichnete Bildungsstelle dann mit einem Rest ausgewählt aus der Gruppe bestehend aus Wasserstoff, Halogen -OR^{g}, -O-C(O)-R^{g}, - NR^{g}R^{g'}, -SiR^{g}R^{g'}R^{g"},-GeR^{g}R^{g'}R^{g"}, -SR^{g}, -SOR^{g} und -SO₂R⁹,
wobei R jeweils unabhängig ausgewählt ist aus der Gruppe bestehend aus Wasserstoff, Deuterium, Halogen, -R^{g}, -OR^{g}, -O-C(O)-R^{g}, -NR^{g}R^{g'}, -SiR^{g}R^{g'}R^{g"},-GeR^{g}R^{g'}R^{g"}, -SR^{g},-SOR⁹ und -SO₂R⁹,
wobei R^{g}, R^{g'} und R^{g"} unabhängig von einander ausgewählt sind aus H, OH, NH₂, NR^{s}R^{s'}, NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R, R^{g}, R^{g'} und R^{g"} optional auch zu anellierten Ringsystemen führen können; und
wobei Y Stickstoff oder CR^{f} ist,
wobei R^{f} ein Rest, ausgewählt aus der Gruppe bestehend aus Wasserstoff, Deuterium, Halogen, -R^{e}, -OC(O)R^{e}, -COOH, -OR^{e}, -NR^{e}R^{e'}, -SiR^{e}R^{e'}R^{e"}, -G^{e}R^{e}R^{e'}R^{e"}, -SR^{e},-SOR^{e}, -SO₂R^{e} und weiteren Donor- und Akzeptor-Gruppen, wie beispielsweise Carboxylaten und deren Estern und CF₃-Gruppen,
wobei R^{e}, R^{e'} und R^{e"} unabhängig von einander ausgewählt sind aus der Gruppe bestehend aus H, OH, NH₂, NR^{s}R^{s'}, NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei der/die Reste R^{e}, R^{e'}, R^{e"} und R^{f} optional auch zu anellierten Ringsystemen führen können,
wobei hierbei z für die ganzen Zahlen 1, 2, 3 oder 4 steht.

In einer Ausführungsform handelt es sich bei dem Liganden L^L' der Formeln A und A' um einen zweizähnigen Liganden der Form L-G-L',
bei dem G ein substituierter oder unsubstituierter C₁₋₉-Alkylen-, C₂₋₈-Alkenylen-, C₂₋₈-Alkinylen- oder Arylenrest, -R^{d}-NR^{d"}-, -NR^{d"}-R^{d}-, -R^{d}-NR^{d"}-R^{d'}-, -R^{d}-SiR^{d"}R^{d"'}-R^{d'}-, -R^{d}-SiR^{d"}R^{d'"}-, SiR^{d"}R^{d'"}-, -R^{d}-GeR^{d"}R^{d'"}-R^{d'}-, -R^{d}-GeR^{d"}R^{d"'}, -GeR^{d"}R^{d"'}, -R^{d}, -R^{d}-O-R^{d'}-, - R^{d}-CO-R^{d'}-, -R^{d}-CO-O-R^{d'}-, -R^{d}-O-CO-O-R^{d'}-, -R^{d}-O-CO-R^{d'}-, -O-R^{d'}-, -R^{d}-CS-R^{d'}-, -R^{d}-CO-S-R^{d'}-, -R^{d}-S-CO-R^{d'}-, -R^{d}-CO-NH-R^{d'}-, -R^{d}-NH-CO-R^{d'}-, -R^{d}-O-, -R^{d}-S-R^{d'}-, -S-R^{d'}-,-R^{d}-S-, -R^{d}-SO-R^{d'}-, -SO-R^{d'}-, -R^{d}-SO-, -R^{d}-SO₂-R^{d'}-, -SO₂-R^{d'}-, oder -R^{d}-SO₂- ist,
wobei R^{d} und R^{d'} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest, der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander und/oder mit einem oder beiden der Reste L und/oder L' optional eine zyklisierte und/oder anellierte Struktur ausbilden können,
wobei R^{d"} und R^{d'"} unabhängig voneinander jeweils ein Rest mit bis zu 20 Kohlenstoffatomen sind, unabhängig voneinander ausgewählt aus der Gruppe bestehend aus Wasserstoff, Halogen, -R^{c}, -OC(O)R^{c}, -COOH, -OR^{c}, -NR^{c}R^{c'}, - SiR^{c}R^{c'}R^{c"}, -GeR^{c}R^{c'}R^{c"}, -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NR^{s}R^{s'}, NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c'}, R^{c"}, R^{d}, R^{d'}, R^{d"} und R^{d"'} optional auch zu anellierten Ringsystemen führen können;
bei dem L und L' Substituenten sind, die gleich oder verschieden sind und die unabhängig voneinander ausgewählt sind aus der Gruppe bestehend aus (wobei der Ligand nicht mehr als 20 Kohlenstoffatome aufweist):
(i) dem Fragment X^{b} oder einer ungesättigten oder aromatischen N-heterozyklischen Einheit mit 4 bis 8 Ring-Atomen, die ausgewählt ist aus der Gruppe bestehend aus Pyridyl, Pyrimidyl, Pyridazyl, Pyrazyl, Pyranyl, Cumaryl, Pteridyl, Thiophenyl, Benzothiophenyl, Furyl, Benzofuryl, Oxazolyl, Thiazolyl, Imidazolyl, Pyrazolyl, Thienothienyl, Dithiaindacenyl, Chinolyl, Isochinolyl, Chinoxalyl, Acridyl, Azanaphthyl, Phenanthrolyl, Triazinyl, Thienyl, Thiadiazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl und 1,2,3,4-Thiatriazolyl, die optional weiter substituiert und/oder anelliert sind,
   wobei die Koordination an das Cu-Atom über das Stickstoffatom des Fragments X^{b} oder ein Stickstoffatom der N-heterozyklischen Einheit stattfindet,
   wobei das Fragment X^{b} ausgewählt ist aus der Gruppe bestehend aus: 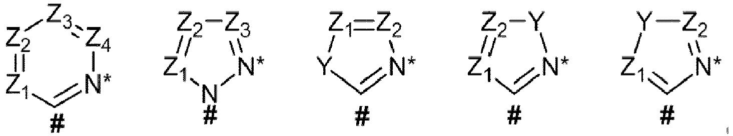 wobei die Verknüpfung zu G an der mit # gekennzeichneten Stelle stattfindet und * das Atom, das die Komplexbindung eingeht, kennzeichnet,
   wobei Z₁, Z₂, Z₃ und Z₄ jeweils unabhängig voneinander CR^{az} oder Stickstoff sind,
   wobei R^{az} ein Rest, ausgewählt aus der Gruppe bestehend aus Wasserstoff, Halogen, -R^{ay}, -OC(O)R^{ay}, -COOH, -OR^{ay}, -NR^{ay}R^{ay'}, -SiR^{ay}R^{ay'}R^{ay"},-GeR^{ay}R^{ay'}R^{ay"}, -SR^{ay}, -SOR^{ay}, -SO₂R^{ay} und weiteren Donor- und Akzeptor-Gruppen, wie beispielsweise Carboxylaten und deren Estern und CF₃-Gruppen,
   wobei R^{ay}, R^{ay'} und R^{ay"} unabhängig von einander ausgewählt sind aus der Gruppe bestehend aus H, OH, NH₂, NR^{s}R^{s'}, NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
   wobei der/die Reste R^{ay}, R^{ay'}, R^{ay"} und R^{az} optional auch zu anellierten Ringsystemen führen können,
(ii) einer Phosphanyl-, Arsenyl- oder Antimonyleinheit der Form -ERⁱR^{j} wie oben definiert; und/oder
(iii) einer das C* enthaltende Gruppe D, die ausgewählt ist aus der Gruppe bestehend aus: 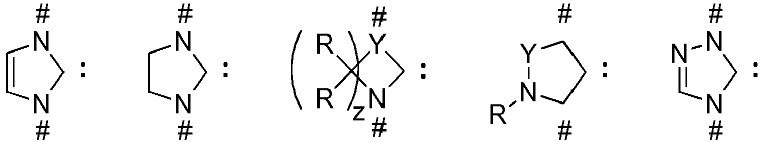 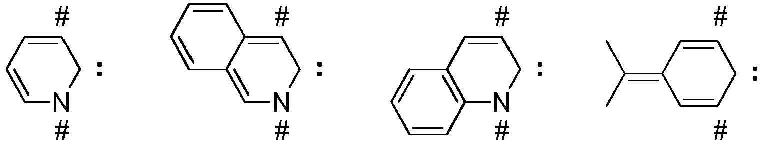 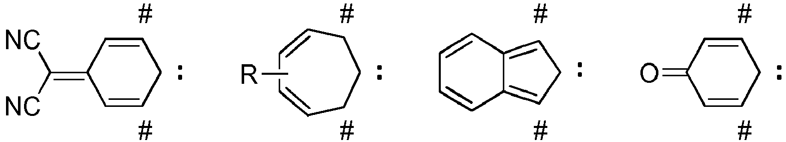 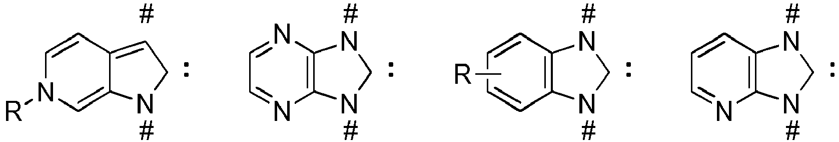 wobei die zwei Punkte ":" für ein divalentes Carben stehen, das an das Cu-Atom koordiniert, und die Struktur mit einer der mit # gekennzeichneten Stellen mit B verknüpft ist;
   wobei die andere die andere mit # gekennzeichnete Bildungsstelle dann mit einem Rest ausgewählt aus der Gruppe bestehend aus Wasserstoff, Halogen - OR^{g}, -O-C(O)-R^{g}, -NR^{g}R^{g'}, -SiR^{g}R^{g'}R^{g"}, -GeR^{g}R^{g'}R^{g"}, -SR^{g}, -SOR^{g} und -SO₂R^{g} substituiert sein kann,
   wobei die Reste R, R^{g}, R^{g'}, R^{g"} und Y und z wie oben definiert sind.

Ein weiterer Aspekt der Erfindung betrifft eine Zusammensetzung enthaltend einen Cu(I)-Komplex, der eine Struktur gemäß der folgenden Formel B aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für derartige Komplexe sind auch in WO 2013/007707 (Formeln I und A hieraus) und in WO 2010/031485 (siehe beispielsweise Formeln II, IV und VI-IX hieraus) gezeigt. 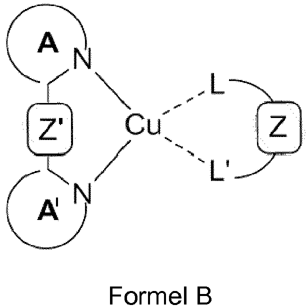 bei der der L, L' und Z umfassende Ligand (L^L') ein optional neutraler, zweizähniger Ligand ist, der über nicht-ionische Gruppen an das Cu gebunden ist;
bei der der die Ringsysteme A und A' und den überbrückenden Liganden Z' umfassende Ligand (N^N) optional über eine anionische Gruppe an das Cu gebunden sein kann, wobei der Ligand N^N dann die positive Ladung des Cu(I) neutralisieren kann;
wobei die Ringsysteme A und A' eine der folgenden Strukturen aufweisen: 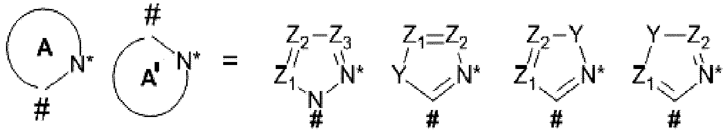 wobei Z₁, Z₂ und Z₃ jeweils unabhängig von einander Stickstoff oder CR sind,
wobei R unabhängig von einander ausgewählt ist aus der Gruppe bestehend aus -H, - D, -F, -Cl, -Br, -I, -CN, -NO₂, -SO, -SO₂, -OH, -OR^{a}, -SH, -SR^{a}, -R^{a}-NR¹R², -NR¹R², -R^{a}-C(=O)R¹, -C(=O)R¹, -R^{a}-SiR¹R²R³, -SiR¹R²R³, -R^{a}-GeR¹R²R³, -GeR¹R²R³, -R^{a}-SeR¹R²R³, -SeR¹R²R³, -R^{a}-R¹C=CR²R³, -R¹C=CR²R³, -R^{a}-C≡C-R¹, -C≡C-R¹, -R^{a}-C=O, -R^{a}-C=S, -R^{a}-C=Se, -R^{a}-C=NR¹, -C=O, -C=S, -C=Se, -C=NR¹, -R^{a}-C-N=R¹, -C-N=R¹,-R^{a}-POR¹ R² R³, -R^{a}-N=R⁴, -CO-NH-R¹, -R^{a}-CO-NH-R¹, -NH-CO-R¹, -R^{a}-NH-CO-R¹,
wobei R¹, R² und R³ unabhängig von einander ausgewählt sind aus der Gruppe bestehend aus H, D, F, I, Br, Cl, CN, einem aliphatischen Kohlenwasserstoffrest mit 1 bis 20 Kohlenstoffatomen, aromatischen oder heteroaromatischen Ringsystem mit 5 bis 30 aromatischen Ringatomen, in dem ein oder mehrere Wasserstoffatome optional durch D, F, Cl, Br, I oder CN ersetzt sein können,
wobei R⁴ ausgewählt ist aus der Gruppe bestehend aus einem aliphatischen Kohlenwasserstoffrest mit 1 bis 20 Kohlenstoffatomen, in dem ein oder mehrere Wasserstoffatome optional durch D, F, Cl, Br, I oder CN ersetzt sein können und der optional mit einem oder mehreren aromatischen oder heteroaromatischen Ringen substituiert sein kann,
wobei R^{a} ausgewählt ist aus der Gruppe bestehend aus einem substituierten oder unsubstituierten C₁₋₉-Alkylen-, C₂₋₈-Alkenylen-, C₂₋₈-Alkinylen- oder Arylenrest, -R^{a'}-NR^{a"'}-, -NR^{a"'}-R^{a'}-, -R^{a'}-NR^{a"'}-R^{a"}, -R^{a'}-SiR^{a"'}R^{a""}-R^{a"}-, -R^{a'}-SiR^{a'"}R^{a""}-, -SiR^{a"'}R^{a""}-R^{a'}-, - R^{a'}-O-R^{a"}-, -R^{a'}-CO-R^{a"}-, -R^{a'}-CO-O-R^{a"}-, -R^{a'}-O-CO-O-R^{a"}-, -R^{a'}-O-CO-R^{a"}- -O-R^{a"} -R^{a'}-CS-R^{a"}-, -R^{a'}-CO-S-R^{a"}-, -R^{a'}-S-CO-R^{a"}-, -R^{a'}-CO-NH-R^{a"}-, -R^{a'}-NH-CO-R^{a"}-, -R^{a'}-O-,-R^{a'}-S-R^{a"}-, -S-R^{a"}-, -R^{a'}-S-, -R^{a'}-SO-R^{a"}-, -SO-R^{a"} -, -R^{a'}-SO-, -R^{a'}-SO₂-R^{a"}-, -SO₂-R^{a"}- und -R^{a'}-SO₂- ist,
wobei R^{a'} und R^{a"} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander und/oder mit dem Rest Z' optional eine zyklisierte und/oder anellierte Struktur ausbilden können,
wobei R^{a'"} und R^{a""} unabhängig voneinander jeweils ein Rest mit bis zu 20 Kohlenstoffatomen sind, unabhängig voneinander ausgewählt aus der Gruppe bestehend aus Wasserstoff, Halogen, -R^{c}, -OC(O)R^{c}, -COOH, -OR^{c}, -NR^{c}R^{c'}, - SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NHR^{a'"}, NR^{a"'}R^{a""}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c'}, R^{c"}, R^{a'}, R^{a"}, R^{a"'} und R^{a'"} optional auch zu anellierten Ringsystemen führen können,
wobei zwei oder mehr benachbarte Substituenten miteinander ein mono-, di-, tri- oder polycyclisches, aliphatisches, aromatisches oder heteroaromatisches Ringsystem bilden können; und
wobei Y O, S oder NR ist, wobei R wie oben definiert ist;
wobei Z' BR¹R² ist, wobei R¹ und R² wie oben definiert sind und B für ein Boratom steht, insbesondere wobei Z' ausgewählt ist aus der Gruppe bestehend aus H₂B, BPh₂, B(CH₃)₂ und B(NR¹R²)₂, wobei Ph ein Phenylrest ist, wobei R¹ und R² wie oben definiert sind und B für ein Boratom steht, insbesondere wobei Z' ausgewählt ist aus der Gruppe bestehend aus H₂B, BPh₂, B(CH₃)₂ und B(NR¹R²)₂, wobei Ph ein Phenylrest ist,
wobei "*" das Atom kennzeichnet, das die Komplexbindung eingeht und "#" das Atom kennzeichnet, das über Z' mit der zweiten Einheit verbunden ist,
bei der L und L' wie oben unter Formel A definiert sein können,
wobei Z wie oben unter Formel A definiert sein kann und/oder ein Rest ist ausgewählt aus der Gruppe bestehend aus -R^{ub}- -R^{ub}-NR^{ub"}-, -NR^{ub"}-R^{ub}-, -R^{ub}-NR^{ub"}-R^{ub'}-, -R^{ub}-SiR^{ub"}R^{ub"'}-R^{ub'}- -R^{ub}-SiR^{ub"}R^{ub"'}-, -SiR^{ub"}R^{ub"'}-R^{ub}-, -R^{ub}-O-R^{ub'}-, -R^{ub}-CO-R^{ub'}-, -R^{ub}-CO-O-R^{ub'}-, -R^{ub}-O-CO-O-R^{ub'}-, -R^{ub}-O-CO-R^{ub'}-, -O-R^{ub'}-, -R^{ub}-CS-R^{ub'}-, -R^{ub}-CO-S-R^{ub'}-,-R^{ub}-S-CO-R^{ub'}-, -R^{ub}-CO-NH-R^{ub'}-, -R^{ub}-NH-CO-R^{ub'}-, -R^{ub}-O-, -R^{ub}-S-R^{ub'}- -S-R^{ub'}-, - R^{ub}-S-, -R^{ub}-SO-R^{ub'}- -SO-R^{ub'}- -R^{ub}-SO-, -R^{ub}-SO₂-R^{ub'}-, -SO₂-R^{ub'} oder -R^{ub}-SO₂- ist,
wobei R^{ub} und R^{ub'} unabhängig voneinander jeweils ein Rest mit bis zu 40 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander und/oder mit dem Rest Z optional eine zyklisierte und/oder anellierte Struktur ausbilden können,
wobei R^{ub"} und R^{ub"'} unabhängig voneinander jeweils ein Rest mit bis zu 40 Kohlenstoffatomen sind, unabhängig voneinander ausgewählt aus der Gruppe bestehend aus Wasserstoff, Halogen, -R^{t"'}, -OC(O)R^{t"'}, -COOH, -OR^{t'"}, -NR^{t"'}R^{t'"'}, - SiR^{t'"}R^{t'"'}R^{t'""} -SR^{t'"}, -SOR^{t'"}, -SO₂R^{t'"} und weiteren Donor- und Akzeptor-Gruppen, wie beispielsweise Carboxylaten und deren Estern und CF₃-Gruppen,
wobei R^{t'"}, R^{t'"'} und R^{t'""} unabhängig von einander ausgewählt sind aus der Gruppe bestehend aus H, OH, NH₂, NHR^{a'"}, NR^{a'"}R^{a""}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{t'"}, R^{t'"'}, R^{t'""}, R^{ub}, R^{ub'}, R^{ub"} und R^{ub"} optional auch zu anellierten Ringsystemen führen können; und
wobei mindestens einer der Reste Z oder Z' mit mindestens einer nicht-komplexierten ionischen Gruppe substituiert ist, bevorzugt mit einer Ammoniumgruppe, einer Carboxylgruppe, einer Sulfonatgruppe, einer Phosphonatgruppe, insbesondere mit - SO₃⁻ substituiert ist.

Folgende Beispiele sollen diese Liganden N^N verdeutlichen: 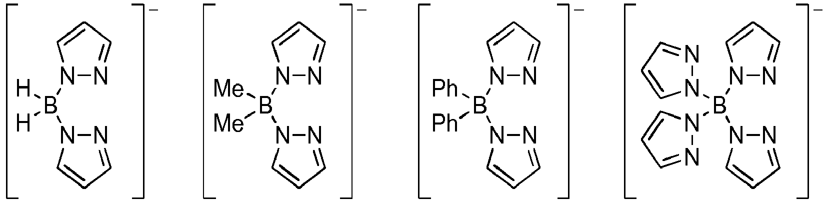 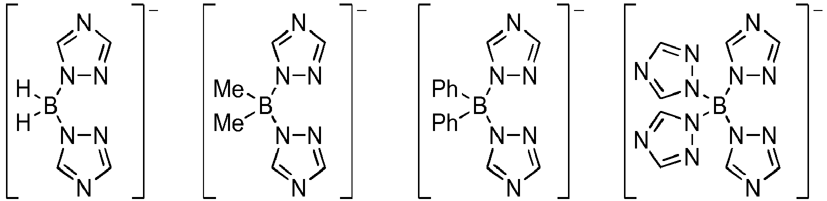 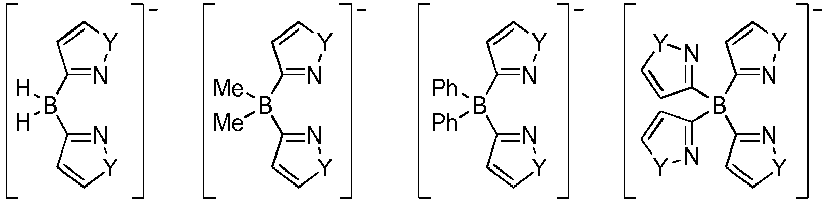 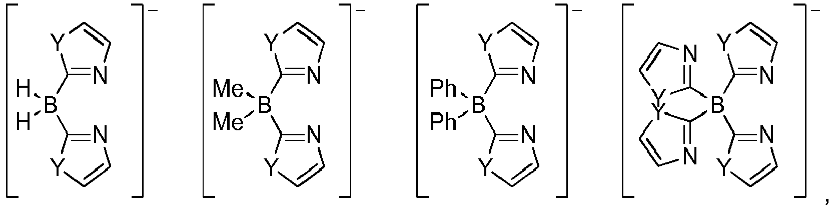 wobei Me für einen Methylrest und Ph für einen Phenylrest steht.

Ein weiterer Aspekt der Erfindung betrifft eine Zusammensetzung enthaltend einen Metall(I)-Komplex, der eine Struktur gemäß der folgenden Formel C aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für derartige Komplexe sind auch in WO 2014/102079 (siehe beispielsweise Formeln A und I-IX hieraus) gezeigt. 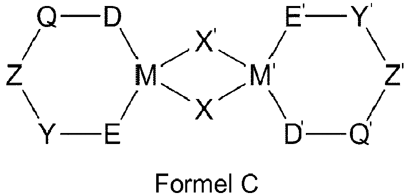 bei der M und M' unabhängig voneinander ausgewählt sind aus der Gruppe bestehend aus Cu, Ag und Au, insbesondere beide jeweils Cu sind;
bei der X und X' unabhängig voneinander ausgewählt sind aus der Gruppe bestehend aus Cl, Br, I, CN, OCN, SCN, Alkinyl und Azid;
bei der die E, Y, Z, Q und D umfassenden Liganden (EnD) und die bei der die E', Y', Z', Q' und D' umfassenden Liganden (E'∩D') jeweils ein zweizähniger Ligand sind,
wobei E und E' unabhängig voneinander jeweils entweder RR'E* ist, wobei E* für N, P, As oder Sb steht, wobei N ein Imin-Stickstoffatom oder Teil eines N-heteroaromatischen Rings ist oder nicht ist, oder E und E' unabhängig voneinander jeweils RE* ist, wobei E* für ein divalentes Carben C*, O oder S steht,
wobei R und R' jeweils unabhängig voneinander ausgewählt ist aus der Gruppe bestehend aus Wasserstoff, Halogen, Deuterium, -R¹, -OC(O)R¹, -COOH, -OR¹, - NR¹R^{1'}, -SiR¹R^{1'}R^{1"} -SR¹, -SOR¹, -SO₂R¹ und weiteren Donor- und Akzeptor-Gruppen, wie beispielsweise Carboxylaten und deren Estern und CF₃-Gruppen,
wobei R¹, R^{1'} und R^{1"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei R^{x} und R^{y} unabhängig von einander ausgewählt sind aus der Gruppe bestehend aus einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei der/die Reste R¹, R^{1'}, R^{1''}, R und R' optional auch zu anellierten Ringsystemen führen können;
wobei D und D' unabhängig voneinander jeweils entweder R"R"'D* ist, wobei D* für N, P, As oder Sb steht, wobei N ein Imin-Stickstoffatom oder Teil eines N-heteroaromatischen Rings ist oder nicht ist, oder D und D' unabhängig voneinander jeweils R"D* ist, wobei D* für ein divalentes Carben C*, O oder S steht,
wobei R" und R'" jeweils unabhängig voneinander ausgewählt ist aus der Gruppe bestehend aus Wasserstoff, Halogen, Deuterium, -R², -OC(O)R², -COOH, -OR²,-NR²R^{2'}, -SiR²R^{2'}R^{2"} -SR², -SOR², -SO₂R² und weiteren Donor- und Akzeptor-Gruppen, wie beispielsweise Carboxylaten und deren Estern und CF₃-Gruppen,
wobei R², R^{2'} und R^{2"} unabhängig von einander ausgewählt sind aus der Gruppe bestehend aus H, OH, NH₂, NHR¹, NR¹R^{1'}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei der/die Reste R², R^{2'}, R^{2"} und R" und R'" optional auch zu anellierten Ringsystemen führen können;
wobei D und E verschieden voneinander oder gleichartig sind;
wobei Q, Y, Z, Q', Y' und Z' unabhängig von einander jeweils ausgewählt sind aus der Gruppe bestehend aus einem substituierten oder unsubstituierten C₁₋₉-Alkylen-, C₂₋₈-Alkenylen-, C₂₋₈-Alkinylen- oder Arylenrest, -R^{a}-NR^{a"}-, -NR^{a"}-R^{a}-, -R^{a}-NR^{a"}-R^{a'}-, -R^{a}-SiR^{a"}R^{a"'}-R^{a'}-, -R^{a}-SiR^{a"} R^{a'"}-, -SiR^{a"}R^{a"'}-R^{a}-, -R^{a}-O-R^{a'}-, -R^{a}-CO-R^{a'}-, -R^{a}-CO-O-R^{a'}-, -R^{a}-O-CO-O-R^{a'}-, -R^{a}-O-CO-R^{a'}-, -O-R^{a'}-, -R^{a}-CS-R^{a'}-, -R^{a}-CO-S-R^{a'}-, -R^{a}-S-CO-R^{a'}-, -R^{a}-CO-NH-R^{a'}-, -R^{a}-NH-CO-R^{a'}-, -R^{a}-O-, -R^{a}-S-R^{a'}-, -S-R^{a'}-, -R^{a}-S-, -R^{a}-SO-R^{a'}-, -SO-R^{a'}-, - R^{a}-SO-, -R^{a}-SO₂-R^{a'}-, -SO₂-R^{a'}-, oder -R^{a}-SO₂- ist,
wobei R^{a'"} und R^{a'} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest, der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander und/oder mit dem Rest D optional eine zyklisierte und/oder anellierte Struktur ausbilden können,
wobei R^{a"} und R^{a"'} unabhängig voneinander jeweils ein Rest mit bis zu 20 Kohlenstoffatomen sind, unabhängig voneinander ausgewählt aus der Gruppe bestehend aus Wasserstoff, Deuterium, Halogen, -R^{c}, -OC(O)R^{c}, -COOH, -OR^{c},-NR^{c}R^{c'}, -SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NHR¹, NR¹R^{1'}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c'}, R^{c"}, R^{a}, R^{a'}, R^{a"} und R^{a"'} optional auch zu anellierten Ringsystemen führen können; und
wobei mindestens einer der Reste Q, Z, Y, Q', Z' und/oder Y' mit mindestens einer nicht-komplexierten ionischen Gruppe substituiert ist, bevorzugt mit einer Ammoniumgruppe, einer Carboxylgruppe, einer Sulfonatgruppe und/oder einer Phosphonatgruppe, insbesondere mit -SO₃⁻ substituiert ist.

Optional können auch die beiden zweizähnigen Liganden EnD und E'∩D' über eine Spacereinheit S (z.B. eine C₁₋₁₀-Alkylengruppe) miteinander verbunden sein, sodass sich ein vierzähniger Ligand ergibt.

Optional kann eine Verbesserung der Löslichkeit des Metall-Komplexes erreicht werden, indem mindestens einer der Liganden EnD und E'∩D' einen entsprechenden Substituenten trägt.

Ein weiterer Aspekt der Erfindung betrifft eine Zusammensetzung enthaltend einen Metall(I)-Komplex, der eine Struktur gemäß der folgenden Formel D aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für derartige Komplexe sind auch in der europäischen Patentanmeldung Nr. 14164815 gezeigt. 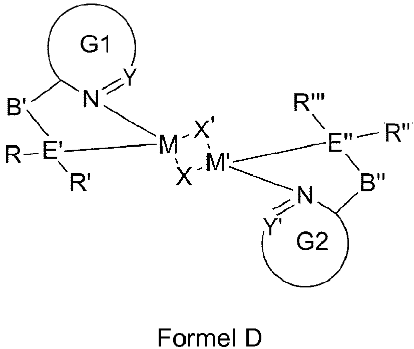 bei der M und M' unabhängig voneinander ausgewählt sind aus der Gruppe bestehend aus Cu, Ag und Au, insbesondere beide Cu sind;
bei der X und X' unabhängig von einander Halogenide, insbesondere ausgewählt aus der Gruppe bestehend aus Cl, Br, I, oder Pseudohalogenide sind;
bei der E' und E" unabhängig von einander ausgewählt sind aus der Gruppe bestehend aus P, As und Sb;
bei der R, R', R" und R'" unabhängig von einander ausgewählt sind aus der Gruppe bestehend aus optional substituierten Alkyl-, Aryl-, Heteroaryl- und Alkoxyresten mit jeweils bis zu 20 Kohlenstoffatomen;
bei der N Stickstoff ist;
bei der Y und Y' der Ringsysteme G1 und G2 jeweils unabhängig von einander ausgewählt sind aus der Gruppe bestehend aus einem substituierten oder unsubstituierten C₁₋₉-Alkylen-, C₂₋₈-Alkenylen-, C₂₋₈-Alkinylen- oder Arylenrest, =R^{a}-NR^{a"}-, =N-R^{a}-, =R^{a}-NR^{a"}-R^{a'}-, =R^{a}-SiR^{a"}R^{a"'}-R^{a'}-,=R^{a}-SiR^{a"}R^{a"'}-, =R^{a}-O-R^{a'}-, =R^{a}-CO-R^{a'}-, =R^{a}-CO-O-R^{a'}-, =R^{a}-O-CO-O-R^{a'}-, =R^{a}-O-CO-R^{a'}-, -O-Ra^{'}-, =R^{a}-CS-R^{a'}-, =R^{a}-CO-S-R^{a'}-, =R^{a}-S-CO-R^{a'}-, =R^{a}-CO-NH-R^{a'}-, =R^{a}-NH-CO-R^{a'}-, =R^{a}-O-, =R^{a}-S-R^{a'}-, =R^{a}-S-, =R^{a}-SO-R^{a'}-, =R^{a}-SO-, =R^{a}-SO₂-R^{a'}- und =R^{a}-SO₂- ist,
wobei R^{a} und R^{a'} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest, der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donorund Akzeptor-Gruppen wie beispielsweise Aminen, Phosphinen, Carboxylaten und deren Estern und CF₃-Gruppen, substituiert sein kann, wobei die Substituenten miteinander optional eine zyklisierte und/oder anellierte Struktur ausbilden können,
wobei R^{a"} und R^{a"'} unabhängig voneinander jeweils ein Rest mit bis zu 20 Kohlenstoffatomen sind, unabhängig voneinander ausgewählt aus der Gruppe bestehend aus Wasserstoff, Deuterium, Halogen, -R^{c}, -OC(O)R^{c}, -COOH, -OR^{c},-NR^{c}R^{c'}, -SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei R^{x} und R^{y} unabhängig von einander ausgewählt sind aus der Gruppe bestehend aus einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c}, R^{c"}, R^{a}, R^{a'}, R^{a"} und R^{a'"} optional auch zu anellierten Ringsystemen führen können;
bei der B und B' jeweils unabhängig von einander eine Überbrückung einer Kettenlänge von mindestens 2 und höchstens 17 Atomen sind,
wobei die Glieder aus -CH₂-, -CHR¹-, -CR¹R²-, -SiR¹R²-, -GeR¹R²-, -O-, -S-, -Se-, -NR¹-, -PR¹- and/oder -AsR¹- bestehen können,
wobei R¹ und R² jeweils unabhängig von einander ein Rest ausgewählt aus der Gruppe bestehend aus einem Alkyl-, Aryl-, Heteroarylrest, -OR³, -SR³, -SeR³, -H und -D mit jeweils bis zu 20 Kohlenstoffatomen sind,
wobei R³ ein Alkyl-, Aryl-, Heteroarylrest, mit jeweils bis zu 20 Kohlenstoffatomen , -H oder -D ist; und
wobei mindestens einer der Reste R-R'" und/oder G1 und/oder G1 mit mindestens einer nicht-komplexierten ionischen Gruppe substituiert ist, bevorzugt mit einer Ammoniumgruppe, einer Carboxylgruppe, einer Sulfonatgruppe, einer Phosphonatgruppe, insbesondere mit -SO₃⁻ substituiert ist.

Bevorzugt sind die Ringsysteme G1 und G2 jeweils ein fünf- oder sechsgliedriges heteroaromatisches Ringsystem, welches optional mit weiteren Resten wie R, R'; R", R'", R^{a"} und/oder R^{a"'} substituiert oder mit weiteren aromatischen Ringen anelliert sein kann.

Ein weiterer Aspekt der Erfindung betrifft eine Zusammensetzung enthaltend einen Metall(I)-Komplex, der eine Struktur gemäß der folgenden Formel E aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für derartige Komplexe sind auch in WO 2013/014066 (siehe beispielsweise Formel IV hieraus) gezeigt. 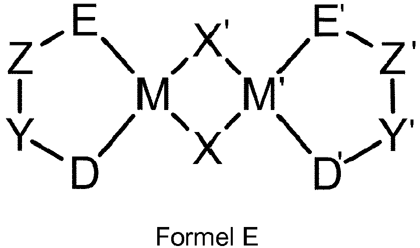 bei der M und M' unabhängig voneinander ausgewählt sind aus der Gruppe bestehend aus Cu, Ag und Au, insbesondere beide Cu sind;
bei der X und X' unabhängig von ausgewählt sind aus der Gruppe bestehend aus Cl, Br, I, CN, OCN, SCN, C₁₋₁₀-Alkinyl und Azid;
bei der die E, Y, Z und D umfassenden Liganden (EnD) und die bei der die E', Y', Z' und D' umfassenden Liganden (E'∩D') jeweils ein zweizähniger Ligand sind;
wobei E und E' unabhängig voneinander jeweils entweder RR'E* ist, wobei E* für N, P, As oder Sb steht, wobei N ein Imin-Stickstoffatom oder Teil eines N-heteroaromatischen Rings ist oder nicht ist, oder E und E' unabhängig voneinander jeweils RE* sind, wobei E* für ein divalentes Carben C*, O oder S steht,
wobei R und R' jeweils unabhängig voneinander ausgewählt ist aus der Gruppe bestehend aus Wasserstoff, Halogen, Deuterium, -R¹, -OC(O)R¹, -COOH, -OR¹,-NR¹R^{1'}, -SiR¹R^{1'}R^{1"} -SR¹, -SOR¹, -SO₂R¹ und weiteren Donor- und Akzeptor-Gruppen, wie beispielsweise Carboxylaten und deren Estern und CF₃-Gruppen,
wobei R¹, R^{1'} und R^{1"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei R^{x} und R^{y} unabhängig von einander ausgewählt sind aus der Gruppe bestehend aus einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei der/die Reste R¹, R^{1'}, R^{1"} und R und R' optional auch zu anellierten Ringsystemen führen können;
wobei D und D' unabhängig voneinander jeweils entweder R"R"'D* ist, wobei D* für N, P, As oder Sb steht, wobei N ein Imin-Stickstoffatom oder Teil eines N-heteroaromatischen Rings ist oder nicht ist, oder D und D' unabhängig voneinander jeweils R"D* ist, wobei D* für ein divalentes Carben C*, O oder S steht,
wobei R" und R'" jeweils unabhängig voneinander ausgewählt ist aus der Gruppe bestehend aus Wasserstoff, Halogen, deuterium, -R², -OC(O)R², -COOH, -OR²,-NR²R^{2'}, -SiR²R^{2'}R^{2"} -SR², -SOR², -SO₂R² und weiteren Donor- und Akzeptor-Gruppen, wie beispielsweise Carboxylaten und deren Estern und CF₃-Gruppen,
wobei R², R^{2'} und R^{2"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei der/die Reste R², R^{2'}, R^{2"} und R" und R'" optional auch zu anellierten Ringsystemen führen können;
wobei D und E verschieden voneinander oder gleichartig sind;
wobei Y, Z, Y' und Z' unabhängig von einander jeweils ausgewählt sind aus der Gruppe bestehend aus einem substituierten oder unsubstituierten C₁₋₉-Alkylen-, C₂₋₈-Alkenylen-, C₂₋₈-Alkinylen- oder Arylenrest, -R^{a}-NR^{a"}-, -NR^{a"}-R^{a}-, -R^{a}-NR^{a"}-R^{a'}-, -R^{a}-SiR^{a"}R^{a'"}-R^{a'}-,-R^{a}-SiR^{a"}R^{a"'}-, -SiR^{a"}R^{a"'}-R^{a}-, -R^{a}-O-R^{a'}-, -R^{a}-CO-R^{a'}-, -R^{a}-CO-O-R^{a'}-, -R^{a}-O-CO-O-R^{a'}-,-R^{a}-O-CO-R^{a'}-, -O-R^{a'}, -R^{a}-CS-R^{a'}-, -R^{a}-CO-S-R^{a'}-, -R^{a}-S-CO-R^{a'}-, -R^{a}-CO-NH-R^{a'}-, -R^{a}-NH-CO-R^{a'}-, -R^{a}-CO-NR^{x}-R^{a'}-, -R^{a}-NR^{x}-CO-R^{a'}-, -R^{a}-O-, -R^{a}-S-R^{a'}-, -S-R^{a'}, -R^{a}-S-, -R^{a}-SO-R^{a'}-, -SO-R^{a'}, -R^{a}-SO-, -R^{a}-SO₂-R^{a'}-, -SO₂-R^{a'} oder -R^{a}-SO₂- ist,
wobei R^{a} und R^{a'} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest, der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donorund Akzeptor-Gruppen wie beispielsweise Aminen, Phosphinen, Carboxylaten und deren Estern und CF₃-Gruppen, substituiert sein kann, wobei die Substituenten miteinander und/oder mit dem Rest D optional eine zyklisierte und/oder anellierte Struktur ausbilden können,
wobei R^{a"} und R^{a'"} unabhängig voneinander jeweils ein Rest mit bis zu 20 Kohlenstoffatomen sind, unabhängig voneinander ausgewählt aus der Gruppe bestehend aus Wasserstoff, Deuterium, Halogen, -R^{c}, -OC(O)R^{c}, -COOH, -OR^{c},-NR^{c}R^{c'}, -SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c'}, R^{c"}, R^{a}, R^{a'}, R^{a"}, R^{a"'} optional auch zu anellierten Ringsystemen führen können; und
wobei mindestens einer der Reste Z, Y, Y' oder Z' mit mindestens einer nicht-komplexierten ionischen Gruppe substituiert ist, bevorzugt mit einer Ammoniumgruppe, einer Carboxylgruppe, einer Sulfonatgruppe, einer Phosphonatgruppe, insbesondere mit -SO₃⁻ substituiert ist.

Optional können auch die beiden zweizähnigen Liganden EnD und E'∩D' über eine Spacereinheit S (z.B. eine C₁₋₁₀-Alkylengruppe) miteinander verbunden sein, sodass sich ein vierzähniger Ligand ergibt.

Optional kann eine Verbesserung der Löslichkeit des Metall-Komplexes erreicht werden, indem mindestens einer der Liganden EnD und E'∩D' einen entsprechenden Substituenten trägt.

Ein weiterer Aspekt der Erfindung betrifft eine Zusammensetzung enthaltend einen Metall(I)-Komplex, der eine Struktur gemäß der folgenden Formel F aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für derartige Komplexe sind auch in WO 2013/017675 (siehe beispielsweise Formel A hieraus) gezeigt. 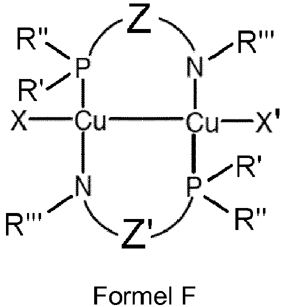 bei der X und X' jeweils unabhängig von einander ausgewählt sind aus der Gruppe bestehend aus Cl, Br, I, CN, OCN, SCN, C₁₋₁₀-Alkinyl und Azid;
bei der Z und Z' unabhängig von einander eine kovalente Verbrückung, die mindestens zwei Kohlenstoff- und/oder Stickstoffatome umfasst darstellen,
wobei P Phosphor und N Stickstoff ist;
bei der der P, Z und N umfassende Ligand (P∩N) und der P, Z' und N umfassende Ligand (P∩N') jeweils ein mit einem N-Heterozyklus substituierter Phosphanligand ist, der eine Struktur gemäß Formel G aufweist: 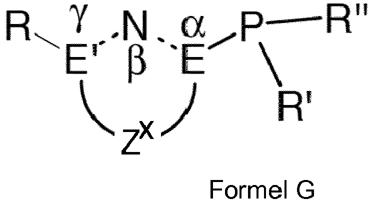 wobei P Phosphor und N Stickstoff ist;
wobei E ein Kohlenstoff- oder Stickstoffatom ist;
wobei E' ein Kohlenstoff- oder Stickstoffatom ist, das nicht an ein Wasserstoffatom gebunden ist;
wobei die gestrichelte Bindung eine Einfach- oder Doppelbindung ist;
wobei R ein optional substituierter, optional verzweigter C₁₋₂₀-Alkyl-Rest, bevorzugt ein C₆₋₂₀-Alkyl-Rest oder ein optional alkylierter C₆₋₂₀-Aryl-Rest, insbesondere Phenyl, ist, wobei eine Substitution hierbei eine Substitution mit einem oder mehreren Halogenen (z.B. F, Cl, Br und/oder I), Silangruppen, Ethergruppen oder optional ihrerseits substituierten Alkyl-, Alkenyl- und/oder Alkinyl-Gruppen sein kann;
bei der R' und R" unabhängig von einander ausgewählt sind aus der Gruppe bestehend aus Alkyl-Gruppen, bevorzugt C₆₋₂₀-Alkyl-Gruppen, sind, die auch verzweigt oder cyclisch sein können, oder
Aryl- oder Heteroarylgruppen, die optional mit Alkyl-Gruppen, Halogenen (z.B., F, Cl, Br und/oder I), Silangruppen oder Ethergruppen substituiert sein können,
wobei R' und R" jeweils direkt an dem Phosphoratom des Phosphan-Liganden gebunden sind;
bei der R'" ausgewählt ist aus der Gruppe bestehend aus Alkyl-Gruppen, bevorzugt C₆₋₂₀-Alkyl-Gruppen, sind, die auch verzweigt oder cyclisch sein können, oder Aryl- oder Heteroarylgruppen, die optional mit Alkyl-Gruppen, Halogenen (z.B., F, Cl, Br und/oder I), Silangruppen oder Ethergruppen substituiert sein können,
wobei R'" mit Z auch ein Ringsystem ausbinden kann, daher einen aliphatischen oder aromatischen Heterozyklus,
wobei Z, Z' und Z^{x} unabhängig von einander jeweils ausgewählt sind aus der Gruppe bestehend aus einem substituierten oder unsubstituierten C₁₋₉-Alkylen-, C₂₋₈-Alkenylen-, C₂₋₈-Alkinylen- oder Arylenrest, -R^{a}-NR^{a"}-, -NR^{a"}-R^{a"}-, -R^{a}-NR^{a"}-R^{a'}-, -R^{a}-SiR^{a"}R^{a"'}-R^{a'}-,-R^{a}-SiR^{a"}R^{a"'}-, -SiR^{a"}R^{a'"}-R^{a}-, -R^{a}-O-R^{a'}-, -R^{a}-CO-R^{a'}-, -R^{a}-CO-O-R^{a'}-, -R^{a}-O-CO-O-R^{a'}-,-R^{a}-O-CO-R^{a'}-, -O-R^{a'}-, -R^{a}-CS-R^{a'}-, -R^{a}-CO-S-R^{a'}-, -R^{a}-S-CO-R^{a'}-, -R^{a}-CO-NH-R^{a'}-, -R^{a}-NH-CO-R^{a'}-, -R^{a}-O-, -R^{a}-S-R^{a'}-, -S-R^{a'}, -R^{a}-S-, -R^{a}-SO-R^{a'}-, -SO-R^{a'}-, -R^{a}-SO-, -R^{a}-SO₂-R^{a'}-, -SO₂-R^{a'}, -R^{a}-CO-NR^{a"}-R^{a'}-, -R^{a}-NR^{a'}-CO-R^{a'}-, und -R^{a}-SO₂- ist,
wobei R^{a} und R^{a'} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander optional eine zyklisierte und/oder anellierte Struktur ausbilden können,
wobei R^{a"} und R^{a'"} unabhängig voneinander jeweils ein Rest mit bis zu 20 Kohlenstoffatomen sind, unabhängig voneinander ausgewählt aus der Gruppe bestehend aus Wasserstoff, Deuterium, Halogen, -R^{c}, -OC(O)R^{c}, -COOH, -OR^{c},-NR^{c}R^{c'}, -SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei R^{x} und R^{y} unabhängig von einander ausgewählt sind aus der Gruppe bestehend aus einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c}, R^{c"}, R^{a}, R^{a'}, R^{a"} und R^{a"'} optional auch zu anellierten Ringsystemen führen können; und
wobei mindestens einer der Reste Z oder Z' mit mindestens einer nicht-komplexierten ionischen Gruppe substituiert ist, bevorzugt mit einer Ammoniumgruppe, einer Carboxylgruppe, einer Sulfonatgruppe, einer Phosphonatgruppe, insbesondere mit - SO₃⁻ substituiert ist.

Ein weiterer Aspekt der Erfindung betrifft eine Zusammensetzung enthaltend einen Cu(I)-Komplex, der eine Struktur gemäß der folgenden Formel H aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für derartige Komplexe sind auch in WO 2013/072508 (siehe beispielsweise Formel A hieraus), WO 2010/149748 (siehe beispielsweise Formel A hieraus) und WO 2013/001086 (siehe beispielsweise Formel A hieraus) gezeigt. 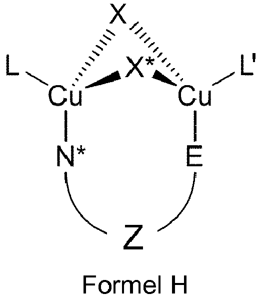 bei der X und X* jeweils unabhängig von einender ausgewählt sind aus der Gruppe bestehend aus Cl, Br, I, CN, OCN, SCN, C₁₋₁₀-Alkinyl und Azid;
bei der N* ein Stickstoffatom, das mit Cu eine Bindung eingeht ist;
wobei E RR'E* ist, wobei E* für N, P, As oder Sb steht, wobei N ein Imin-Stickstoffatom oder Teil eines N-heteroaromatischen Rings ist oder nicht ist, oder E RE* ist, wobei E* für ein divalentes Carben C*, O oder S steht,
wobei R und R' jeweils unabhängig voneinander ausgewählt ist aus der Gruppe bestehend aus Wasserstoff, Halogen, Deuterium, -R¹, -OC(O)R¹, -COOH, -OR¹,-NR¹R^{1'}, -SiR¹R^{1'}R^{1"} -SR¹, -SOR¹, -SO₂R¹ und weiteren Donor- und Akzeptor-Gruppen, wie beispielsweise Carboxylaten und deren Estern und CF₃-Gruppen,
wobei R¹, R^{1'} und R^{1"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei R^{x} und R^{y} unabhängig von einander ausgewählt sind aus der Gruppe bestehend aus einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei der/die Reste R¹, R^{1'}, R^{1"} und R und R' optional auch zu anellierten Ringsystemen führen können;
bei der Z eine kovalente Verbrückung, die mindestens zwei Kohlenstoff- und/oder Stickstoffatome umfasst, ist;
bei der die Liganden L und L' unabhängig voneinander jeweils ein beliebiger organischer Ligand mit 1 bis 20 Kohlenstoffatomen sind, die bevorzugt eine oder mehrere Gruppen enthalten, ausgewählt aus der Gruppe bestehend aus -OC(O)R^{c},-COOH, -OR^{c}, -NR^{c}R^{c'}, -SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern, CF₃-Gruppen, phosphor-, arsen- oder antimonhaltige Gruppen,
wobei R^{c}, R^{c'} und R^{c"} unabhängig von einander ausgewählt sind aus der Gruppe bestehend aus H, OH, NH₂, NHR^{a"}, NR^{a"}R^{a"'}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrestund einem C₇₋₃₂-Heteroalkylarylalkylrest,
wobei die Reste R^{c}, R^{c'}, R^{c}, R^{d}, R^{d'}, R^{d"} und R^{d"'} optional auch zu anellierten Ringsystemen führen können, wobei L und L' auch miteinander verbunden und wie oben bei Formel A beschrieben definiert sein können oder wie unten stehend gemäß Formel K definiert sein können;
bei der der N*, Z und E umfassende Ligand (E∩N*) ein zweizähniger Ligand gemäß der Struktur nach Formel K sein kann: 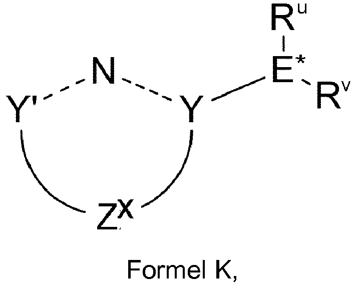 bei der Y ein Kohlenstoff- oder Stickstoffatom ist;
bei der Y' ein Kohlenstoff- oder Stickstoffatom ist, das mit einem Wasserstoffatom substituiert ist;
bei der E* ausgewählt ist aus der Gruppe bestehend aus P, N, As, Sb, einem divalenten Carben C*, O und S;
wobei die gestrichelte Bindung eine Einfach- oder Doppelbindung ist;
bei der N ein Stickstoffatom, das in eine Imin-Gruppe eingebunden ist darstellt, die Bestandteil einer heteroaromatischen Gruppe umfassend N, Y, Y'und Z^{x} darstellt, wobei die heteroaromatische Gruppe bevorzugt ausgewählt ist aus der Gruppe bestehend aus Pyridyl, Pyrimidyl, Pyridazinyl, Triazinyl, Oxazolyl, Thiazolyl, Imidazolyl, die optional substituiert sein können (beispielsweise mit einem oder mehrerer der Substituenten der vorstehend genannten Gruppe) und/oder mit anderen Gruppen des Komplexes anelliert sein können,
bei der R^{u} und R^{v} unabhängig von einander ausgewählt sind aus der Gruppe bestehend aus Alkyl-Gruppen, bevorzugt C₆₋₂₀-Alkyl-Gruppen, sind, die auch verzweigt oder cyclisch sein können, oder Aryl- oder Heteroarylgruppen, die optional mit Alkyl-Gruppen, Halogenen (z.B., F, Cl, Br und/oder I), Silan- oder Ethergruppen substituiert sein können;
bei der Z und Z^{x} unabhängig von einander jeweils ausgewählt sind aus der Gruppe bestehend aus einem substituierten oder unsubstituierten C₁₋₉-Alkylen-, C₂₋₈-Alkenylen-, C₂₋₈-Alkinylen- oder Arylenrest, -R^{a}-NR^{a"}-, -NR^{a"}-R^{a}-, -R^{a}-NR^{a"}-R^{a'}-, -R^{a}-SiR^{a"}R^{a"'}-R^{a'}-,-R^{a}-SiR^{a"}R^{a'"}-, -SiR^{a"}R^{a"'}-R^{a}-, -R^{a}-O-R^{a'}-, -R^{a}-CO-R^{a'}-, -R^{a}-CO-O-R^{a'}-, -R^{a}-O-CO-O-R^{a'}-,-R^{a}-O-CO-R^{a'}-, -O-R^{a}-, -R^{a}-CS-R^{a'}-, -R^{a}-CO-S-R^{a'}-, -R^{a}-S-CO-R^{a'}-, -R^{a}-CO-NH-R^{a'}-, -R^{a}-NH-CO-R^{a'}-, -R^{a}-O-, -R^{a}-S-R^{a'}-, -S-R^{a'}-, -R^{a}-S-, -R^{a}-SO-R^{a'}-, -SO-R^{a'}-, -R^{a}-SO-, -R^{a}-SO₂-R^{a'}-, -SO₂-R^{a'}- und -R^{a}-SO₂- ist,
wobei R^{a} und R^{a'} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander optional eine zyklisierte und/oder anellierte Struktur ausbilden können,
wobei R^{a"} und R^{a'"} unabhängig voneinander jeweils ein Rest mit bis zu 20 Kohlenstoffatomen sind, unabhängig voneinander ausgewählt aus der Gruppe bestehend aus Wasserstoff, Deuterium, Halogen, -R^{c}, -OC(O)R^{c}, -COOH, -OR^{c},-NR^{c}R^{c'}, -SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei R^{x} und R^{y} unabhängig von einander ausgewählt sind aus der Gruppe bestehend aus einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c}, R^{c"}, R^{a}, R^{a'}, R^{a"} und R^{a'"} optional auch zu anellierten Ringsystemen führen können; und
wobei mindestens einer der Reste Z (bzw. Z^{x}) mit mindestens einer nicht-komplexierten ionischen Gruppe substituiert ist, bevorzugt mit einer Ammoniumgruppe, einer Carboxylgruppe, einer Sulfonatgruppe, einer Phosphonatgruppe, insbesondere mit - SO₃⁻ substituiert ist.

Bevorzugt ist die heteroaromatische Gruppe umfassend N, Y, Y' und Z^{x} ausgewählt aus der Gruppe bestehend aus Pyridyl, Pyrimidyl, Pyridazinyl, Triazinyl, Oxazolyl, Thiazolyl, Imidazolyl, die jeweils optional substituiert und/oder mit anderen Gruppe des Komplexes anelliert sein können.

Bevorzugt handelt es sich bei den Liganden L und L' gemäß Formel H um einzähnige Liganden mit bis zu 42 Kohlenstoffatomen.

Das nachfolgend aufgeführte Ausführungsbeispiel und die Ansprüche dienen der näheren Darstellung und Erläuterung der Erfindung.

### Beispiel.

Unter einer Schutzgasatmosphäre werden 100 mg Triphenylphosphin-3-natriumsulfonat in 5 mL Ethanol gelöst und mit 47 mg CuI versetzt. Anschließend erfolgt die Zugabe des Diphenyl-2-picolylphopshins (34mg). Es wird über Nacht bei RT gerührt und die gelbe Lösung wird mit Diethylether behandelt. Der gelbe Feststoff wird abfiltriert und mit Diethylether gewaschen. Nach Trocknung im Vakuum erhält man einen gelben Feststoff.

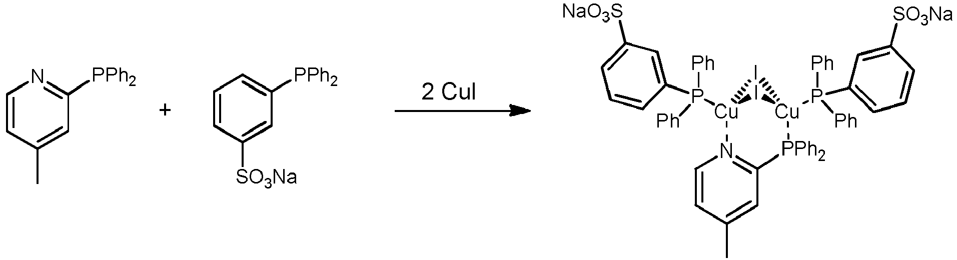

Das Emissionsmaximum (Eₘₐₓ) liegt bei 545 nm. Die Quantenausbeute bei 68%. Somit kann eine gute Lichtausbeute im gewünschten sichtbaren Spektrum erreicht werden. Zudem ist eine aus dieser Verbindung hergestellte Emitterschicht B ist besonders gut leitfähig.

## Patentansprüche

1. Metall(I)-Komplex eines Metalls M, ausgewählt aus der Gruppe bestehend aus Cu, Ag und Au, wobei das Metall(I) komplexiert ist mit:
I.) mindestens einem organischen Liganden L, der mindestens eine nichtkomplexierte ionische Gruppe enthält; und
II.) mindestens einem anorganischen Liganden X ausgewählt aus der Gruppe bestehend aus einem Halogenid, einem Thiosulfation, einem Isocyanation, einem Cyanidion und einem Azid,
wobei der Metall(I)-Komplex ein Salz darstellt.

2. Metall(I)-Komplex gemäß Anspruch 1, bei dem das komplexierte Metall(I) Cu(I) und der anorganische Ligand X ein Halogenid ist, bevorzugt Iodid, Bromid oder Chlorid ist, insbesondere Iodid ist.

3. Metall(I)-Komplex gemäß Anspruch 1 oder 2, bei dem der Metall(I)-Komplex ein vierfach koordinierter organischer Cu(I)-Komplex ist, bevorzugt wobei der Metall(I)-Komplex zwei vierfach komplexierte Cu(I) enthält, wobei die Cu(I) zudem jeweils zwei Bindungen mit Halogenid eingehen.

4. Metall(I)-Komplex gemäß einem der Ansprüche 1 bis 3, bei dem der Metall(I)-Komplex eine Struktur gemäß einer der folgenden Formeln (I) oder (II) aufweist: 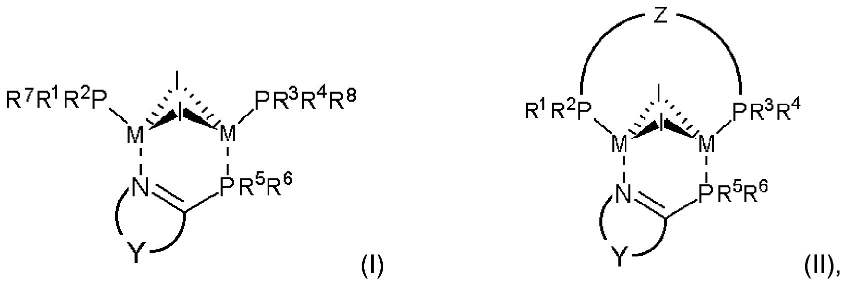 in der R¹, R², R³, R⁴, R⁵, R⁶, R⁷ und R⁸ unabhängig voneinander je einen beliebigen organischen Rest, bevorzugt einen substituierten oder unsubstituierten Arylrest, einen substituierten oder unsubstituierten Alkylarylrest, einen substituierten oder unsubstituierten Arylalkylrest oder einen substituierten oder unsubstituierten C₁₋₂₀-Alkylrest, darstellen, wobei mindestens einer der Reste R¹, R², R³, R⁴, R⁵, R⁶, R⁷ und R⁸die ionische Gruppe enthält;
wobei M ein Metall(I), bevorzugt Cu(I), Ag(I) oder Au(I), insbesondere Cu(I) ist;
in der Y eine beliebige bivalente Gruppe ist, bevorzugt eine bivalente Gruppe, die zusammen mit dem Kohlenstoffatom und dem Stickstoffatom der Struktur der Formeln (I) oder (II) ein konjugiertes π-Elektronensystem enthält, bevorzugt eine bivalente Gruppe ist, die zusammen mit dem Kohlenstoffatom und dem Stickstoffatom der Struktur der Formeln (I) oder (II) ein mono-, di-, tri- oder polyzyklisches, substituiertes oder unsubstituiertes aromatisches Ringsystem bildet; welches auch anelliert sein kann, und
wobei in der Struktur gemäß Formel (II) Z eine beliebige bivalente Gruppe ist, bevorzugt eine bivalente Gruppe ausgewählt aus der Gruppe bestehend aus -R^{a}-, -O-R^{a}-O-, -R^{a}-N=N-, -N=N-R^{a}-, -R^{a}-N=N-R^{b}-, -O-R^{a}-, -R^{a}-O-, -R^{a}-O-R^{b}-, -NR^{d}-R^{a}-, -R^{a}-NR^{d}-, -R^{a}-NR^{d}-R^{a}-, -NR^{d}-R^{a}-NR^{e}-, -R^{a}-NR^{d}-NR^{e}-, -R^{a}-N=N-, -NR^{d}-NR^{e}-R^{a}-, -N=N-R^{a}-, -R^{a}-N=N-R^{b}-, -N=CR^{d}-NR^{e}-, -R^{a}-N=CR^{d}-NR^{e}-, -R^{a}-N=CR^{d}-NR^{e}-R^{b}-, -N=CR^{d}-NR^{e}-R^{a}-, -N=CR^{d}-R^{a}-NH- -R^{a}-N=CR^{d}-R^{b}-NR^{e}-, -N=CR^{d}-R^{a}-NR^{e}-R^{a}-,-R^{a}-N=CR^{d}-R^{b}-NR^{e}-R^{c}-, -NR^{d}-CR^{e}=N-, -R^{a}-NR^{d}-CR^{e}=N-, -NR^{d}-CR^{e}=N-R^{a}-, -R^{a}-NR^{d}-CR^{e}=N-R^{b}-, -NR^{d}-R^{a}-CR^{e}=N-, -R^{a}-NR^{d}-R^{b}-CR^{e}=N-, -NR^{d}-R^{a}-CR^{e}=N-R^{b}-, -R^{a}-NR^{d}-R^{b}-CR^{e}=N-R^{a}-, -R^{a}-N=C=N-, -N=C=N-R^{a}-, -N=CR^{d}-CR^{e}=N-, -R^{a}-N=CR^{d}-CR^{e}=N-, -N=CR^{d}-CR^{e}=N-R^{a}-, -R^{a}-N=CR^{d}-CR^{e}=N-R^{b}-, -N=CR^{d}-R^{a}-CR^{e}=N-R^{b}-,-R^{a}-N=CR^{d}-R^{b}-CR^{e}=N-, -R^{a}-N=CR^{d}-R^{b}-CR^{e}=N-R^{c}-, -O-R^{a}-NR^{d}-R^{a}-O-R^{b}-NH-, -O-R^{a}-NR^{d}-R^{b}-, -R^{a}-O-R^{b}-NR^{d}-R^{c}-, -NR^{d}-R^{a}-O- -R^{a}-NR^{d}-R^{b}-O-, -NR^{d}-R^{a}-O-R^{b}- -R^{a}-NR^{d}-R^{b}-O-R^{c}-, -R^{a}-CO-NR^{d}-, -CO-NR^{d}-R^{a}-, -R^{a}-CO-NR^{d}-R^{a}-, -R^{a}-NR^{d}-CO-, -NR^{d}-CO-R^{a}- oder -R^{a}-NR^{d}-CO-R^{a}-, S-R^{a}-S-, -O-R^{a}-S-, -S-R^{a}-O-, -S-R^{a}-, -R^{a}-S-, -R^{a}-S-R^{b}-, -S-R^{a}-NR^{d}-, -R^{a}-S-R^{b}-NR^{d}-, -S-R^{a}-NR^{d}-R^{b}-, -R^{a}-S-R^{b}-NR^{d}-R^{c}-, -NR^{d}-R^{a}-S-,-R^{a}-NR^{d}-R^{b}-S-, -NR^{d}-R^{a}-S-R^{b}-, -R^{a}-NR^{d}-R^{b}-S-R^{c}-, -R^{a}-CS-NR^{d}-, -CS-NR^{d}-R^{a}-, -R^{a}-CS-NR^{d}-R^{b}-, -R^{a}-NR^{d}-CS-, -NR^{d}-CS-R^{a}-, -R^{a}-NR^{d}-CS-R^{b}-, -SO-R^{a}-S-, -SO-R^{a}-SO-, -SO₂-R^{a}-SO₂-, -SO₂-R^{a}-SO-, -SO-R^{a}-SO₂-, -O-R^{a}-SO-, -O-R^{a}-SO₂-, -SO-R^{a}-O-, -SO₂-R^{a}-O-, -SO-R^{a}-, -SO₂-R^{a}-, -R^{a}-SO-, -R^{a}-SO₂-, -R^{a}-SO-R^{b}-, -R^{a}-SO₂-R^{b}-, -SO-R^{a}-NR^{d}-, -SO₂-R^{a}-NR^{d}-, -R^{a}-SO-R^{b}-NR^{d}-, -SO-R^{a}-NR^{d}-R^{b}-, -R^{a}-SO-R^{b}-NR^{d}-R^{c}-, -NR^{d}-R^{a}-SO-, -R^{a}-NR^{d}-R^{b}-SO-, -NR^{d}-R^{a}-SO-R^{b}-, -R^{a}-NR^{d}-R^{b}-SO-R^{c}-, -R^{a}-SO₂-R^{b}-NR^{d}-, -SO₂-R^{a}-NR^{d}-R^{b}-, -R^{a}-SO₂-R^{b}-NR^{d}-R^{c}-, -NR^{d}-R^{a}-SO₂-, -R^{a}-NR^{d}-R^{b}-SO₂-, -NR^{d}-R^{a}-SO₂-R^{b}- und -R^{a}-NR^{d}-R^{b}-SO₂-R^{c}-ist,
wobei R^{a}, R^{b} und R^{c} jeweils unabhängig voneinander ausgewählt sind aus der Gruppe bestehend aus substituiertem oder unsubstituiertem C₁₋₂₀-Alkylen, substituiertem oder unsubstituiertem C₂₋₂₀-Alkenylen, substituiertem oder unsubstituiertem C₆₋₂₀-Arylen, substituiertem oder unsubstituiertem C₇₋₃₂-Arylalkylen, substituiertem oder unsubstituiertem C₈₋₃₃-Alkylarylen und substituiertem oder unsubstituiertem C₈₋₃₃-Alkylarylalkylen, und
wobei R^{d} und R^{e} jeweils unabhängig voneinander ausgewählt sind aus der Gruppe bestehend aus Wasserstoff, Deuterium, einem substituierten oder unsubstituierten C₁₋₂₀-Alkylrest, einem substituierten oder unsubstituierten C₂₋₂₀-Alkenylrest, einem substituierten oder unsubstituierten C₆₋₂₀-Arylrest, einem substituierten oder unsubstituierten C₇₋₃₂-Arylalkylrest und einem substituierten oder unsubstituierten C₈₋₃₃-Alkylarylalkylrest, insbesondere wobei R^{d} und R^{e} jeweils Wasserstoff sind.

5. Metall(I)-Komplex gemäß Anspruch 4, bei dem bedeuten:
Z -R^{a}-, -O-R^{a}-O- oder -O-R^{a} ist; und/oder
Y zusammen mit dem Kohlenstoffatom und dem Stickstoffatom der Struktur der Formeln (I) oder (II) ein substituiertes oder unsubstituiertes aromatisches Ringsystem ausgewählt aus der Gruppe bestehend aus einem Pyridinring, Oxadiazolring, Pyrrolring, Indolring, Isoindolring, Imidazolring, Triazolring, Benzimidazolring, Purinring, Pyrazolring, Indazolring, Oxazolring, Benzoxazolring, Isoxazolring, Benzisoxazolring, Thiazolring, Benzothiazolring, Chinolinring, Isochinolinring, Pyrazinring, Chinoxalinring, Pyrimidinring und Chinazolinring bildet, insbesondere zusammen mit dem Kohlenstoffatom und dem Stickstoffatom der Struktur der Formeln (I) oder (II) einen substituierten oder unsubstituierten Pyridin-, 1,3,4-Oxadiazol-, Imidazol- oder Benzimidazolring bildet.

6. Metall(I)-Komplex gemäß Anspruch 4 oder 5, bei dem
R¹ und/oder R³ unabhängig von einander mit mindestens einer ionischen Gruppe substituierte Arylreste sind, bevorzugt R¹ und R³ jeweils mit mindestens einer ionischen Gruppe substituierte Arylreste sind; und/oder
R², R⁴, R⁵, R⁶, R⁷ und R⁸ unsubstituierte Reste aus der Gruppe: Arylreste, Alkylreste, Arylalkylreste, Alkylarylreste oder Alkylarylalkylreste sind.

7. Metall(I)-Komplex gemäß einem der Ansprüche 1 bis 6, bei dem der Metall(I)-Komplex eine Struktur gemäß einer der folgenden Formeln (III) oder (IV) aufweist: 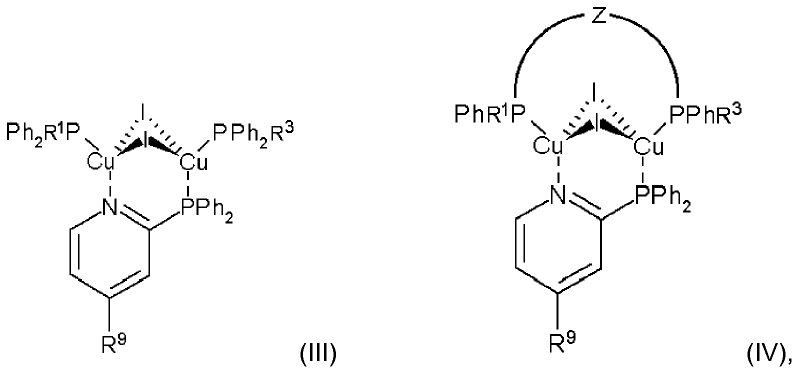 wobei Z wie in Anspruch 4 oder 5 definiert ist, insbesondere wobei Z ein unsubstitutierter C₄₋₇-Alkylrest oder ein -O-Aryl-O- ist;
wobei R¹ und R³ jeweils mit mindestens einer ionischen Gruppe substituierte Arylreste sind; und
wobei R⁹ ein beliebiger Rest ist, bevorzugt wobei R⁹ ein C₁₋₂₀-Alkyl oder H ist, insbesondere wobei R⁹ ein C₁₋₁₀-Alkyl ist.

8. Metall(I)-Komplex gemäß einem der Ansprüche 1 bis 7, bei dem der Metall(I)-Komplex eine Struktur gemäß einer der folgenden Formel (V) aufweist: 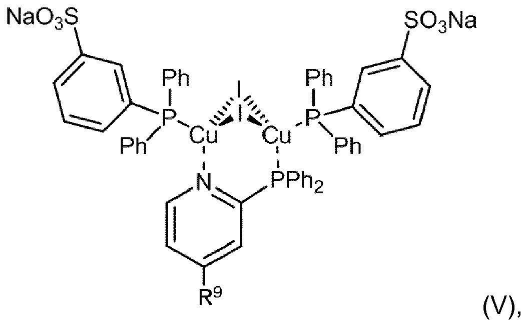 wobei R⁹ ein beliebiger Rest ist, bevorzugt wobei R⁹ ein C₁₋₂₀-Alkyl oder H ist, insbesondere wobei R⁹ ein C₁₋₁₀-Alkyl oder H ist.

9. Zusammensetzung Z enthaltend:
(a) mindestens einen Metall(I)-Komplex gemäß einem der Ansprüche 1 bis 8; und
(b) eine ionische Flüssigkeit, ein oder mehrere Salze und/oder ein oder mehrere polymere Komponente(n).

10. Verfahren zur Herstellung eines Metall(I)-Komplexes gemäß einem der Ansprüche 1 bis 8, umfassend die Schritte:
(i) Bereitstellen einer Lösung enthaltend die Verbindung gemäß der Formel (vi) 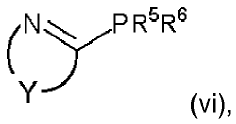 PR¹R²R⁷, PR³R⁴R⁹ und mindestens ein Metall(I)-Halogenidsalz in einem geeigneten Lösungsmittel,
wobei die R¹, R², R³, R⁴, R⁵, R⁶, R⁷, R⁸, Y, das Metall(I) und das Halogen wie in einem der Ansprüche 1 bis 8 definiert sind;
(ii) Inkubieren des Ansatzes unter Rühren;
(iii) optional Waschen des Metall(I)-Komplexes mit einer Flüssigkeit, in dem der Metall(I)-Komplex nicht oder nur schwer löslich ist; und
(iv) Isolieren des Metall(I)-Komplexes von dem Reaktionsansatz.

11. Opto-elektronische Vorrichtung, enthaltend mindestens einen Metall(I)-Komplex gemäß einem der Ansprüche 1 bis 8 oder eine Zusammensetzung Z gemäß Anspruch 9.

12. Opto-elektronische Vorrichtung gemäß Anspruch 11, in der die opto-elektronische Vorrichtung eine lichtemittierende elektrochemische Zelle, eine organische Leuchtdiode, ein organischer Laser, eine organische Solarzelle oder ein optischer Sensor ist, insbesondere eine lichtemittierende elektrochemische Zelle ist, und den Metall(I)-Komplex oder die Zusammensetzung Z in der Emitterschicht B enthält.

13. Opto-elektronische Vorrichtung gemäß Anspruch 11 oder 12, in der die opto-elektronische Vorrichtung eine lichtemittierende elektrochemische Zelle ist, die folgende Schichten umfasst:
A) eine Anodenschicht A, bevorzugt umfassend Indium-Zinn-Oxid, Indium-Zink-Oxid, PbO, SnO, Grafit, dotiertes Si, dotiertes Ge, dotiertes GaAs, dotiertes Polyanilin, dotiertes Polypyrrol und/oder dotiertes Polythiophen;
B) eine Emitterschicht B enthaltend einen Metall(I)-Komplex gemäß einem der Ansprüche 1 bis 8 oder eine Zusammensetzung Z gemäß Anspruch 9; und
C) eine Kathodenschicht C, bevorzugt umfassend Al, Au, Ag, Pt, Cu, Zn, Ni, Fe, Pb, In, W, Pd und/oder Mischungen oder Legierungen aus zwei oder mehr dieser Metalle.

14. Verfahren zur Erzeugung von Licht einer bestimmten Wellenlänge, umfassend den Schritt der Bereitstellung eines Metall(I)-Komplexes gemäß einem der Ansprüche 1 bis 8 oder einer Zusammensetzung Z gemäß Anspruch 9 in der Emitterschicht B einer opto-elektronischen Vorrichtung gemäß einem der Ansprüche 11 bis 13.
